(19) Europäisches Patentamt
European Patent Office
Office européen des brevets

(11) EP 2 387 735 B1

(12) EUROPEAN PATENT SPECIFICATION

(45) Date of publication and mention of the grant of the patent:
**13.03.2019 Bulletin 2019/11**

(21) Application number: **10732115.0**

(22) Date of filing: **15.01.2010**

(51) Int Cl.:
***G03F 7/00*** *(2006.01)*

(86) International application number:
**PCT/US2010/021096**

(87) International publication number:
**WO 2010/083350 (22.07.2010 Gazette 2010/29)**

# (54) NONPOLYMERIC BINDERS FOR SEMICONDUCTOR SUBSTRATE COATINGS

NICHT POLYMERE BINDER FÜR HALBLEITERSUBSTRATBESCHICHTUNGEN

LIANTS NON POLYMÈRES POUR REVÊTEMENTS DE SUBSTRAT SEMI-CONDUCTEUR

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **16.01.2009 US 205275 P**

(43) Date of publication of application:
**23.11.2011 Bulletin 2011/47**

(73) Proprietor: **FujiFilm Electronic Materials USA, Inc.**
**North Kingstown, RI 02852 (US)**

(72) Inventors:
- **MALIK, Sanjay**
  **Attleboro**
  **MA 02703 (US)**
- **DILOCKER, Stephanie, J.**
  **East Providence**
  **RI 02914 (US)**
- **REINERTH, William, A.**
  **Riverside**
  **RI 02915 (US)**
- **SAKAMURI, Raj**
  **Sharon**
  **MA 02067 (US)**

(74) Representative: **Boult Wade Tennant LLP**
**Verulam Gardens**
**70 Gray's Inn Road**
**London WC1X 8BT (GB)**

(56) References cited:
**EP-A1- 1 850 180**
**WO-A1-2008/072624**
**US-A- 4 431 421**
**US-A1- 2005 238 997**
**US-B2- 7 132 216**

- **DOMINIC LALIBERTÉ ET AL: "Molecular Tectonics. Dendritic Construction of Porous Hydrogen-Bonded Networks", ORGANIC LETTERS, vol. 5, no. 25, 1 December 2003 (2003-12-01), pages 4787-4790, XP055058171, ISSN: 1523-7060, DOI: 10.1021/ol035712j**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

## FIELD OF THE DISCLOSURE

This disclosure relates to thermally-curable coating compositions comprising novel, nonpolymeric binders, which are useful for semiconductor substrate coatings in applications such as gap fill applications and as bottom antireflective coatings in photolithographic processes.

## BACKGROUND TO THE DISCLOSURE

The microelectronics industry, as well as other related industries, is constantly reducing the feature size for constructing micro- and nano-scopic structures. Effective lithographic techniques are essential in this quest and require constantly improved radiation-sensitive materials (photoresists). In order to resolve smaller structures, the wavelength of the exposing light has been reduced into the deep UV regions of 248 nm, 193 nm and 157 nm in addition to exposure to EUV or x-ray radiation. As the patterns and wavelengths become finer, the material properties of the photoresists used for pattern delineation have become more and more demanding. In particular, requirements of sensitivity, transparency, aesthetics of the image produced, and the selectivity of the photoresist films to etch conditions for pattern transfer become more and more rigorous.

In order to improve aerial image performance in exposure systems, monochromatic light is frequently employed to produce high resolution images. Unfortunately, because of the wave nature of the light, monochromatic reflected light results in what are called standing waves. These standing waves are variations of light intensity in the photoresist film caused by constructive and destructive interference of the reflected monochromatic light. This variation in light intensity reduces resolution and causes linewidth variations and undercutting of the relief profiles. When exposing photoresist films coated over topography, localized reflections off the topography complicate control of exposures received within the bulk of the film, which results in certain very localized areas of the photoresist film being over- or under-exposed.

To solve these problems, antireflective coatings are employed. Coatings placed above the photoresist film are referred to as "top antireflective coatings" and those placed between the photoresist film and the substrate are referred to as "bottom antireflective coatings" (B.A.R.C.s), which are more frequently used.

The use of B.A.R.C.s to control reflection, however, requires additional processing steps and creates other problems requiring innovative solutions. For example, after the photoresist film development step, the B.A.R.C. must be removed in the areas where the photoresist film has been removed. Although there are other solutions, this is typically done by an oxidative plasma etch step. Unfortunately, during the plasma etch step, the photoresist film also etches because of low etch selectivity between the B.A.R.C. and the photoresist film. Thus the B.A.R.C. needs to be thin, in order to minimize the amount of photoresist film etched away when removing the B.A.R.C..

In order to minimize the thickness of the B.A.R.C. yet obtain the desired antireflective properties, the B.A.R.C. optical properties, need to be optimized. The refractive index (N) is a complex number, $N = n - ik$, where n is the "real" part of the refractive index, and ik the imaginary part of the refractive index. The extinction coefficient, k, is proportional to the absorption coefficient ($\alpha$), which is a function of the wavelength ($\lambda$), and can be approximated by the following relationship $k = \lambda\alpha/(4\pi)$. If there is a large difference in the index of refraction between the photoresist film and the B.A.R.C., light will reflect off of the B.A.R.C. causing standing wave effects in the photoresist film. Thus, the real portion "n" of the index of refraction of the two layers must be made to essentially match or to have their differences minimized, and the imaginary portion "k" of the index of refraction of the two layers must be optimized to minimize reflectivity effects. This optimization is important to minimize residual reflectivity from the photoresist film / B.A.R.C. interface. Thus, when selecting the appropriate k-value a trade-off must be made between suppression of substrate reflectivity and reflectivity from the photoresist film / B.A.R.C. interface.

With the growing implementation of immersion lithography, the characteristics of the B.A.R.C. need to be optimized for immersion lithography. The wider range of angles of the incident radiation changes the optimum optical characteristics required for reflection control. To address this situation, some in the semiconductor industry are employing multilayer B.A.R.C.s in which two B.A.R.C.s of differing optical properties are employed. These may be two layers of organic B.A.R.C.s or a combination of an organic B.A.R.C. layer and an inorganic or organometallic B.A.R.C.. The use of multilayer B.A.R.C.s and their general characteristics are described in Advances in Resist Technology and Processing, volume 5753 pp417-435 (2005), volume 6519 pp651928-1 to 651928-10, 651929-1 to 651929-10, and 65192A-1 to 65192A-8 (2007).

Many conventional B.A.R.C.s are produced by thermally curing soluble polymeric compositions into crosslinked films that are insoluble in a photoresist casting solvent. If the cured B.A.R.C. has appreciable solubility in the photoresist casting solvent, intermixing of the two layers will occur and negatively impact photoresist imaging performance. Also, at typical curing temperatures for conventional B.A.R.C.s, sublimation of small amounts of the B.A.R.C. components (e.g. TAGs (thermal acid generators), crosslinkers, etc.) or reaction by-products (e.g. acids, alcohols, water) from the

thermal curing frequently occur. This can result in contamination of equipment, which requires more frequent cleaning and replacement to avoid loss of production yield. This is undesirable as it can result in significantly increased production costs.

Commonly used antireflective compositions are multicomponent formulations which use an acrylic polymer binder containing substituents pendant to the polymer backbone. The acrylic polymer binder has the strongest effect on the characteristics of the cured B.A.R.C.. Such characteristics include the optical properties, plasma etch rate, solubility in casting solvents, adhesion to the underlying substrate and interaction with the photoresist film. In addition the polymer binder typically provides sites which will react in a crosslinking reaction with itself or an added crosslinker.

Typical acrylic polymers used in conventional B.A.R.C. formulations are prepared by radical copolymerization of different functional monomers. Alternatively, specific functional groups may be grafted onto the polymeric backbone via known chemical reactions. The deep ultraviolet (DUV) chromophore required for film absorbance may also be physically dispersed into the composition rather than chemically linked to the polymer backbone. However, when the chromophore is physically dispersed into the B.A.R.C., two negative consequences can result: (1) sublimation of the chromophore during the bake step; and, (2) extraction of the chromophore into the photoresist during the photoresist coating / baking processes.

A major limitation of this polymeric design is the random distribution of the functional groups along the polymer backbone leading to deleterious effects on important film properties. For instance, loss of adhesion leading to pattern collapse may occur if the functional groups responsible for adhesion are not uniformly distributed in the film or if a block of monomers with poor adhesive properties is obtained. Similarly, aggregation of certain types of functional groups may result in coating defects if this particular portion of the polymer chain shows different solubility behavior than the rest of the chain. Likewise, if groups in the polymer having higher plasma etch resistance are not uniformly distributed across the polymer backbone, localized areas having higher etch resistance may occur resulting in incomplete etching or requiring an over-etch to the detriment of the photoresist film thickness. As image resolution requirements become smaller and smaller, uniformity, repeatability, and other requirements require more and more homogeneity in the materials employed.

One way to resolve these issues would be to introduce the necessary functional groups in a manner which distributes them homogeneously at the molecular level along the polymer backbone. In theory, such materials can be produced via "living" polymerization methods. Unfortunately, most "living" polymerization techniques useful for producing acrylate polymers require onerous precautions or are unsuitable for desired functional groups, and thus restrict the use of such polymers in commercial applications.

With devices having a smaller feature size, Cu is replacing Al in the device manufacturing. A dual damascene process is commonly employed to prepare copper features in the device. (See U.S. Pat. No. 6,057,239) In this process, a bottom anti-reflective coating is used on a substrate having large aspect ratios (>1) between the top of the topography and the bottom of trenches or vias versus the trench or via diameter. However, due to the characteristics of an organic bottom anti-reflective coating material and the large thickness variations between the coating on the top of the topography and the coating in the trench (or via), it is difficult to obtain good results employing a bottom anti-reflective coating material in the dual damascene process. Thus, it may be advantageous to first coat and cure an aperture fill (gap fill) composition) to fill the trench (or via) and planarize the topography and then coat an antireflective coating on top of the cured aperture fill coating.

Desirable properties required for gap fill material for lithography include a) the ability to planarize semiconductor substrates having high aspect ratio topography with a film which has minimal film thickness over the top of the topography; b) no solubility in the photoresist or antireflective coating solvent after curing in order to prevent intermixing of the gap fill material and the photoresist or antireflective coating; c) no diffusion of gap fill components into photoresist or antireflective coatings; d) reasonable to high plasma etch rates (higher than the photoresist etch rate); e) the ability to completely fill the trench or vias; and f) minimal absorption at the wavelength of light used to expose the photoresist.

Exemplary compositions of resist underlayer film of the prior art can be found in WO2008072624A1 and EP1850180A1.

The present disclosure addresses the deficiencies of the prior art by utilizing semiconductor substrate coating compositions that employ nonpolymeric binders (NPCBs) to create bottom antireflective coatings and gap fill compositions with tunable plasma etch rates, virtually no intermixing with photoresist films, excellent substrate adhesion, and tunable optical properties. Thereby, the present disclosure serves the need for a B.A.R.C. and gap fill compositions with improved etch selectivity for the creation of relief images on substrates for the production of semiconductor, electronic, and optical devices.

## SUMMARY OF THE DISCLOSURE

The present disclosure provides a semiconductor coating composition and process according to the claims appended hereto.

The present disclosure provides semiconductor coating compositions suitable for preparing compositions useful as aperture fill compositions and bottom antireflective coatings. The semiconductor coating compositions of the present disclosure comprise:

(1) at least one nonpolymeric, binder (NPB) as defined in the appended claims;
(2) at least one crosslinking agent; and
(3) at least one solvent.

In another embodiment, the disclosure further relates to a lithographic process for forming a relief image on a substrate which comprises:

(a) providing a substrate, optionally coated with a first bottom antireflective coating previously applied or an aperture fill composition previously applied;
(b) coating in a first coating step said substrate with an antireflective composition of this disclosure to form an uncured bottom antireflective coating;
(c) baking in a first baking step said uncured bottom antireflective coating to provide a cured bottom antireflective coating (B.A.R.C.);
(d) coating in a second coating step a photoresist over the cured B.A.R.C. to form a photoresist film over the cured B.A.R.C.;
(e) baking the photoresist film in a second baking step to form a photoresist film / cured B.A.R.C./ optional first bottom antireflective coating stack;
(f) exposing the photoresist film of the stack to Deep UV imaging radiation;
(g) developing a portion of the photoresist film of the stack thereby uncovering a portion of the underlying cured B.A.R.C of the stack; and
(h) rinsing the cured photoresist film / B.A.R.C. / optional first bottom antireflective coating stack with an aqueous rinse; and
(i) etching the uncovered portion of the underlying cured B.A.R.C. of the stack in an oxidizing plasma to produce a relief image.

In another embodiment, the present disclosure discloses thermally-cured bottom antireflective coatings and aperture fill coatings prepared from the antireflective and aperture fill compositions of the present disclosure. These cured coatings may be formed, e.g., by steps a-c in the lithographic process described above and the process for manufacture of a planarized layer described above.

In another embodiment, the present disclosure discloses a photoresist film / B.A.R.C. / aperture fill film stack comprising a semiconductor substrate with at least two apertures, a thermally-cured film of an aperture fill film composition of this disclosure coated on the semiconductor substrate, a thermally-cured film coating of a bottom antireflective composition coated on the aperture fill film, and a photoresist film over the thermally-cured film of the antireflective composition of this disclosure. The photoresist film / B.A.R.C. / aperture fill film stack of this disclosure may be prepared, e.g., by the process for manufacture of a planarized layer described above followed by steps a-e in the lithographic process described above.

In another embodiment, the present disclosure discloses a photoresist film / B.A.R.C. stack comprising a substrate, optionally coated with a first bottom antireflective coating previously applied, a thermally-cured film coating of a bottom antireflective composition of this disclosure (B.A.R.C.) coated on the substrate, and a photoresist film over the thermally-cured film of the antireflective composition of this disclosure. The photoresist film / B.A.R.C. stack of this disclosure may be prepared, e.g., by steps a-e in the lithographic process described above.

The semiconductor coating compositions of the present disclosure provide B.A.R.C.s and aperture fill compositions with tunable plasma etch rates, virtually no intermixing with photoresists, excellent substrate adhesion, and controllable optical properties. They are suitably used with either positive or negative tone photoresists for producing high resolution relief images on substrates for the production of semiconductor, electronic, and optical devices.

## DETAILED DESCRIPTION OF THE DISCLOSURE

### Definitions and Nomenclature

In this specification references will be made to a number of terms which shall be defined to have the following meanings:

The singular forms "a" and "the" are intended to encompass plural referents, unless the context clearly dictates otherwise.

The term "antireflective coating" is used herein to refer to a coating placed on top or below a photoresist film to reduce the reflectance of imaging radiation and the standing wave effects associated with said reflectance.

The terms "bottom antireflective coating" and "B.A.R.C." are used interchangeably herein to refer to a coating situated below a photoresist film to reduce the reflectance of imaging radiation from the substrate and the standing wave effects associated with said reflectance.

The terms "photoresist film", "photoresist layer", "photoresist coating" and "coated photoresist" are used interchangeably herein to refer to a solid, glassy, and / or tacky admixture containing one or more chemical species whose physical and / or chemical properties (usually solubility) are altered upon exposure to radiation of a particular wavelength(s) said alteration permitting the creation of relief images on a substrate.

The terms "chromophore", "Deep UV chromophore" and "DUV chromophore" are used interchangeably herein to refer to a chemical moiety that absorbs radiation of selected wavelength(s) in the deep ultraviolet region of the electromagnetic spectrum, chiefly absorbing radiation in the range from about 100 nm to about 300 nm. Selected wavelengths of particular interest include, but are not limited to, imaging wavelengths such as 248 nm, 193 nm, and 157 nm.

The term "binder" is used herein to refer to a component of a semiconductor coating composition whose chief purpose is to react with a crosslinking agent to form a semiconductor coating that is substantially insoluble in the photoresist casting solvent. In addition, the binder may also fulfill other key functions including, but not limited to, improving the adhesive, antireflective, and film-forming properties of the semiconductor coating composition.

The term "polymer" is used herein to refer to a chemical compound or a mixture of chemical compounds consisting of greater than two repeating structural units directly connected to each other through covalent chemical bonds. This definition expressly includes crown ethers, dextrins, cyclodextrins and oligomeric epoxy resins. The term "nonpolymeric" thus excludes crown ethers, dextrins, cyclodextrins and oligomeric epoxy resins.

The terms "aperture" and "gap" are used synonymously. The terms "coating" and "film" are used synonymously. The terms "semiconductor substrate coating compositions" and semiconductor coating compositions" are used synonymously.

In the context of this description, the term "reactive functional group" in the context of X and $Y^{11}$, shall mean one or more of hydroxyl, sulfhydryl, primary or secondary amino, alkenyl, allyl ether, vinyl ether, (meth)acryl, halogen, sulfonate, carboxyl, carboxyl ester, carboxyl anhydride, and carboxyl acid halide groups.

The present disclosure provides semiconductor coating compositions suitable for preparing compositions useful as aperture fill compositions and bottom antireflective coatings. The semiconductor coating compositions of the present disclosure comprise:

(1) at least one nonpolymeric, binder (NPB) as defined in the appended claims;
(2) at least one crosslinking agent; and
(3) at least one solvent.

The NPB is represented by formula ($A^0$),

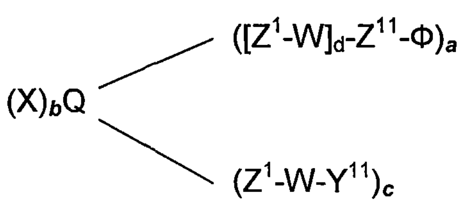

($A^0$)

where Q is a multivalent organic nucleus, $Z^1$ and $Z^{11}$ are divalent linking groups, W is a divalent organic bridging group, Φ is an organic DUV chromophore-containing substituent T or an organic substituent a having little or no absorbance to DUV light. , X is a reactive functional group, $Y^{11}$ is a reactive functional group, *a* ranges from about 2 to about 15, *b* ranges from zero to about 10, *c* ranges from zero to about 5, and d is independently zero or 1, wherein Q, W, and Φ together contain at least two groups or sites which are reactive in a crosslinking reaction and with the proviso that the sum of (*a*+*b*+*c*) is greater than or equal to

Examples of Φ include, but are not limited to those examples described below for T and a.

ə is an organic substituent having little or no absorbance to DUV light. Typical examples of ə include:

a) a hydrogen atom;
b) a substituted or unsubstituted $C_1$-$C_{24}$ linear, branched, cyclic, or polycyclic alkyl or alkenyl not containing as an integral part of a ring or chain structure oxygen, sulfur, or nitrogen atoms; and

c) a substituted or unsubstituted $C_1$-$C_{24}$ linear, branched, cyclic, or polycyclic alkyl or alkenyl containing as an integral part of a ring or chain structure one or more oxygen, sulfur, or nitrogen atoms including mixtures thereof.

Preferably ə is selected from the group consisting of

(a) a hydrogen atom;
(b) a substituted or unsubstituted $C_1$-$C_{16}$ linear, branched, cyclic, or polycyclic alkyl or alkenyl not containing as an integral part of a ring or chain structure oxygen, sulfur, or nitrogen atoms; and
(c) a substituted or unsubstituted $C_1$-$C_{16}$ linear, branched, cyclic, or polycyclic alkyl or alkenyl containing as an integral part of a ring or chain structure one or more oxygen, sulfur, or nitrogen atoms including mixtures thereof.

More preferably a is selected from the group consisting of

(a) a hydrogen atom;
(b) a substituted or unsubstituted $C_1$-$C_{16}$ linear, branched or cyclic alkyl or alkenyl not containing as an integral part of a ring or chain structure oxygen, sulfur, or nitrogen atoms; and
(c) a substituted or unsubstituted $C_1$-$C_{16}$ linear, branched or cyclic alkyl or alkenyl containing as an integral part of a ring or chain structure one or more oxygen, sulfur, or nitrogen atoms including mixtures thereof.

Most preferably a is selected from the group consisting of

(a) a hydrogen atom;
(b) a substituted or unsubstituted $C_1$-$C_{12}$ linear, branched or cyclic alkyl or alkenyl not containing as an integral part of a ring or chain structure oxygen, sulfur, or nitrogen atoms; and
(c) a substituted or unsubstituted $C_1$-$C_{12}$ linear, branched or cyclic alkyl or alkenyl containing as an integral part of a ring or chain structure one or more oxygen, sulfur, or nitrogen atoms including mixtures thereof.

In the context of the description of all as (e.g. ə, $ə^1$, $ə^2$...) an oxygen atom or sulfur atom is considered to be an integral part of a ring or chain structure if it is bonded to two different carbon atoms. A nitrogen atom is considered an integral part of a ring or chain structure if it is bonded to three different carbon atoms.

Each a group may be the same or different. The choice of the appropriate number and nature of a group(s) will vary depending on the particular application and properties desired (e.g. size, flexibility, effects on viscosity, etc.) In addition, a may possess certain structural units and/or contain functional groups suitable to facilitate crosslinking reactions of the semiconductor coating composition.

Examples of ə include, but are not limited to methyl, ethyl, 1-propyl, 2-propyl, 1-butyl and structures shown below,

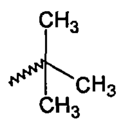
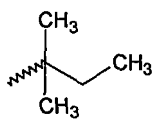
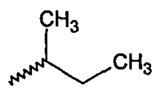
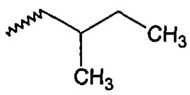

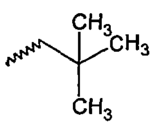
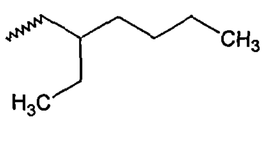
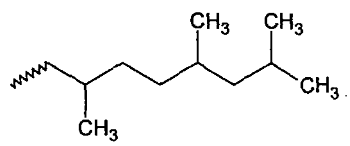

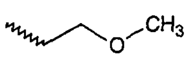
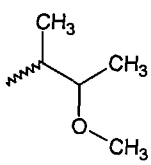
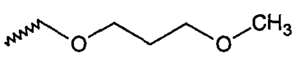
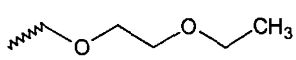

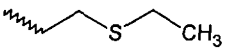
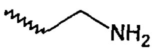
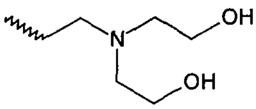
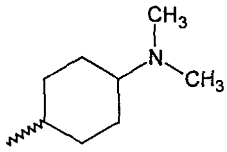

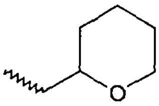
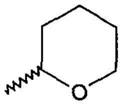
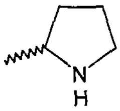
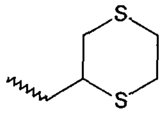

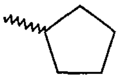
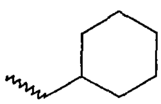
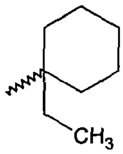
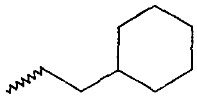

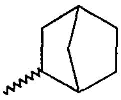
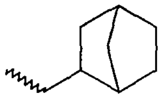
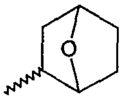
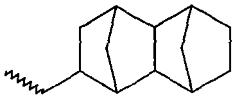

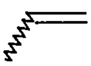
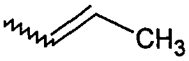
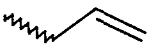
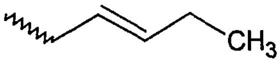

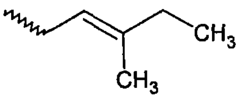
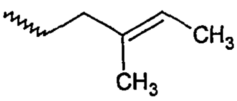
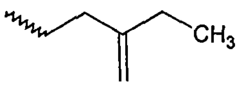
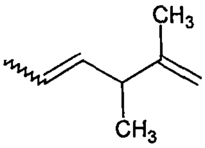

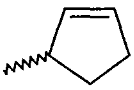
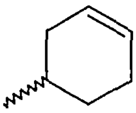
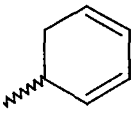
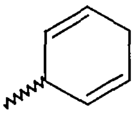
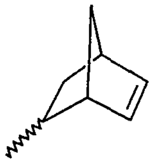

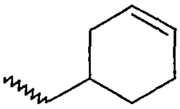
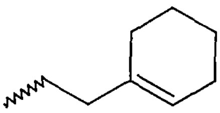
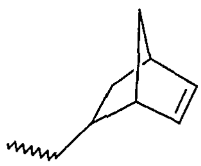
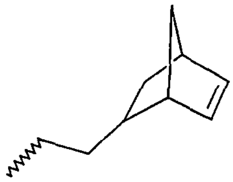

X, Q, $Z^1$, $Z^{11}$, W, $Y^{11}$, *a*, *b*, and c are further described below in the antireflective composition section.

In one embodiment of the disclosure the at least one NPB in the antireflective compositions is represented by formula ($A^1$):

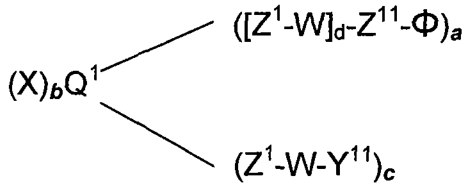

($A^1$)

where $Z^1$ and $Z^{11}$ are divalent linking groups, W is a divalent organic bridging group, Φ is ə or T, X is a reactive functional group, $Y^{11}$ is a reactive functional group, T is an organic DUV chromophore-containing substituent, ə is an organic substituent having little or no absorbance to DUV light, *a* ranges from about 2 to about 15, *b* ranges from zero to about 10, *c* ranges from zero to about 5, and *d* is independently zero or 1, wherein $Q^1$, W, and Φ together contain at least two groups or sites which are reactive in a crosslinking reaction and with the proviso that the sum of (*a*+*b*+*c*) is greater than or equal to 3 and $Q^1$ is selected from the group consisting of:

(a) an unsubstituted $C_2$-$C_{40}$ linear, branched, cyclic, or polycyclic aliphatic group not containing as an integral part of a ring or chain structure oxygen, sulfur, or nitrogen atoms;
(b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
(c) an unsubstituted $C_2$-$C_{40}$ aliphatic group containing both cyclic and acyclic components not containing as an integral part of a ring or chain structure oxygen, sulfur, or nitrogen atoms; and
(d) an unsubstituted $C_2$-$C_{40}$ aliphatic group containing both cyclic and acyclic components and as an integral part of a ring or chain structure one or more oxygen, sulfur, or nitrogen atoms including mixtures thereof.

In one embodiment of the disclosure the at least one NPB in the antireflective compositions is represented by formula ($A^2$):

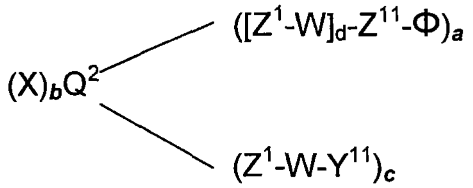

($A^2$)

where $Z^1$ and $Z^{11}$ are divalent linking groups, W is a divalent organic bridging group, Φ is a or T, X is a reactive functional group, $Y^{11}$ is a reactive functional group, T is an organic DUV chromophore-containing substituent, ə is an organic substituent having little or no absorbance to DUV light, *a* ranges from about 2 to about 15, *b* ranges from zero to about 10, *c* ranges from zero to about 5, and *d* is independently zero or 1, wherein $Q^2$, W, and Φ together contain at least two groups or sites which are reactive in a crosslinking reaction and with the proviso that the sum of (*a*+*b*+*c*) is greater than or equal to 3 and $Q^2$ is an unsubstituted $C_2$-$C_{40}$ linear, branched, cyclic, or polycyclic aliphatic group not containing as an integral part of a ring or chain structure oxygen, sulfur, or nitrogen atoms.

In one embodiment of the disclosure the at least one NPB in the antireflective compositions is represented by formula ($A^3$):

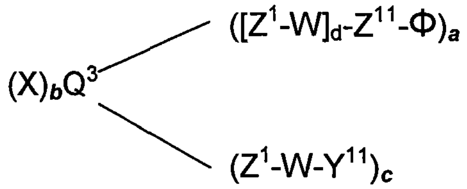

($A^3$)

where $Z^1$ and $Z^{11}$ are divalent linking groups, W is a divalent organic bridging group, Φ is ə or T, X is a reactive functional group, $Y^{11}$ is a reactive functional group, T is an organic DUV chromophore-containing substituent, ə is an organic substituent having little or no absorbance to DUV light, *a* ranges from about 2 to about 15, *b* ranges from zero to about 10, *c* ranges from zero to about 5, and *d* is independently zero or 1, wherein $Q^3$, W, and Φ together contain at least two groups or sites which are reactive in a crosslinking reaction and with the proviso that the sum of (*a*+*b*+*c*) is greater than or equal to 3 and $Q^3$ is an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof.

In one embodiment of the disclosure the at least one NPB in the antireflective compositions is represented by formula ($A^4$):

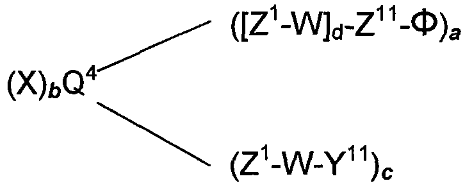

($A^4$)

where $Z^1$ and $Z^{11}$ are divalent linking groups, W is a divalent organic bridging group, Φ is ə or T, X is a reactive functional group, $Y^{11}$ is a reactive functional group, T is an organic DUV chromophore-containing substituent, ə is an organic substituent having little or no absorbance to DUV light, *a* ranges from about 2 to about 15, *b* ranges from zero to about 10, *c* ranges from zero to about 5, and *d* is independently zero or 1, wherein $Q^4$, W, and Φ together contain at least two groups or sites which are reactive in a crosslinking reaction and with the proviso that the sum of (*a*+*b*+*c*) is greater than or equal to 3 and $Q^4$ is an unsubstituted $C_2$-$C_{40}$ aliphatic group containing both cyclic and acyclic components not containing as an integral part of a ring or chain structure oxygen, sulfur, or nitrogen atoms.

In one embodiment of the disclosure the at least one NPB in the antireflective compositions is represented by formula ($A^5$):

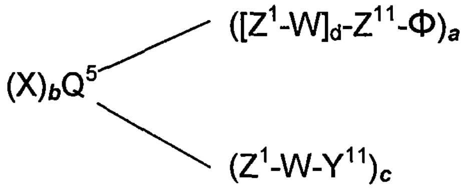

($A^5$)

where $Z^1$ and $Z^{11}$ are divalent linking groups, W is a divalent organic bridging group, Φ is ə or T, X is a reactive functional group, $Y^{11}$ is a reactive functional group, T is an organic DUV chromophore-containing substituent, a is an organic substituent having little or no absorbance to DUV light, *a* ranges from about 2 to about 15, *b* ranges from zero to about 10, *c* ranges from zero to about 5, and *d* is independently zero or 1, wherein $Q^5$, W, and Φ together contain at least two groups or sites which are reactive in a crosslinking reaction and with the proviso that the sum of (*a*+*b*+*c*) is greater than or equal to 3 and $Q^5$ is an unsubstituted $C_2$-$C_{40}$ aliphatic group containing both cyclic and acyclic components and as an integral part of a ring or chain structure one or more oxygen, sulfur, or nitrogen atoms including mixtures thereof.

In one embodiment of the disclosure the at least one NPB in the antireflective compositions is represented by formula ($A^6$):

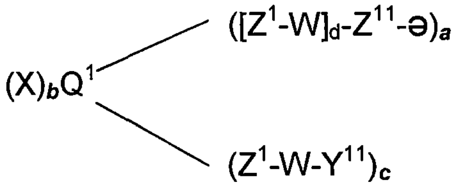

($A^6$)

where $Z^1$ and $Z^{11}$ are divalent linking groups, W is a divalent organic bridging group, ə is an organic substituent having little or no absorbance to DUV light, a ranges from about 2 to about 15, *b* ranges from zero to about 10, *c* ranges from zero to about 5, and *d* is independently zero or 1, wherein $Q^1$, W, and ə together contain at least two groups or sites which are reactive in a crosslinking reaction and with the proviso that the sum of (*a*+*b*+*c*) is greater than or equal to 3 and $Q^1$ is selected from the group consisting of:

a) an unsubstituted $C_2$-$C_{40}$ linear, branched, cyclic, or polycyclic aliphatic group not containing as an integral part of a ring or chain structure oxygen, sulfur, or nitrogen atoms;
b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
c) an unsubstituted $C_2$-$C_{40}$ aliphatic group containing both cyclic and acyclic components not containing as an integral part of a ring or chain structure oxygen, sulfur, or nitrogen atoms; and

d) an unsubstituted $C_2$-$C_{40}$ aliphatic group containing both cyclic and acyclic components and as an integral part of a ring or chain structure one or more oxygen, sulfur, or nitrogen atoms including mixtures thereof.

In one embodiment of the disclosure the at least one NPB in the antireflective compositions is represented by formula ($A^7$):

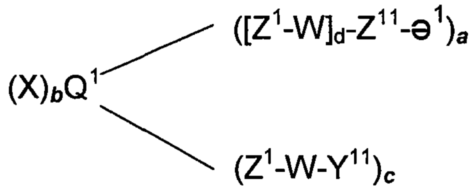

($A^7$)

where $Z^1$ and $Z^{11}$ are divalent linking groups, W is a divalent organic bridging group, ə $^1$ is a hydrogen atom, *a* ranges from about 2 to about 15, *b* ranges from zero to about 10, c ranges from zero to about 5, and *d* is independently zero or 1, wherein $Q^1$ and W together contain at least two groups or sites which are reactive in a crosslinking reaction and with the proviso that the sum of (*a*+*b*+*c*) is greater than or equal to 3 and $Q^1$ is selected from the group consisting of

a) an unsubstituted $C_2$-$C_{40}$ linear, branched, cyclic, or polycyclic aliphatic group not containing as an integral part of a ring or chain structure oxygen, sulfur, or nitrogen atoms;
b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
c) an unsubstituted $C_2$-$C_{40}$ aliphatic group containing both cyclic and acyclic components not containing as an integral part of a ring or chain structure oxygen, sulfur, or nitrogen atoms; and
d) an unsubstituted $C_2$-$C_{40}$ aliphatic group containing both cyclic and acyclic components and as an integral part of a ring or chain structure one or more oxygen, sulfur, or nitrogen atoms including mixtures thereof.

In one embodiment of the disclosure the at least one NPB in the antireflective compositions is represented by formula ($A^8$):

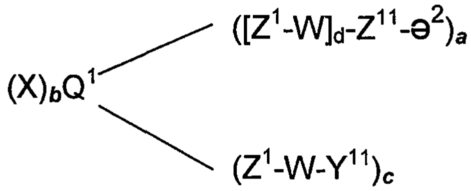

($A^8$)

where $Z^1$ and $Z^{11}$ are divalent linking groups, W is a divalent organic bridging group, ə $^2$ is a substituted or unsubstituted $C_1$-$C_{24}$ linear, branched, cyclic, or polycyclic alkyl or alkenyl not containing as an integral part of a ring or chain structure oxygen, sulfur, or nitrogen atoms, *a* ranges from about 2 to about 15, *b* ranges from zero to about 10, *c* ranges from zero to about 5, and *d* is independently zero or 1, wherein $Q^1$, W, and ə $^2$ together contain at least two groups or sites which are reactive in a crosslinking reaction and with the proviso that the sum of (*a*+*b*+*c*) is greater than or equal to 3 and $Q^1$ is selected from the group consisting of:

a) an unsubstituted $C_2$-$C_{40}$ linear, branched, cyclic, or polycyclic aliphatic group not containing as an integral part of a ring or chain structure oxygen, sulfur, or nitrogen atoms;
b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
c) an unsubstituted $C_2$-$C_{40}$ aliphatic group containing both cyclic and acyclic components not containing as an integral part of a ring or chain structure oxygen, sulfur, or nitrogen atoms; and
d) an unsubstituted $C_2$-$C_{40}$ aliphatic group containing both cyclic and acyclic components and as an integral part of a ring or chain structure one or more oxygen, sulfur, or nitrogen atoms including mixtures thereof.

In one embodiment of the disclosure the at least one NPB in the antireflective compositions is represented by formula ($A^9$):

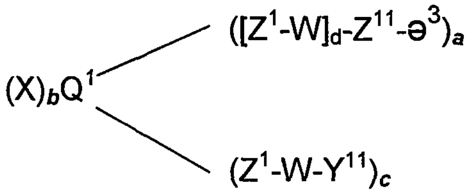

(A$^9$)

where $Z^1$ and $Z^{11}$ are divalent linking groups, W is a divalent organic bridging group, ə$^3$ is a substituted or unsubstituted $C_1$-$C_{24}$ linear, branched, cyclic, or polycyclic alkyl or alkenyl containing as an integral part of a ring or chain structure one or more oxygen, sulfur, or nitrogen atoms including mixtures thereof, *a* ranges from about 2 to about 15, *b* ranges from zero to about 10, c ranges from zero to about 5, and *d* is independently zero or 1, wherein $Q^1$, W, and ə$^3$ together contain at least two groups or sites which are reactive in a crosslinking reaction and with the proviso that the sum of (*a*+*b*+*c*) is greater than or equal to 3 and $Q^1$ is selected from the group consisting of:

a) an unsubstituted $C_2$-$C_{40}$ linear, branched, cyclic, or polycyclic aliphatic group not containing as an integral part of a ring or chain structure oxygen, sulfur, or nitrogen atoms;
b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
c) an unsubstituted $C_2$-$C_{40}$ aliphatic group containing both cyclic and acyclic components not containing as an integral part of a ring or chain structure oxygen, sulfur, or nitrogen atoms; and
d) an unsubstituted $C_2$-$C_{40}$ aliphatic group containing both cyclic and acyclic components and as an integral part of a ring or chain structure one or more oxygen, sulfur, or nitrogen atoms including mixtures thereof.

Antireflective Compositions

In a preferred embodiment, the semiconductor coating compositions have antireflective properties suitable for preparing bottom antireflective coatings (B.A.R.C.s) useful for the formation of high resolution relief images. Antireflective compositions of the present disclosure comprise:

(1) at least one nonpolymeric, chromophore-containing binder (NPCB);
(2) at least one crosslinking agent; and
(3) at least one solvent.

The NPCB is represented by formula (A)

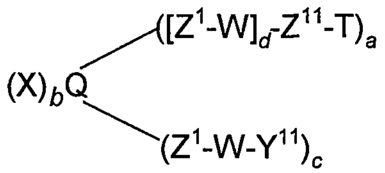

(A)

where Q is a multivalent organic nucleus, $Z^1$ and $Z^{11}$ are divalent linking groups, W is a divalent organic bridging group, T is an organic DUV chromophore-containing substituent, X is a reactive functional group, $Y^{11}$ is a reactive functional group, *a* ranges from about 2 to about 15, *b* ranges from zero to about 10, *c* ranges from zero to about 5, and *d* is independently zero or 1, wherein Q, W, and T together contain at least two groups or sites which are reactive in a crosslinking reaction and with the proviso that the sum of (*a*+*b*+*c*) is greater than or equal to 3 and Q is selected from the group consisting of:

a) an unsubstituted $C_2$-$C_{40}$ linear, branched, cyclic, or polycyclic aliphatic group not containing as an integral part of a ring or chain structure oxygen, sulfur, or nitrogen atoms;
b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
c) an unsubstituted $C_2$-$C_{40}$ aliphatic group containing both cyclic and acyclic components not containing as an integral part of a ring or chain structure oxygen, sulfur, or nitrogen atoms; and
d) an unsubstituted $C_2$-$C_{40}$ aliphatic group containing both cyclic and acyclic components and as an integral part

of a ring or chain structure one or more oxygen, sulfur, or nitrogen atoms including mixtures thereof.

In the context of the description of all Qs (e.g. Q, $Q^1$, $Q^2$...) an oxygen atom or sulfur atom is considered to be an integral part of a ring or chain structure if it is bonded to two different carbon atoms. A nitrogen atom is considered an integral part of a ring or chain structure if it is bonded to three different carbon atoms. All Qs are unsubstituted except where specifically stated in this disclosure.

Preferably, Q is selected from the group consisting of:

(a) an unsubstituted $C_3$-$C_{24}$ linear or branched aliphatic group not containing as an integral part of a ring or chain structure oxygen, sulfur, or nitrogen atoms; and
(b) an unsubstituted $C_2$-$C_{24}$ linear, branched, aliphatic group containing as an integral part of a ring or chain structure one or more oxygen, sulfur, or nitrogen atoms including mixtures thereof.

More preferably, Q is selected from the group consisting of:

(a) an unsubstituted $C_4$-$C_{16}$ linear or branched aliphatic group not containing as an integral part of a ring or chain structure oxygen, sulfur, or nitrogen atoms; and
(b) an unsubstituted $C_3$-$C_{16}$ linear, branched, aliphatic group containing as an integral part of a ring or chain structure one or more oxygen, sulfur, or nitrogen atoms including mixtures thereof.

Most preferably, Q is selected from the group consisting of:

(a) an unsubstituted $C_6$-$C_{12}$ linear or branched aliphatic group not containing as an integral part of a ring or chain structure oxygen, sulfur, or nitrogen atoms; and
(b) an unsubstituted $C_4$-$C_{12}$ linear, branched, aliphatic group containing as an integral part of a ring or chain structure one or more oxygen, sulfur, or nitrogen atoms including mixtures thereof.

Examples of Q include, but are not limited to,

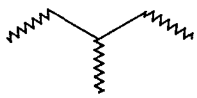
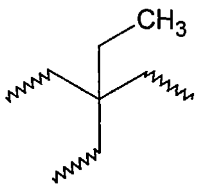
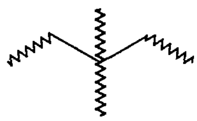
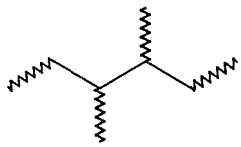

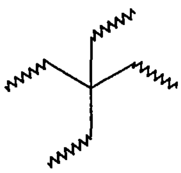
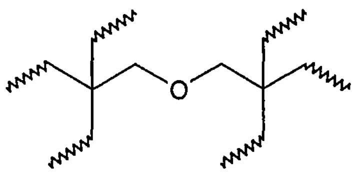
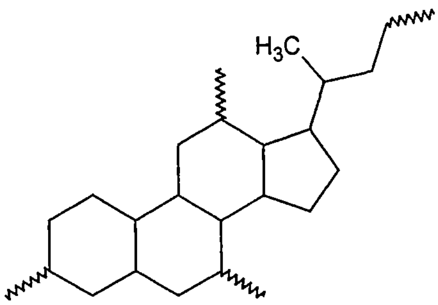

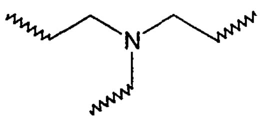
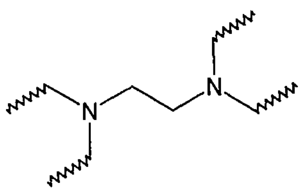
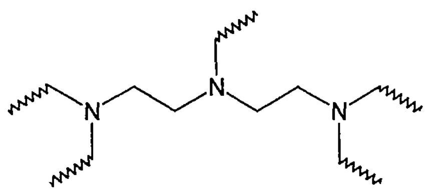

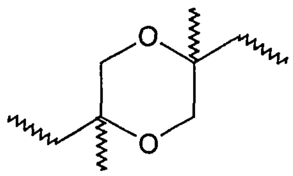

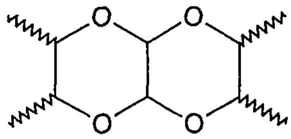

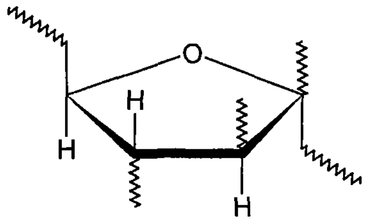

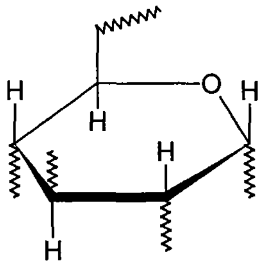

and

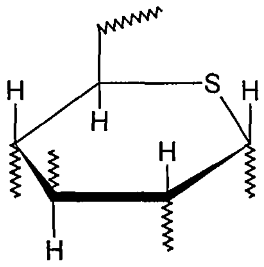

where 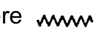 indicates the bond between Q and X, $Z^1$, or $Z^{11}$.

Q is not polymeric. The exact composition and structure of Q is chosen so as to optimize certain key properties including, but not limited to, substrate adhesion, solubility characteristics, and plasma etch selectivity between the photoresist film and the B.A.R.C.. For example, increasing the oxygen content of Q or containing fewer cyclic rings could lead to a B.A.R.C. with a higher etch rate and increased etch selectivity between the photoresist film and the B.A.R.C..

In precursors to the NPBs and NPCBs of formula (A) and formula ($A^0$), Q is contained within a multifunctional, nonpolymeric, reactive entity represented by structure (C),

$$Q(X)_{(a+b+c)} \qquad (C)$$

wherein (C) contains (a+b+c) reactive functional groups, from which (A) may be synthesized. X is a reactive functional group that facilitates linking reactions so as to attach the desired moieties directly or indirectly to Q. For the purpose of this definition a cyclic anhydride with both sides attached to Q is considered as two reactive functional groups since it can connect two moieties to Q. Each X group may be the same or different and is selected from the group consisting of hydroxyl, sulfhydryl, primary or secondary amino, alkenyl, allyl ether, vinyl ether, (meth)acryl, halogen, sulfonate, carboxyl, carboxyl ester, carboxyl anhydride, and carboxyl acid halide. Preferably X groups are selected from the group consisting of hydroxyl, sulfhydryl, primary or secondary amino, alkenyl, allyl ether, vinyl ether, (meth)acryl, halogen, sulfonate, carboxyl, carboxyl anhydride and carboxyl acid halide. More preferably X groups are selected from the group consisting of hydroxyl, sulfhydryl, primary or secondary amino, alkenyl, allyl ether, (meth)acryl and carboxyl. Most preferably X groups are selected from the group consisting of hydroxyl, sulfhydryl, primary or secondary amino, alkenyl, (meth)acryl and carboxyl.

Structures of formulas (A) and ($A^0$) may contain unreacted X groups in the amount of *b* attached to Q. These X groups may, among other functions, enhance substrate adhesion and/or facilitate crosslinking reactions during curing of the antireflective composition.

Examples of the multifunctional, nonpolymeric, reactive entity (C) include, but are not limited to, the following types of materials:

(a) Polyhydric compounds such as pentaerythritol, dipentaerythritol, glycerol, erythritol, and monosaccharides and disaccharides such as xylitol, mannitol, sorbitol, sucrose, fructose, glucose, and maltose;

(b) Polythiols such as 1,2,3-propanetrithiol, 1,3,5-pentanetrithiol, 1,2,6-hexanetrithiol, 1,2,3,4-butanetetrathiol, and 1,3,5-cyclohexanetrithiol;

(c) Polycarboxylic acids not containing nitrogen atoms such as ethanetricarboxylic acid, 1,2,3-propanetricarboxylic acid, butanetetracarboxylic acid, tetrahydrofuran tetracarboxylic acid, cyclobutane tricarboxylic acid, cyclopentane tetracarboxylic acid, cyclohexane hexacarboxylic acid, and nitrogen containing polycarboxylic acids such as ethylenediaminetetraacetic acid, 1,2-diaminopropane-N,N,N'N'-tetraacetic acid, 1,3-diaminopropane-N,N,N'N'-tetraacetic acid, 5H-diethylenetriaminepentaacetic acid, and ethylene glycol-bis(2-aminoethylether)-*N,N,N',N'*-tetraacetic acid;

(d) Primary and secondary amines with three or more amino groups such as tris(2-aminoethyl)amine;

(e) Alkenes with three or more alkene groups such as 1,3,7-octatriene, myrcene, and cembrene;

(f) Allyl ethers with three or more allyl ether groups such as trimethylolpropane triallyl ether, erythritol tetraallyl ether,

pentaerythritol tetraallyl ether, and dipentaerythritol hexaallyl ether;
(g) Vinyl ethers with three or more vinyl ether groups such as trimethylolpropane trivinyl ether, erythritol tetravinyl ether, pentaerythritol tetravinyl ether, and dipentaerythritol hexavinyl ether;
(h) Polycarboxylic acid esters such as trimethylpropanetricarboxylate, tetramethyl butanetetracarboxylate, and hexaethyl cyclohexane hexacarboxylate;
(i) Carboxylic acid anhydrides such as ethylenediaminetetraacetic acid dianhydride, bicyclo[2.2.2]octane-2,3,5,6-tetracarboxylic dianhydride, cyclobutane-1,2,3,4-tetracarboxylic dianhydride, tetrahydrofuran-2,3,4,5- tetracarboxylic dianhydride, 1,2,3-propanetricarboxylic tris(acetic anhydride), and tetrahydrofuran-2,3,4,5-tetracarboxylic tetrakis(acetic anhydride);
(j) Carboxylic acid halides with three or more carboxylic acid halide groups such as 1,1,2,2,-ethanetetracarbonyl chloride, 1,2,3-propanetricarbonyl chloride, and cyclohexane hexacarbonyl chloride or the analogous bromides,;
(k) Alkyl halides with three or more halides such as 1,2,3-trichloropropane, 1,2,3-tribromopropane, 1,2,3,4-tetrabromopropane, 1,1,1-tris(chloromethyl)propane, 1,3-dichloro-2-(chloromethyl)-2-methylpropane and pentaerythritol tetrabromide;
(l) Sulfonate derivatives with three or more sulfonate groups such as pentaerythritol tetrakis(p-toluenesulfonate), pentaerythritol tetrakis(methanesulfonate), 1,2,3-tris(trifluoromethanesulfonyl) propane and dipentaerythritol hexakis(p-toluenesulfonate);
(m) (Meth)Acrylate derivatives with three or more (meth)acrylate groups such as dipentaerythritol hexaacrylate, pentaerythritol tetraacrylate, and trimethylolpropane trimethacrylate; and
(n) Multifunctional combination compounds containing three or more different reactive functional groups, such as, lactobionic acid, tartaric acid, citric acid, citric acid trimethylester, quinic acid, serine, cysteine, cystine, diethylenetriaminepentaacetic acid dianhydride, N-(2-hydroxyethyl) ethylenediamine-N, N', N'-triacetic acid, dipentaerythritol pentaacrylate, dithioerythritol, dithiothreitol and 2,3-dimercapto-1-propanol.

Suitable values in formulas (A) and ($A^0$) and (C) for *a* are from about 2 to about 15, preferably from about 2 to about 12, more preferably from about 2 to about 10, and most preferably from about 2 to about 8; suitable values for *b* are from zero to about 10, preferably from zero to about 8, more preferably from zero to about 6, and most preferably from zero to about 4; and suitable values for c are from zero to about 5, preferably from zero to about 4, more preferably from zero to about 3, and most preferably from zero to about 2 with the proviso that the sum of ($a$+$b$+$c$) is greater than or equal to 3.

The divalent organic bridging group, W, is a bridging group that connects Q to Φ (which may be ə or the Deep UV chromophore-containing substituent T) via $Z^1$ and $Z^{11}$. Preferably, W is selected from the group consisting of:

(a) a substituted or unsubstituted $C_1$-$C_{12}$ linear, branched, cyclic, or polycyclic alkylene not containing as an integral part of a ring or chain structure oxygen, sulfur, or nitrogen atoms;
(b) a substituted or unsubstituted $C_1$-$C_{12}$ linear, branched, cyclic, or polycyclic alkylene containing as an integral part of a ring or chain structure one or more oxygen, sulfur, or nitrogen atoms including mixtures thereof;
(c) a substituted or unsubstituted phenylene;
(d) a substituted or unsubstituted $C_3$-$C_5$ mononuclear heteroarylene containing one or more oxygen, sulfur, or nitrogen atoms including mixtures thereof;
(e) a substituted or unsubstituted $C_{10}$-$C_{30}$ polynuclear arylene; and
(f) a substituted or unsubstituted $C_6$-$C_{30}$ polynuclear heteroarylene containing one or more oxygen, sulfur, or nitrogen atoms including mixtures thereof.

More preferably, W is selected from the group consisting of:

(a) a substituted or unsubstituted $C_1$-$C_{12}$ linear, branched, cyclic, or polycyclic alkylene not containing as an integral part of a ring or chain structure oxygen, sulfur, or nitrogen atoms;
(b) a substituted or unsubstituted $C_1$-$C_{12}$ linear, branched, cyclic, or polycyclic alkylene containing as an integral part of a ring or chain structure one or more oxygen, sulfur, or nitrogen atoms including mixtures thereof;
(c) a substituted or unsubstituted phenylene; and
(d) a substituted or unsubstituted $C_{10}$-$C_{20}$ polynuclear arylene.

Most preferably, W is selected from the group consisting of:

(a) a substituted or unsubstituted $C_1$-$C_8$ linear, branched, cyclic, or polycyclic alkylene not containing as an integral part of a ring or chain structure oxygen, sulfur, or nitrogen atoms;

(b) a substituted or unsubstituted $C_1$-$C_8$ linear, branched, cyclic, or polycyclic alkylene containing as an integral part of a ring or chain structure one or more oxygen, sulfur, or nitrogen atoms including mixtures thereof; and
(c) a substituted or unsubstituted phenylene.

In the context of the description of W an oxygen atom, sulfur atom or nitrogen atom is considered to be an integral part of a ring or chain structure if it is bonded to two different carbon atoms.

When W is substituted, the number and identity of the substituents may, among other functions, enhance substrate adhesion and/or facilitate crosslinking reactions of the antireflective composition. Additionally, W may be flexible or rigid and its exact structure will impact a number of key properties including, but not limited to, solubility, coating quality, crosslinking efficiency, and plasma etch selectivity between the photoresist film and the B.A.R.C.. In addition, when W is an arylene or heteroarylene, it can assist in controlling the optical properties of the antireflective composition by increasing the total absorbance of the NPCB at the selected wavelength(s). The structure of W and its substituents, if any, must be appropriately balanced to obtain the desired blend of properties. For example, when W possesses a flexible, aliphatic structure, the solubility of the NPCB may be enhanced as could the coating quality and crosslinking efficiency of the antireflective composition. However, there would be a sacrifice of antireflective capability as the contribution to optical absorbance from W would be diminished.

Suitable substituents on W are selected from the group consisting of:

(a) a substituted or unsubstituted linear, branched, or cyclic $C_1$-$C_6$ alkyl group;
(b) a substituted or unsubstituted phenyl group;
(c) a nitro group;
(d) a cyano group;
(e) ($-OR^{161}$) where $R^{161}$ is a hydrogen atom, a substituted or unsubstituted $C_1$-$C_6$ linear, branched, or cyclic alkyl or a phenyl group;
(f) ($-SR^{162}$) where $R^{162}$ is a hydrogen atom, a substituted or unsubstituted $C_1$-$C_6$ linear, branched, or cyclic alkyl or a phenyl group;
(g) ($-NR^{163}R^{164}$) where $R^{163}$ and $R^{164}$ are, independently, a hydrogen atom, a substituted or unsubstituted $C_1$-$C_6$ linear, branched, or cyclic alkyl, or a phenyl group;
(h) [$-C(=O)R^{165}$] where $R^{165}$ is a hydrogen atom, a substituted or unsubstituted $C_1$-$C_6$ linear, branched, or cyclic alkyl or a phenyl group;
(i) [$-C(=O)OR^{166}$] where $R^{166}$ is a hydrogen atom, a substituted or unsubstituted $C_1$-$C_6$ linear, branched, or cyclic alkyl or a phenyl group;
(j) [$-OC(=O)R^{167}$] where $R^{167}$ is a hydrogen atom, a substituted or unsubstituted $C_1$-$C_6$ linear, branched, or cyclic alkyl or a phenyl group;
(k) [$-C(=O)NR^{168}R^{169}$] where $R^{168}$ and $R^{169}$ are, independently, a hydrogen atom, a substituted or unsubstituted $C_1$-$C_6$ linear, branched, or cyclic alkyl, or a phenyl group; and
(l) [$-SC(=O)R^{170}$] where $R^{170}$ is a hydrogen atom, a substituted or unsubstituted $C_1$-$C_6$ linear, branched, or cyclic alkyl or a phenyl group.

Examples of W include, but are not limited to, methylene, ethylene, propylene, butylene, isopropylene, isobutylene,

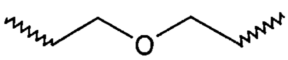
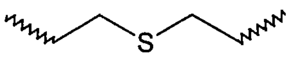
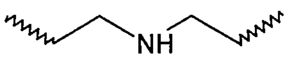

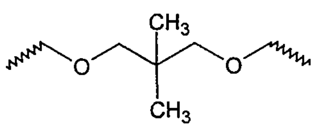
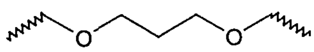
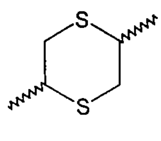

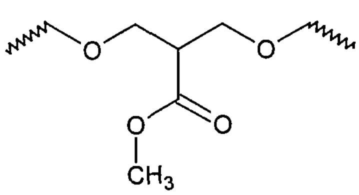
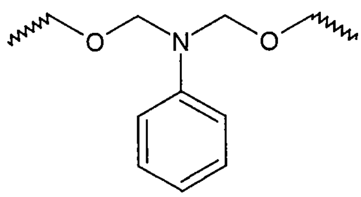
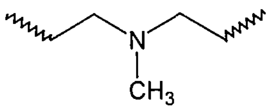

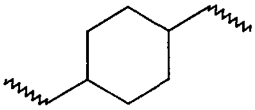
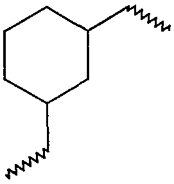
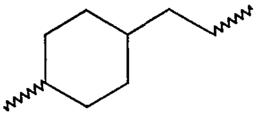
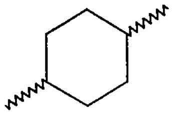

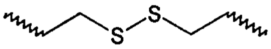
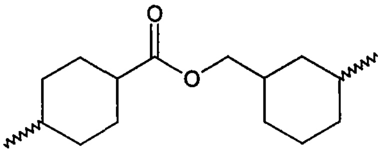
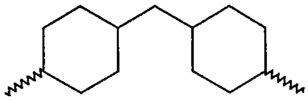

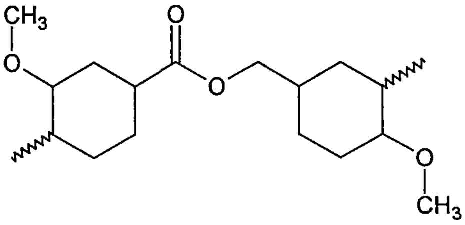
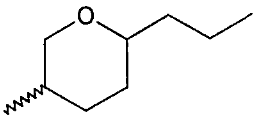
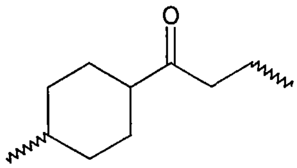

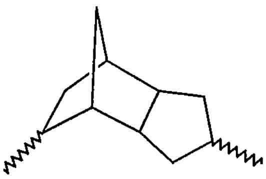
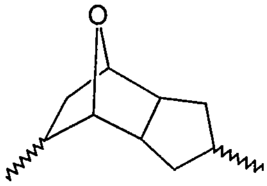

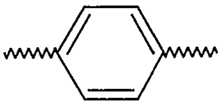
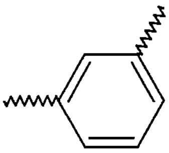
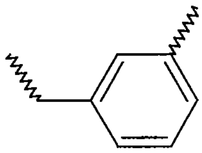

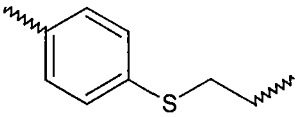
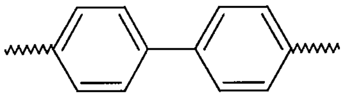
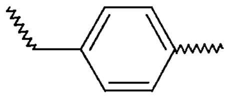

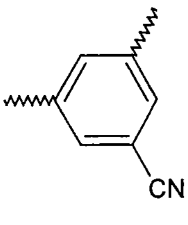
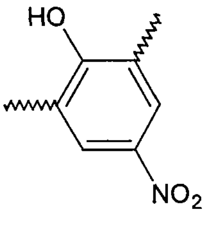
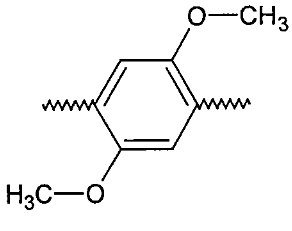
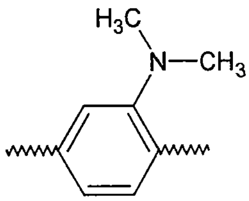

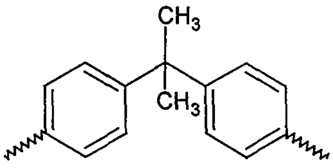 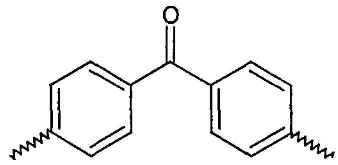 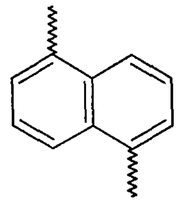

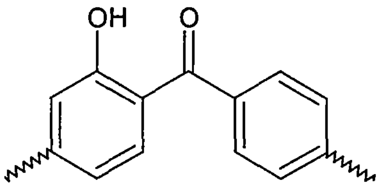 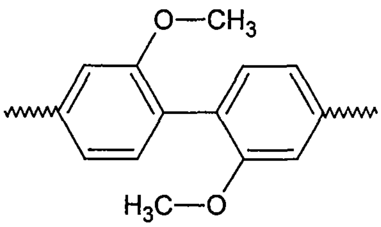

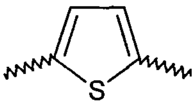 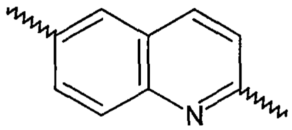 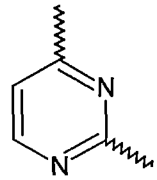

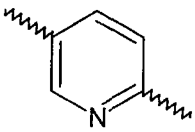 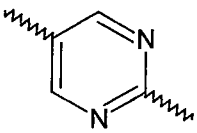 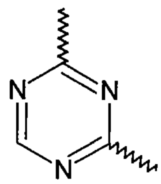 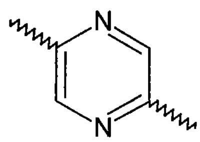

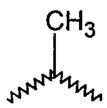 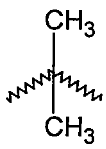 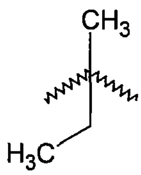 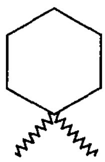 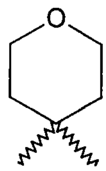

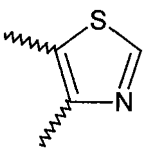 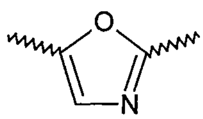 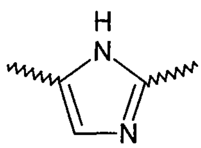 and 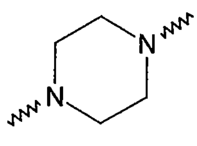

where 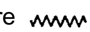 indicates the bonds between W and $Y^1$, $Y^{11}$, $Z^1$ or $Z^{11}$.

T is an organic DUV chromophore-containing substituent. T may be any substituent which contains at least one suitable DUV chromophore that absorbs radiation of selected wavelength(s) of a range from about 100 nm to about 300 run. Selected wavelengths of particular interest include, but are not limited to, imaging wavelengths such as 248 nm, 193 nm, and 157 nm. Highly conjugated moieties are generally suitable chromophores. T is a moiety containing at least one DUV chromophore selected from the group consisting of:

(a) a substituted or unsubstituted phenyl;

(b) a substituted or unsubstituted $C_3$-$C_5$ mononuclear heteroaryl containing one or more oxygen, sulfur, or nitrogen atoms including mixtures thereof;

(c) a substituted or unsubstituted $C_{10}$-$C_{30}$ polynuclear aryl;

(d) a substituted or unsubstituted $C_6$-$C_{30}$ polynuclear heteroaryl containing one or more oxygen, sulfur, or nitrogen atoms including mixtures thereof; and

(e) a nonaromatic Deep UV chromophore-containing at least one double bond conjugated with at least one electron withdrawing group.

Examples of DUV chromophore groups include, but are not limited to, substituted or unsubstituted derivatives of aryl or heteroaryl groups, such as phenyl, biphenyl, naphthyl, furanyl, thienyl, anthracyl, phenanthryl, acridine, benzoylphenyl, and quinolinyl. Examples of suitable non-aromatic Deep UV chromophores containing at least one double bond conjugated with at least one electron withdrawing group are described in U.S. Pat. No. 7,132,216. Preferred examples of DUV chromophore groups include, but are not limited to, phenyl, biphenyl, 2-mercaptophenyl, benzoylphenyl and various nonaromatic Deep UV chromophores containing at least one double bond conjugated with at least one electron withdrawing group. The more preferred examples of DUV chromophore groups include, but are not limited to, phenyl, biphenyl, 2- mercaptophenyl, benzoylphenyl, 2,4-hexadienoate, and butendioate. It is to be understood that one or more of the DUV chromophores may be chemically modified at various points within their structure while retaining or even improving their radiation-absorbing properties.

Each T group may be the same or different. The choice of the appropriate number and nature of T group(s) will vary depending on the absorbance wavelength(s) of interest and the particular application. In addition, T may possess certain structural units and/or contain functional groups suitable to facilitate crosslinking reactions of the antireflective composition, e.g., by electrophilic aromatic substitution.

Examples of the phenyl, polynuclear aryl, and heteroaryl types of T include, but are not limited to, the structures shown below,

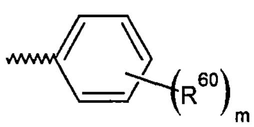
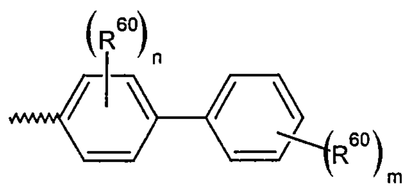
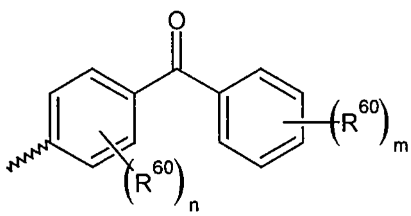
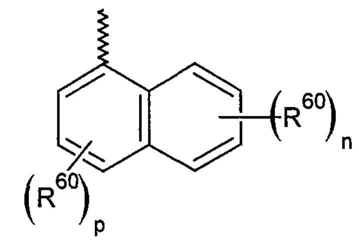
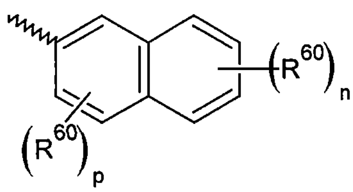
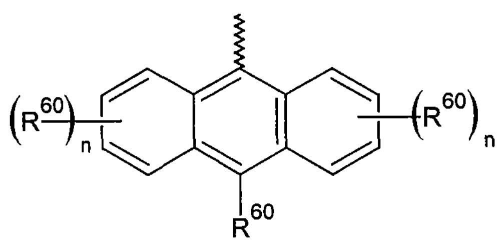
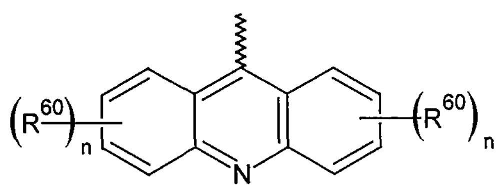
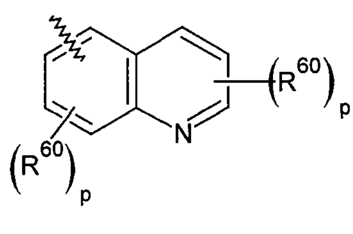
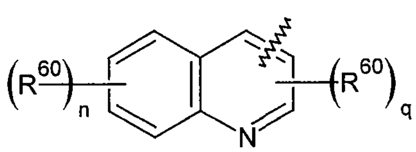

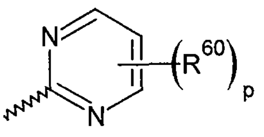
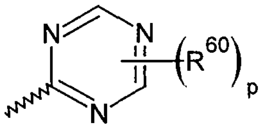
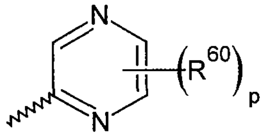

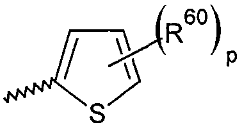
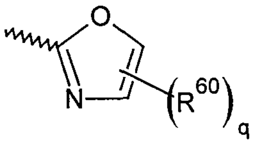
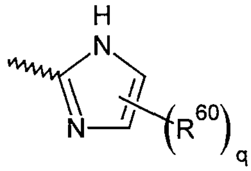

where  indicates the bond between T and $U^{11}$ or $Z^{11}$ and where m = 1-5; n = 1-4; p = 1-3; q = 1-2; and $R^{60}$ may be independently selected from the group consisting of:

(a) a hydrogen atom;
(b) a substituted or unsubstituted linear, branched, or cyclic $C_1$-$C_6$ alkyl group;
(c) a nitro group;
(d) a cyano group;
(e) ($-OR^{61}$) where $R^{61}$ is a hydrogen atom, a substituted or unsubstituted $C_1$-$C_6$ linear, branched, or cyclic alkyl or a phenyl group;
(f) ($-SR^{62}$) where $R^{62}$ is a hydrogen atom, a substituted or unsubstituted $C_1$-$C_6$ linear, branched, or cyclic alkyl or a phenyl group;
(g) ($-NR^{63}R^{64}$) where $R^{63}$ and $R^{64}$ are, independently, a hydrogen atom, a substituted or unsubstituted $C_1$-$C_6$ linear, branched, or cyclic alkyl, or a phenyl group;
(h) [$-C(=O)R^{65}$] where $R^{65}$ is a hydrogen atom, a substituted or unsubstituted $C_1$-$C_6$ linear, branched, or cyclic alkyl or a phenyl group;
(i) [$-C(=O)OR^{66}$] where $R^{66}$ is a hydrogen atom, a substituted or unsubstituted $C_1$-$C_6$ linear, branched, or cyclic alkyl or a phenyl group;
(j) [$-OC(=O)R^{67}$] where $R^{67}$ is a hydrogen atom, a substituted or unsubstituted $C_1$-$C_6$ linear, branched, or cyclic alkyl or a phenyl group;
(k) [$-C(=O)NR^{68}R^{69}$] where $R^{68}$ and $R^{69}$ are, independently, a hydrogen atom, a substituted or unsubstituted $C_1$-$C_6$ linear, branched, or cyclic alkyl, or a phenyl group; and
(l) [$-SC(=O)R^{70}$] where $R^{70}$ is a hydrogen atom, a substituted or unsubstituted $C_1$-$C_6$ linear, branched, or cyclic alkyl or a phenyl group.

Examples of T with nonaromatic chromophores include, but are not limited to the following groups.

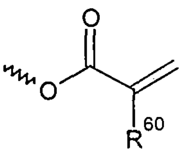
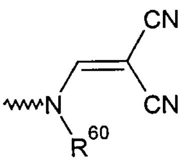
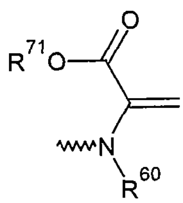
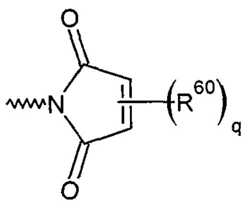

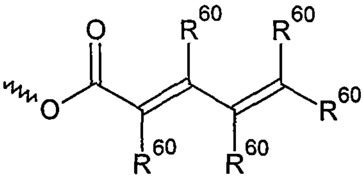
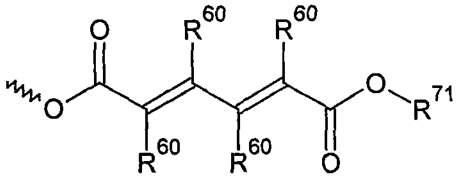

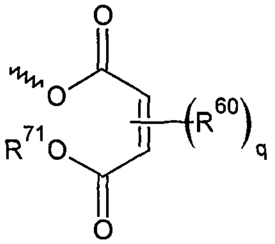
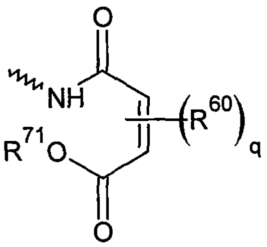
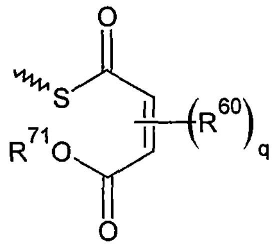

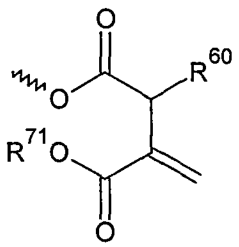
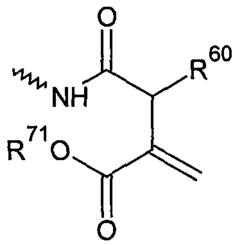
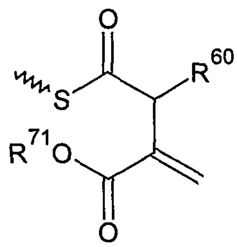

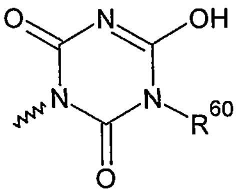
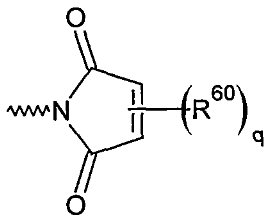

where ∿∿∿ indicates the bond between T and $U^{11}$ or $Z^{11}$, where q and $R^{60}$ are as defined previously and wherein $R^{71}$ is a substituted or unsubstituted $C_1$-$C_6$ alkyl.

The absorbance of the NPCB at the exposure wavelengths is tuned by controlling the nature of both W and T. It should be noted that the absorbance of a given NPCB may be different at different wavelengths, requiring the optimization of the NPCB for a particular wavelength of interest. The choice of both W and T must be optimized for several key parameters in addition to absorbance, including, but not limited to, substrate adhesion, solubility, coating quality, crosslinking efficiency, and plasma etch selectivity between the photoresist film and the B.A.R.C.. Often the choice of the appropriate W and/or T is complicated because enhancement of one desired property will be accompanied by an unwanted deterioration in another. For example, when W possesses an arylene or heteroarylene structure, the antireflective capability of the NPCB will be improved but other properties such as crosslinking efficiency and plasma etch selectivity of the antireflective composition may be negatively impacted.

Where aperture fill compositions are employed with an antireflective coating, it is preferred that the total absorbance of the aperture fill compositions at the wavelength of photoresist exposure be significantly less than that of a bottom antireflective coating. In addition, it is preferred that the plasma etch resistance of the aperture fill composition be low. It is thus preferred that Φ be predominantly a in the binder for this application. However, mixtures of ə and T in the binder may be employed to optimize optical or other properties.

As stated above, a key role of the NPB is to react with a crosslinking agent to form a semiconductor coating (e.g. a aperture fill or antireflective coating) that is substantially insoluble in the photoresist (or antireflective coating) casting solvent. This is critical to insure that there is no intermixing between the coating and the photoresist, which could degrade the imaged pattern or between an aperture fill coating and an antireflective coating. The functional groups or sites which are reactive in a crosslinking reaction may be incorporated in or attached to one or more of Q, W, and Φ. Together Q, W, and Φ must contain at least two functional groups or sites which are reactive in said crosslinking reaction. Unreacted X and $Y^{11}$ groups may fulfill this requirement, but other substituent groups or sites may also facilitate the crosslinking reaction. The specific type of crosslinking reaction that occurs will depend on the nature of the NPB employed in the semiconductor coating composition. For example, an NPCB containing an activated aromatic ring, such as a phenol, may react via an electrophilic aromatic substitution reaction with an electrophilic crosslinking agent to crosslink the antireflective film. Alternately, an NPCB which contains sulfhydryl groups may undergo crosslinking with crosslinking agents which contain either multiple epoxy, alkenyl, or sulfhydryl groups through various reaction mechanisms. As will become evident (vide infra) in the description of the synthetic approaches to structures of formulas (A) and ($A^0$)), (B), and ($B^0$)) some of the produced materials may be mixtures of suitable compounds. The criteria for having at least two

groups or sites which are reactive in said crosslinking can be considered to be met by mixtures having an average of two such groups or sites. It is preferred that at least three such groups or sites are present in order to maximize the number of individual molecules having at least two crosslinking groups.

The NPBs (including NPCBs) of the present disclosure may be prepared through a variety of chemical reactions including, but not limited to, addition reactions, substitution reactions, and metathesis reactions. The chemical reactions used to link the core, the bridging groups, and substituents may or may not require a catalyst. Depending on the reaction, suitable catalysts include, but are not limited to, acid catalysts, base catalysts, and metal-containing catalysts. The NPBs may be prepared by either convergent or divergent chemical synthetic pathways. One skilled in the art will be able to determine the appropriate reactions, catalysts (if necessary), and synthetic pathways to construct NPBs of the present disclosure. The preparation approaches to NPCBs are discussed below. The approaches are described using T, but equally apply to all NPB binders including those containing a (and thus apply to all NPB binders containing $\Phi$).

The key components of the NPCB (Q, W, and T) may be linked through three distinct approaches. First, Q may be connected to the chromophore-containing group T through formation of the divalent linking group $Z^{11}$. Here, $Z^{11}$ is derived from the reaction of X with $U^{11}$, a reactive functional group attached to T according to Eq. (1). The product of Eq. (1) is therefore an example of (A) in which c, and d are zero.

$$Q(X)_{(a+b)} + a\ U^{11}\text{-T} \rightarrow (X)_b Q(Z^{11}\text{-T})_a \qquad \text{Eq. (1)}$$

In the second approach, Q may first be connected to the bridging group W by formation of the divalent linking group $Z^1$. $Z^1$ is derived from the reaction of X with $Y^1$, a reactive functional group attached to the bridging group W according to Eq. (2).

$$Q(X)_{(a+b+c)} + (a+c)\ Y^1\text{-W-}Y^{11} \rightarrow (X)_b Q(Z^1\text{-W-}Y^{11})_{(a+c)} \qquad \text{Eq. (2)}$$

Once Q and W are connected, the chromophore-containing group T can then be linked to W through a divalent linking group $Z^{11}$. In this approach, $Z^{11}$ is derived from the reaction of $U^{11}$ with $Y^{11}$, a second reactive functional group attached to the bridging group W according to Eq. (3).

$$(X)_b Q(Z^1\text{-W-}Y^{11})_{(a+c)} + (a+c)\ U^{11}\text{-T} \rightarrow (X)_b Q(Z^1\text{-W-}Z^{11}\text{-T})_{(a+c)} \qquad \text{Eq. (3)}$$

The product of Eq. (3) is an example where complete reaction of the $Y^{11}$ groups has occurred. When less than complete reaction of $Y^{11}$ takes place, an NPCB is formed according to Eq. (4), producing an example of (A), where d = 1 and c does not equal

$$(X)_b Q(Z^1\text{-W-}Y^{11})_{(a+c)} + a\ U^{11}\text{-T} \longrightarrow (X)_b Q \begin{cases} (Z^1\text{-W-}Z^{11}\text{-T})_a \\ (Z^1\text{-W-}Y^{11})_c \end{cases} \qquad \text{(Eq. 4)}$$

A third synthetic approach may be employed in which W is first connected to the chromophore-containing group T through $Z^{11}$ according to Eq. (5). Next, this material may be linked to Q through $Z^1$ according to Eq. (6). In this approach $c = 0$.

$$Y^1\text{-W-}Y^{11} + U^{11}\text{-T} \rightarrow Y^1\text{-W-}Z^{11}\text{-T} \qquad \text{Eq. (5)}$$

$$Q(X)_{(a+b)} + a\ Y^1\text{-W-}Z^{11}\text{-T} \rightarrow (X)_b Q(Z^1\text{-W-}Z^{11}\text{-T})_a \qquad \text{Eq. (6)}$$

A variation of this approach can be employed to produce NPCBs in which some T groups are connected directly to Q through $Z^{11}$ and others are indirectly connected through the additional $Z^1$W moiety (Eq. 7). If *e* equivalents of $Y^1$-W-$Z^{11}$-T are reacted with $Q(X)_{(a+b)}$ as in Eq. 6 and/equivalents of $U^{11}$-T are subsequently reacted, then the product in Eq. 7 is formed ($c = 0$, $a = e+f$).

$$(X)_{(a+b-e)}Q(Z^1\text{-W-}Z^{11}\text{-T})_e + f\,U^{11}\text{-T} \rightarrow (X)_bQ(Z^1\text{-W-}Z^{11}\text{-T})_e(Z^{11}T)_f \qquad \text{Eq. (7)}$$

Relative to (A), this corresponds basically to the situation where *c* = 0, and *a* is split into two portions; one in which *d* = 1 (*e*) and one in which *d* = 0 (*f*) in the same molecule.

Any of the products of Equations 1, 2, 3, 4, 6, and 7 may be modified by reaction with $Y^1$-W-$Y^{11}$ to produce (additional) $Z^1$-W-$Y^{11}$ substituents, where W may be the same or different if the previous product contained a W moiety, as long as there are unreacted X groups. An alternative approach to a mixture of W groups is to employ a mixture of $Y^1$-W-$Y^{11}$ compounds with different W groups.

In this manner, binders of structure (A) or ($A^0$) can be constructed to optimize materials having required levels of optical properties, plasma etch rates, reactivity to crosslinking, and other properties.

$Z^1$ and $Z^{11}$ are divalent linking groups with each individual $Z^1$ and $Z^{11}$ being independently selected. These divalent linking groups are prepared from the reaction of reactive substitutents on Q, W, and T. $Z^1$ linking groups are prepared by the reaction of X with $Y^1$ of a reagent $Y^1$-W-$Y^{11}$ or $Y^1$-W-$Z^{11}$-T. $Z^{11}$ linking groups are prepared by the reaction of X or $Y^{11}$ of a -W-$Y^{11}$ compound with $U^{11}$ of a $U^{11}$-T compound.

$Y^1$, $Y^{11}$, and $U^{11}$ are independently selected and comprise functional groups that facilitate linking reactions so as to link the specified units. The reactive functional groups $Y^1$, $Y^{11}$, and $U^{11}$ are selected from the group consisting of hydroxyl, sulfhydryl, primary or secondary amino, alkenyl, allyl ether, vinyl ether, (meth)acryl, halogen, sulfonate, carboxyl, carboxyl ester, carboxyl anhydride, and carboxyl acid halide.

Preferably $Y^1$, $Y^{11}$, and $U^{11}$ are selected from the group consisting of hydroxyl, sulfhydryl, primary or secondary amino, alkenyl, allyl ether, vinyl ether, (meth)acryl, halogen, sulfonate, carboxyl, carboxyl anhydride and carboxyl acid halide.

More preferably $Y^1$, $Y^{11}$, and $U^{11}$ are selected from the group consisting of hydroxyl, sulfhydryl, primary or secondary amino, alkenyl, allyl ether, (meth)acryl and carboxyl.

Most preferably $Y^1$, $Y^{11}$, and $U^{11}$ are selected from the group consisting of hydroxyl, sulfhydryl, primary or secondary amino, alkenyl, (meth)acryl and carboxyl.

$Z^1$ and $Z^{11}$ are divalent linking groups with each individual $Z^1$ and $Z^{11}$ being independently selected. Examples of suitable divalent linking groups $Z^1$ and $Z^{11}$ include, but are not limited to:

(a) [-C(=O)O-];
(b) [-OC(=O)-];
(c) [-C(=O)N$R^1$-] where $R^1$ is a hydrogen atom or a substituted or unsubstituted $C_1$-$C_6$ linear or branched alkyl;
(d) [-N$R^2$C(=O)-] where $R^2$ is a hydrogen atom or a substituted or unsubstituted $C_1$-$C_6$ linear or branched alkyl;
(e) [-C(=O)S-];
(f) [-SC(=O)-];
(g) [-SCH($R^7$)CH($R^8$)-] where $R^7$ and $R^8$ are, independently, a hydrogen atom or a substituted or unsubstituted $C_1$-$C_6$ linear or branched alkyl;
(h) [-CH($R^9$)CH($R^{10}$)S-] where $R^9$ and $R^{10}$ are, independently, a hydrogen atom or a substituted or unsubstituted $C_1$-$C_6$ linear or branched alkyl;
(i) [-SCH($R^{72}$)CH($R^{73}$)C(=O)O-] where $R^{72}$ and $R^{73}$ are, independently, a hydrogen atom or a substituted or unsubstituted $C_1$-$C_6$ linear or branched alkyl;
(j) [-OC(=O)CH($R^{74}$)CH($R^{75}$)S-] where $R^{74}$ and $R^{75}$ are, independently, a hydrogen atom or a substituted or unsubstituted $C_1$-$C_6$ linear or branched alkyl;
(k) [-$SCH_2$CH($R^{76}$)CH($R^{77}$)O-] where $R^{76}$ and $R^{77}$ are, independently, a hydrogen atom or a substituted or unsubstituted $C_1$-$C_6$ linear or branched alkyl;
(l) [-OCH($R^{78}$)CH($R^{79}$)$CH_2$S-] where $R^{78}$ and $R^{79}$ are, independently, a hydrogen atom or a substituted or unsubstituted $C_1$-$C_6$ linear or branched alkyl;
(m) [-$SCH_2$CH($R^{80}$)O-] where $R^{80}$ is a hydrogen atom or a substituted or unsubstituted $C_1$-$C_6$ linear or branched alkyl;
(n) [-OCH($R^{81}$)$CH_2$S-] where $R^{81}$ is a hydrogen atom or a substituted or unsubstituted $C_1$-$C_6$ linear or branched alkyl;
(o) [-C(=O)$OCH_2$CH($R^{12}$)O-] where $R^{82}$ is a hydrogen atom or a substituted or unsubstituted $C_1$-$C_6$ linear or branched alkyl;
(p) [-OCH($R^{83}$)$CH_2$OC(=O)-] where $R^{83}$ is a hydrogen atom or a substituted or unsubstituted $C_1$-$C_6$ linear or branched alkyl;
(q) (-0-);
(r) (-S-);
(s) (-S-S-);
(t) (-N$R^{19}$-) where $R^{19}$ is a hydrogen atom or a substituted or unsubstituted $C_1$-$C_6$ linear or branched alkyl;
(u) [-($R^3$)C=C($R^4$)-] where $R^3$ and $R^4$ are, independently, a hydrogen atom or a substituted or unsubstituted $C_1$-$C_6$

linear or branched alkyl; and,
(v) [-CH($R^S$)CH($R^6$)-] where $R^5$ and $R^6$ are, independently, a hydrogen atom or a substituted or unsubstituted $C_1$-$C_6$ linear or branched alkyl.

Preferred examples of $Z^1$ and $Z^{11}$ include, but are not limited to,

(a) [-C(=O)O-];
(b) [-OC(=O)-];
(c) [-C(=O)N$R^1$-] where $R^1$ is a hydrogen atom or a substituted or unsubstituted $C_1$-$C_6$ linear or branched alkyl;
(d) [-N$R^2$C(=O)-] where $R^2$ is a hydrogen atom or a substituted or unsubstituted $C_1$-$C_6$ linear or branched alkyl;
(e) [-C(=O)S-];
(f) [-SC(=O)-];
(g) [-SCH($R^7$)CH($R^8$)-] where $R^7$ and $R^8$ are, independently, a hydrogen atom or a substituted or unsubstituted $C_1$-$C_6$ linear or branched alkyl;
(h) [-CH($R^9$)CH($R^{10}$)S-] where $R^9$ and $R^{10}$ are, independently, a hydrogen atom or a substituted or unsubstituted $C_1$-$C_6$ linear or branched alkyl;
(i) [-SCH($R^{72}$)CH($R^{73}$)C(=O)O-] where $R^{72}$ and $R^{73}$ are, independently, a hydrogen atom or a substituted or unsubstituted $C_1$-$C_6$ linear or branched alkyl;
(j) [-OC(=O)CH($R^{74}$)CH($R^{75}$)S-] where $R^{74}$ and $R^{75}$ are, independently, a hydrogen atom or a substituted or unsubstituted $C_1$-$C_6$ linear or branched alkyl;
(k) [-$SCH_2$CH($R^{76}$)CH($R^{77}$)O-] where $R^{76}$ and $R^{77}$ are, independently, a hydrogen atom or a substituted or unsubstituted $C_1$-$C_6$ linear or branched alkyl;
(l) [-OCH($R^{78}$)CH($R^{79}$)$CH_2$S-] where $R^{78}$ and $R^{79}$ are, independently, a hydrogen atom or a substituted or unsubstituted $C_1$-$C_6$ linear or branched alkyl;
(m) [-$SCH_2$CH($R^{80}$)O-] where $R^{80}$ is a hydrogen atom or a substituted or unsubstituted $C_1$-$C_6$ linear or branched alkyl;
(n) [-OCH($R^{81}$)$CH_2$S-] where $R^{81}$ is a hydrogen atom or a substituted or unsubstituted $C_1$-$C_6$ linear or branched alkyl;
(o) [-C(=O)O$CH_2$CH($R^{82}$)O-] where $R^{82}$ is a hydrogen atom or a substituted or unsubstituted $C_1$-$C_6$ linear or branched alkyl;
(p) [-OCH($R^{83}$)$CH_2$OC(=O)-] where $R^{83}$ is a hydrogen atom or a substituted or unsubstituted $C_1$-$C_6$ linear or branched alkyl;
(q) (-O-);
(r) (-S-);
(s) (-S-S-); and,
(t) (-N$R^{19}$-) where $R^{19}$ is a hydrogen atom or a substituted or unsubstituted $C_1$-$C_6$ linear or branched alkyl.

More preferred examples of $Z^1$ and $Z^{11}$ include, but are not limited to,

(a) [-C(=O)O-];
(b) [-OC(=O)-];
(c) [-C(=O)N$R^1$-] where $R^1$ is a hydrogen atom or a substituted or unsubstituted $C_1$-$C_6$ linear or branched alkyl;
(d) [-N$R^2$C(=O)-] where $R^2$ is a hydrogen atom or a substituted or unsubstituted $C_1$-$C_6$ linear or branched alkyl;
(e) [-C(=O)S-];
(f) [-SC(=O)-];
(g) [-SCH($R^7$)CH($R^8$)-] where $R^7$ and $R^8$ are, independently, a hydrogen atom or a substituted or unsubstituted $C_1$-$C_6$ linear or branched alkyl;
(h) [-CH($R^9$)CH($R^{10}$)S-] where $R^9$ and $R^{10}$ are, independently, a hydrogen atom or a substituted or unsubstituted $C_1$-$C_6$ linear or branched alkyl;
(i) [-SCH($R^{72}$)CH($R^{73}$)C(=O)O-] where $R^{72}$ and $R^{73}$ are, independently, a hydrogen atom or a substituted or unsubstituted $C_1$-$C_6$ linear or branched alkyl;
(j) [-OC(=O)CH($R^{74}$)CH($R^{75}$)S-] where $R^{74}$ and $R^{75}$ are, independently, a hydrogen atom or a substituted or unsubstituted $C_1$-$C_6$ linear or branched alkyl;
(k) [-$SCH_2$CH($R^{76}$)CH($R^{77}$)O-] where $R^{76}$ and $R^{77}$ are, independently, a hydrogen atom or a substituted or unsubstituted $C_1$-$C_6$ linear or branched alkyl; and,
(l) [-OCH($R^{78}$)CH($R^{79}$)$CH_2$S-] where $R^{78}$ and $R^{79}$ are, independently, a hydrogen atom or a substituted or unsubstituted $C_1$-$C_6$ linear or branched alkyl.

The most preferred examples of $Z^1$ and $Z^{11}$ include, but are not limited to,

(a) [-C(=O)O-];
(b) [-OC(=O)-];
(c) [-C(=O)NR$^1$-] where $R^1$ is a hydrogen atom or a substituted or unsubstituted $C_1$-$C_6$ linear or branched alkyl;
(d) [-NR$^2$C(=O)-] where $R^2$ is a hydrogen atom or a substituted or unsubstituted $C_1$-$C_6$ linear or branched alkyl;
(e) [-C(=O)S-];
(f) [-SC(=O)-];
(g) [-SCH(R$^7$)CH(R$^8$)-] where $R^7$ and $R^8$ are, independently, a hydrogen atom or a substituted or unsubstituted $C_1$-$C_6$ linear or branched alkyl;
(h) [-CH(R$^9$)CH(R$^{10}$)S-] where $R^9$ and $R^{10}$ are, independently, a hydrogen atom or a substituted or unsubstituted $C_1$-$C_6$ linear or branched alkyl;
(i) [-SCH(R$^{72}$)CH(R$^{73}$)C(=O)O-] where $R^{72}$ and $R^{73}$ are, independently, a hydrogen atom or a substituted or unsubstituted $C_1$-$C_6$ linear or branched alkyl; and,
(j) [-OC(=O)CH(R$^{74}$)CH(R$^{75}$)S-] where $R^{74}$ and $R^{75}$ are, independently, a hydrogen atom or a substituted or unsubstituted $C_1$-$C_6$ linear or branched alkyl.

Examples of structures of formula ($A^0$) include, but are not limited to the following compounds and those compounds shown for (A) below.

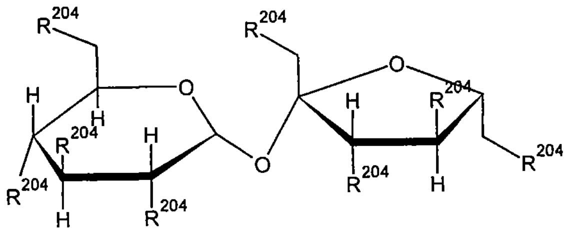

$R^{204}$ = 63%

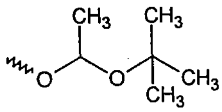

37% OH

($A^0$-1)

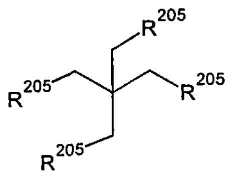

$R^{205}$ = 75%

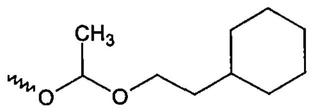

25% OH

($A^0$-2)

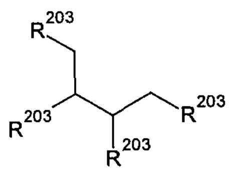

$R^{203}$ = 50%

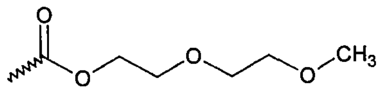

50%

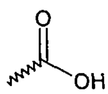

($A^0$-3)

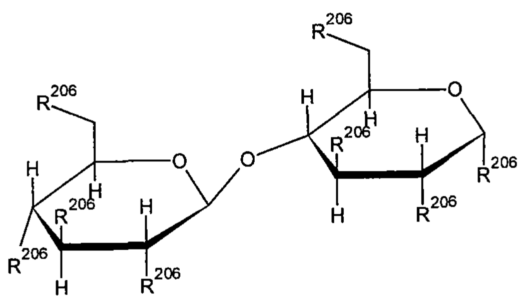

$R^{206}$ = 25%

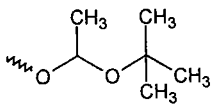

50% OH

25%

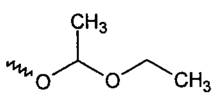

($A^0$-4)

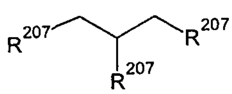

$R^{207}$ = 67%

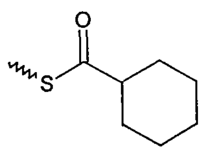

33% SH

($A^0$-5)

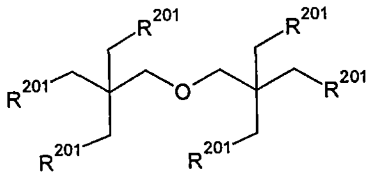

$R^{201}$ = 83%

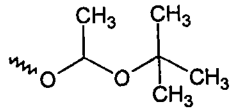

17% OH

($A^0$-6)

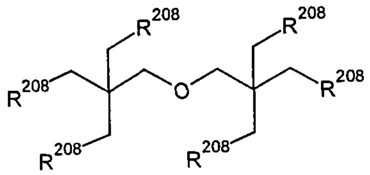

$R^{208}$ = 67%

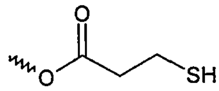

33% OH

($A^0$-7)

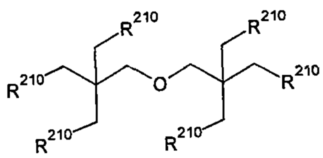

$R^{210}$ = 33%

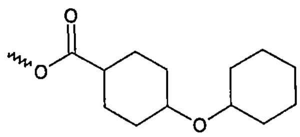

33%

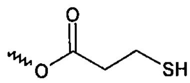

33% OH

($A^0$-8)

($A^0$-9)

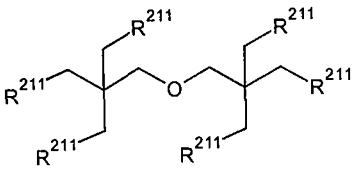

$R^{211}$ = 66%

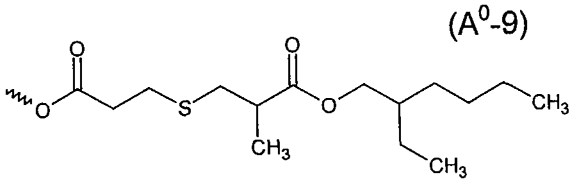

17%

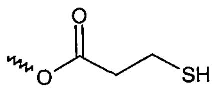

17% OH

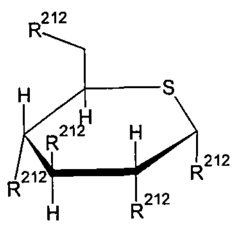

$R^{212}$ = 83%

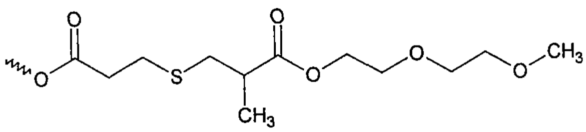

17% OH

($A^0$-10)

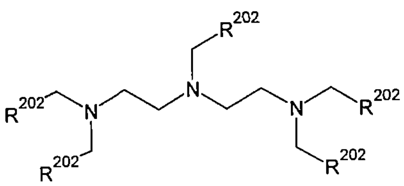

$R^{202}$ = 60%

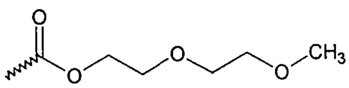

40%

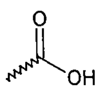

($A^0$-11)

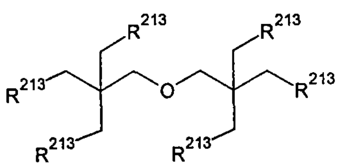

$R^{213}$ = 50%

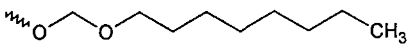

50% OH

($A^0$-12)

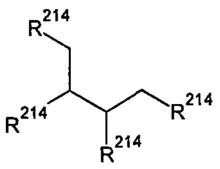

$R^{214}$ = 50%

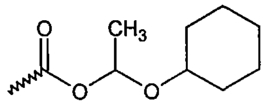

50%

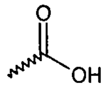

($A^0$-13)

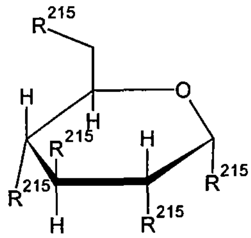

$R^{215}$ = 40%

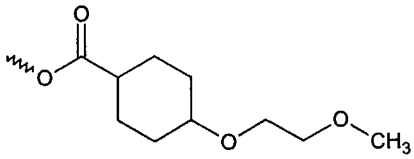

60% OH

($A^0$-14)

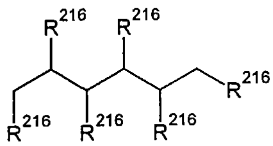

$R^{216}$ = 80%

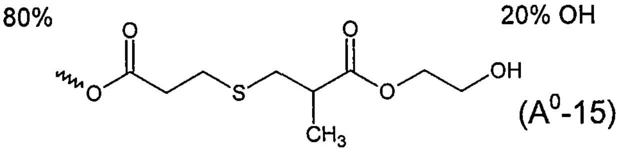

20% OH

($A^0$-15)

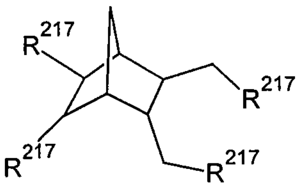

$R^{217}$ =

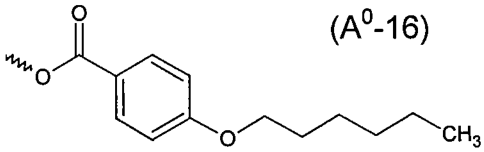

($A^0$-16)

($A^0$-17)

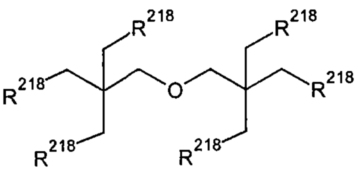

$R^{218}$ = 33%

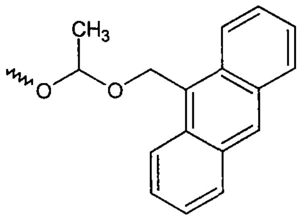

33%

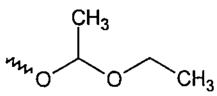

33% OH

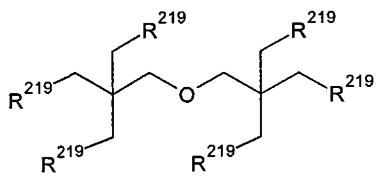

$R^{219}$ = 83%

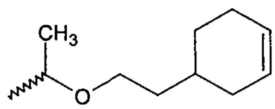

17% OH

($A^0$-18)

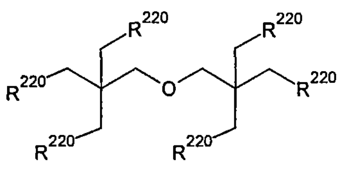

$R^{220}$ = 50%

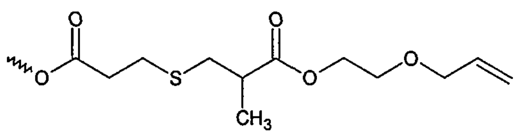

17% OH

33%

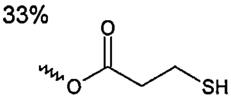

($A^0$-19)

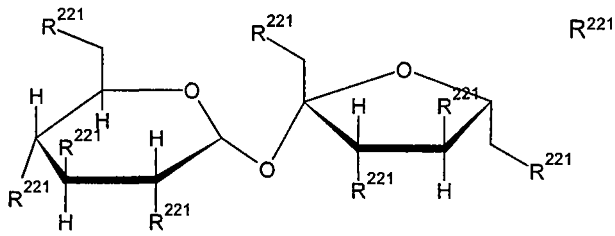

$R^{221}$ = 50%

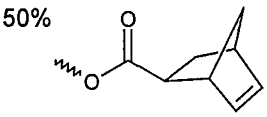

50% OH

($A^0$-20)

($A^0$-21)

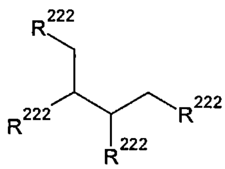

$R^{222}$ =

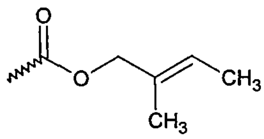

Examples of structures of formula (A) include, but are not limited to the following compounds:

(A-30)

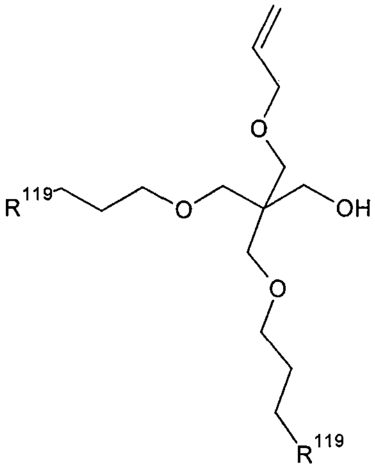

$R^{119}$ =

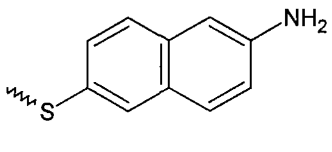

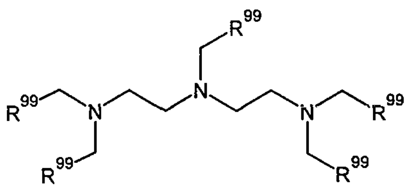

$R^{99}$ = 60%

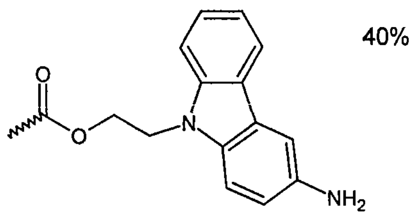

40%

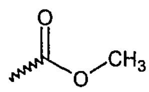

(A-31)

$R^{104}$ = 50%

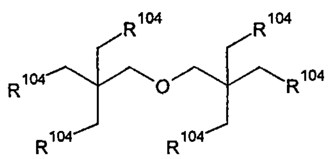

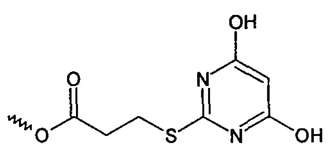

50%

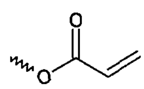

(A-32)

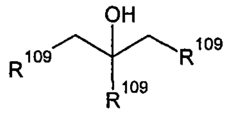

$R^{109}$ =

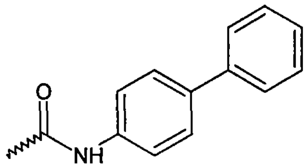

(A-33)

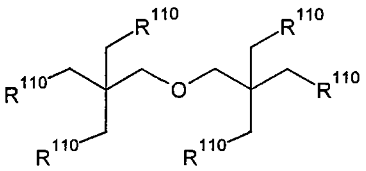

$R^{110}$ = 33%

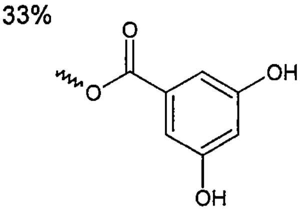

33%

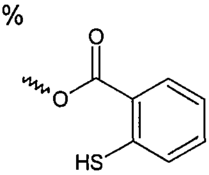

33% OH

(A-34)

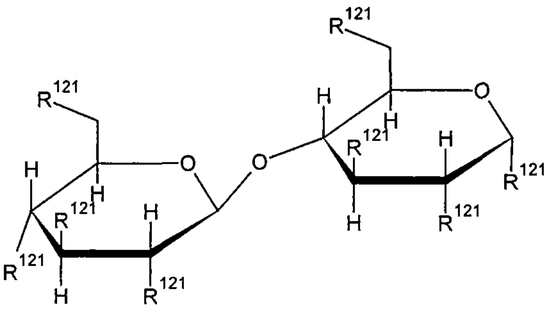

$R^{121}$ = 50%

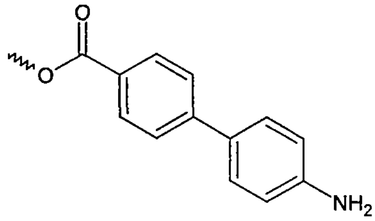

50% OH

(A-35)

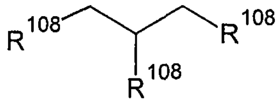

$R^{108}$ =

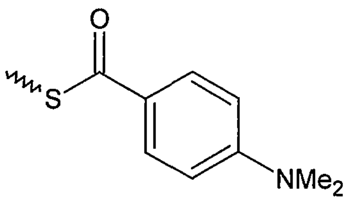

(A-36)

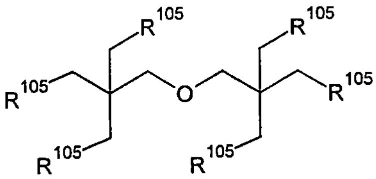

$R^{105}$ = 50%

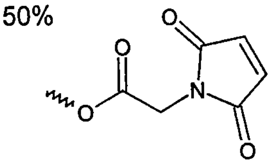

33%

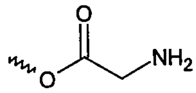

17% OH

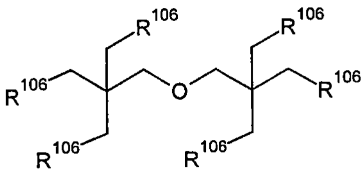

$R^{106}$ = 66%

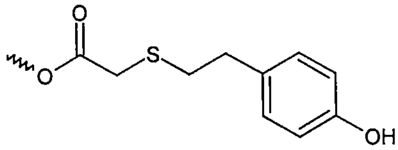

17% OH

17%

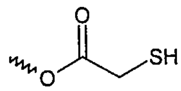

(A-38)

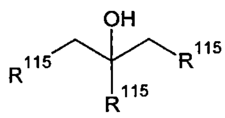

$R^{115}$ =

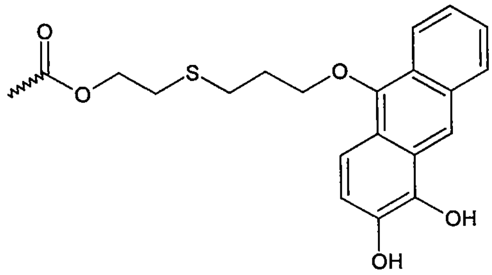

(A-39)

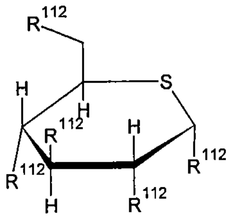

$R^{112}$ = 60%

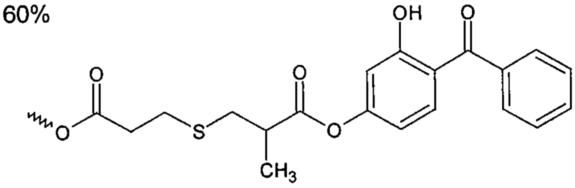

40%

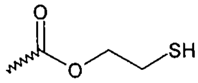

(A-40)

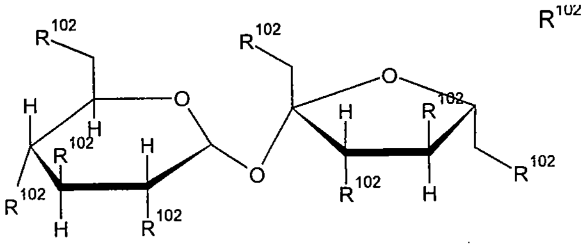

$R^{102}$ = 38%

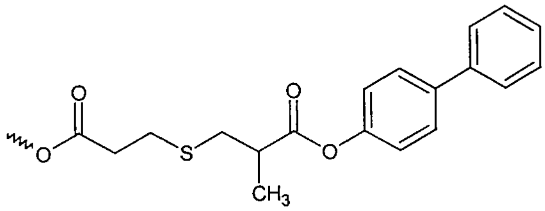

(A-41)

25%

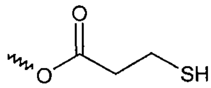

37% OH

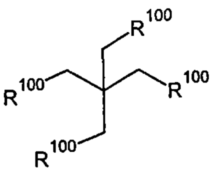

$R^{100}$ = 50%

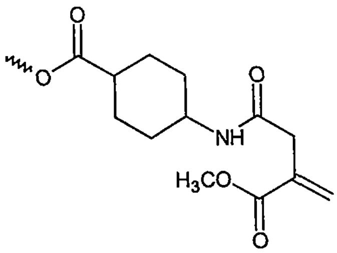

50%

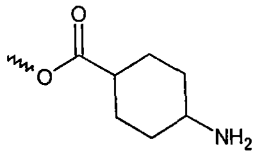

(A-42)

(A-43)

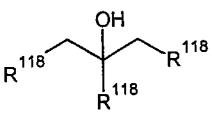

$R^{118}$ = 34%

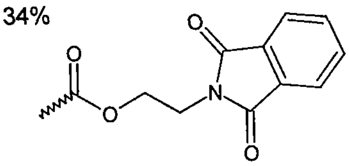

66%

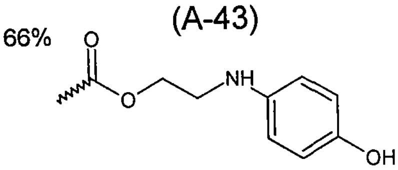

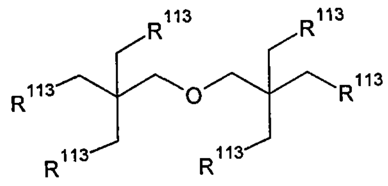

$R^{113}$ = 50%

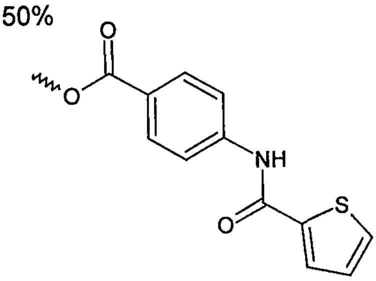

50%

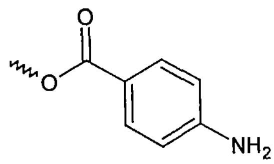

(A-44)

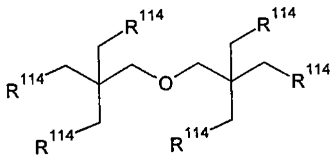

$R^{114}$ = 50%

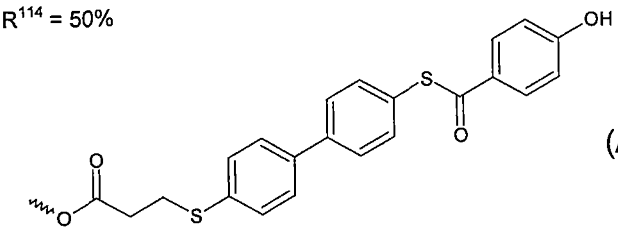

50%

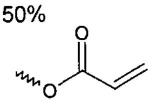

(A-45)

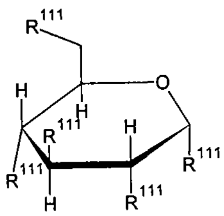

$R^{111}$ = 60%

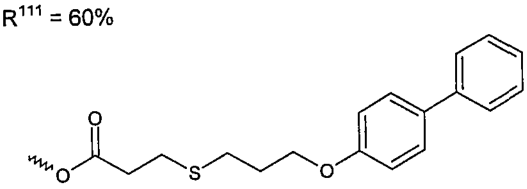

20%

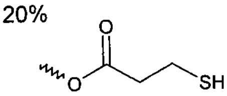

20% OH

(A-46)

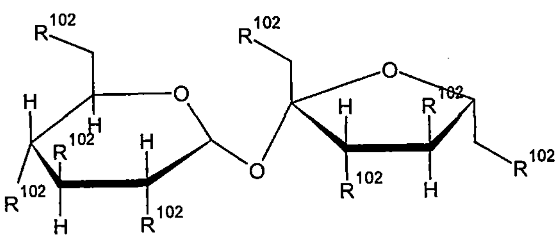

$R^{102}$ = 63%

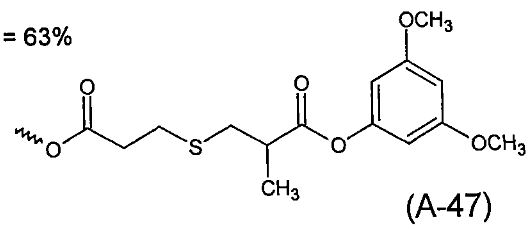

(A-47)

12%

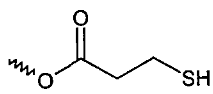

25% OH

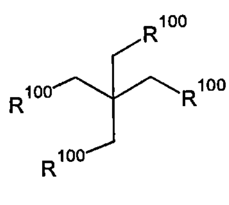

$R^{100}$ =

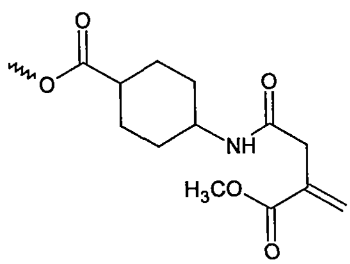

(A-48)

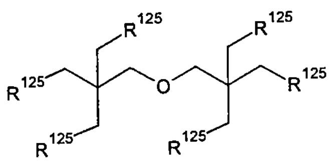 $R^{125}$ = 67% 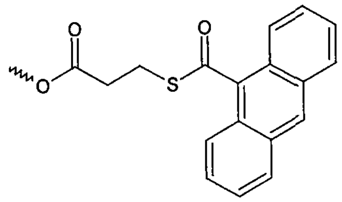 33% 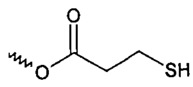

(A-49)

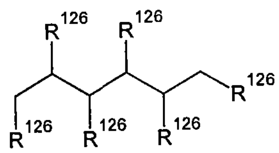 $R^{126}$ = 80% 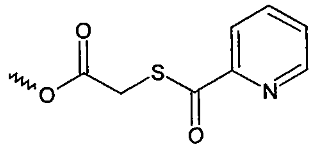 20% OH

(A-50)

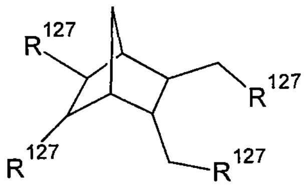 $R^{127}$ = 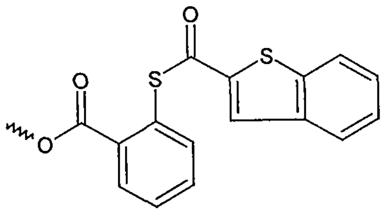

(A-51)

In one embodiment of the disclosure the at least one NPCB in the antireflective compositions is represented by formula (D):

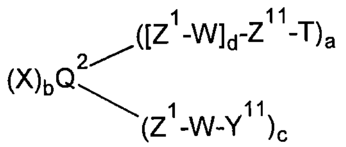

(D)

where X, $Z^1$, $Z^{11}$, $Y^{11}$, W, T, *b, c,* and *d* are as described above and $Q^2$ is a multivalent organic nucleus consisting of an unsubstituted $C_2$-$C_{40}$ linear, branched, cyclic, or polycyclic aliphatic group not containing as an integral part of a ring or chain structure oxygen, sulfur, or nitrogen atoms, and *a* ranges from about 2 to about 15.

Preferably, $Q^2$ is a multivalent organic nucleus consisting of an unsubstituted $C_3$-$C_{24}$ linear, branched, or cyclic aliphatic group not containing as an integral part of a ring or chain structure oxygen, sulfur, or nitrogen atoms, and *a* ranges from about 3 to about 12.

More preferably, $Q^2$ is a multivalent organic nucleus consisting of an unsubstituted $C_4$-$C_{20}$ linear, or branched, aliphatic group not containing as an integral part of a ring or chain structure oxygen, sulfur, or nitrogen atoms, and *a* ranges from about 3 to about 10.

Most preferably, $Q^2$ is a multivalent organic nucleus consisting of an unsubstituted $C_6$-$C_{20}$ linear, or branched, aliphatic group not containing as an integral part of a ring or chain structure oxygen, sulfur, or nitrogen atoms, and *a* ranges from about 4 to about 8.

In one embodiment of the disclosure the at least one NPCB in the antireflective compositions is represented by structures of formula (E):

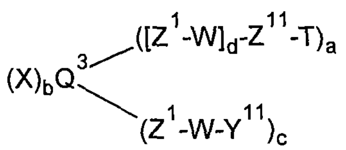

(E)

where X, $Z^1$, $Z^{11}$, $Y^{11}$, W, T, *b, c,* and *d* are as described above and $Q^3$ is a multivalent organic nucleus consisting of an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof, and *a* ranges from about 2 to about 15.

Preferably, $Q^3$ is a multivalent organic nucleus consisting of an unsubstituted $C_2$-$C_{24}$ linear, branched, or cyclic aliphatic group containing as an integral part of a ring or chain structure one or more oxygen, sulfur, or nitrogen atoms including mixtures thereof, and *a* ranges from about 3 to about 12.

More preferably, $Q^3$ is a multivalent organic nucleus consisting of an unsubstituted $C_3$-$C_{20}$ linear, or branched, aliphatic group containing as an integral part of a ring or chain structure one or more oxygen, sulfur, or nitrogen atoms including mixtures thereof, and *a* ranges from about 3 to about 10.

Most preferably, $Q^3$ is a multivalent organic nucleus consisting of an unsubstituted $C_4$-$C_{16}$ linear, or branched, aliphatic group containing as an integral part of a ring or chain structure one or more oxygen, sulfur, or nitrogen atoms including mixtures thereof, and *a* ranges from about 4 to about 8.

In one embodiment of the disclosure the at least one NPCB in the antireflective compositions is represented by structures of formula (F):

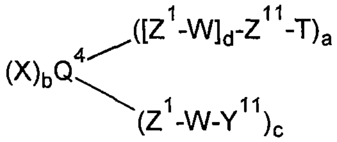

(F)

where X, $Z^1$, $Z^{11}$, $Y^{11}$, W, T, *b, c*, and *d are* as described above and $Q^4$ is an unsubstituted $C_6$-$C_{40}$ multivalent organic nucleus consisting of both cyclic and acyclic components not containing as an integral part of a ring or chain structure oxygen, sulfur, or nitrogen atoms, and *a* ranges from about 2 to about 15.

Preferably $Q^4$ is an unsubstituted $C_6$-$C_{28}$ multivalent organic nucleus consisting of both cyclic and acyclic components not containing as an integral part of a ring or chain structure oxygen, sulfur, or nitrogen atoms, and *a* ranges from about 3 to about 12.

More preferably $Q^4$ is an unsubstituted $C_7$-$C_{22}$ multivalent organic nucleus consisting of both cyclic and acyclic components not containing as an integral part of a ring or chain structure oxygen, sulfur, or nitrogen atoms, and *a* ranges from about 3 to about 10.

Most preferably $Q^4$ is an unsubstituted $C_8$-$C_{18}$ multivalent organic nucleus consisting of both cyclic and acyclic components not containing as an integral part of a ring or chain structure oxygen, sulfur, or nitrogen atoms, and *a* ranges from about 4 to about 8.

In one embodiment of the disclosure the at least one NPCB in the antireflective compositions is represented by structures of formula (G):

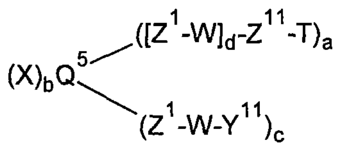

(G)

where X, $Z^1$, $Z^{11}$, $Y^{11}$, W, T, *b,* c, and *d* are as described above and $Q^5$ is an unsubstituted $C_5$-$C_{40}$ multivalent organic nucleus consisting of both cyclic and acyclic components containing as an integral part of a ring or chain structure one or more oxygen, sulfur, or nitrogen atoms including mixtures thereof, and *a* ranges from about 2 to about 15.

Preferably $Q^5$ is an unsubstituted $C_5$-$C_{24}$ multivalent organic nucleus consisting of both cyclic and acyclic components containing as an integral part of a ring or chain structure one or more oxygen, sulfur, or nitrogen atoms including mixtures thereof, and *a* ranges from about 3 to about 12.

More preferably $Q^5$ is an unsubstituted $C_6$-$C_{20}$ multivalent organic nucleus consisting of both cyclic and acyclic components containing as an integral part of a ring or chain structure one or more oxygen, sulfur, or nitrogen atoms including mixtures thereof, and *a* ranges from about 3 to about 10.

Most preferably $Q^5$ is an unsubstituted $C_6$-$C_{16}$ multivalent organic nucleus consisting of both cyclic and acyclic components containing as an integral part of a ring or chain structure one or more oxygen, sulfur, or nitrogen atoms including mixtures thereof, and *a* ranges from about 4 to about 8.

In another embodiment of the disclosure the at least one NPCB in the antireflective compositions is represented by structures of formula (H):

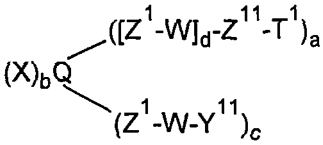

(H)

where Q, X, $Z^1$ $Z^{11}$, $Y^{11}$, W, *b, c,* and *d* are as described above and $T^1$ is independently a substituted or unsubstituted phenyl group. *a* is ranges from about 2 to about 15, preferably *a* ranges from about 3 to about 12, more preferably from about 3 to about 10 and the most preferred *a* ranges from about 4 to about 8.

In another embodiment of the disclosure the at least one NPCB in the antireflective compositions is represented by structures of formula (I):

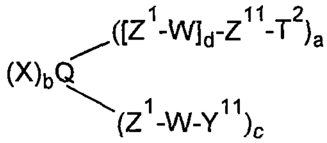

(I)

where Q, X, $Z^1$, $Z^{11}$, $Y^{11}$, W, *b, c,* and *d* are as described above and $T^2$ is independently a substituted or unsubstituted $C_3$-$C_5$ mononuclear heteroaryl containing one or more oxygen, sulfur, or nitrogen atoms including mixtures thereof. *a* ranges from about 2 to about 15, preferably *a* ranges from about 3 to about 12, more preferably from about 3 to about 10 and the most preferred *a* ranges from about 4 to about 8.

In another embodiment of the disclosure the at least one NPCB is represented by structures of formula (J):

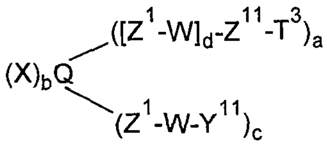

(J)

where Q, X, $Z^1$, $Z^{11}$, $Y^{11}$, W, *b, c,* and *d* are as described above and $T^3$ is independently a substituted or unsubstituted $C_{10}$-$C_{30}$ polynuclear aryl. *a* ranges from about 2 to about 15, preferably *a* ranges from about 3 to about 12, more preferably from about 3 to about 10 and the most preferred *a* ranges from about 4 to about 8.

In another embodiment of the disclosure the at least one NPCB in the antireflective compositions is represented by structures of formula (K):

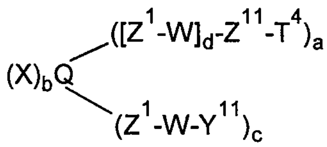

(K)

where Q, X, $Z^1$, $Z^{11}$, $Y^{11}$, W, *b, c,* and d are as described above and $T^4$ independently is a substituted or unsubstituted $C_6$-$C_{30}$ polynuclear heteroaryl containing one or more oxygen, sulfur, or nitrogen atoms including mixtures thereof. *a* ranges from about 2 to about 15, preferably *a* ranges from about 3 to about 12, more preferably from about 3 to about 10 and the most preferred *a* ranges from about 4 to about 8.

In yet another embodiment of the disclosure the at least one NPCB in the antireflective compositions is represented by structures of formula (L):

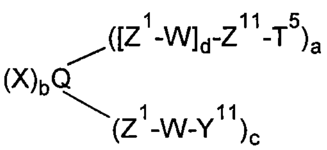

(L)

where Q, X, $Z^1$, $Z^{11}$, $Y^{11}$, W, *b, c,* and *d* are as described above and $T^5$ is independently a nonaromatic Deep UV chromophore containing at least one double bond conjugated with at least one electron withdrawing group. *a* ranges from about 2 to about 15, preferably *a* ranges from about 3 to about 12, more preferably from about 3 to about 10 and

the most preferred *a* ranges from about 4 to about 8.

In another embodiment of the disclosure the at least one NPCB in the antireflective compositions is represented by structures of formula (N):

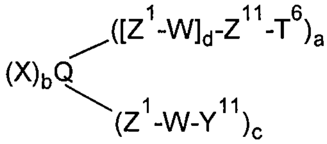

(N)

where Q, X, $Z^1$, $Z^{11}$, $Y^{11}$, W, *b, c,* and *d* are as described above and $T^6$ is a mixture of two or more DUV chromophore containing groups selected from the group consisting of $T^1$, $T^2$, $T^3$, $T^4$, and $T^5$. More preferably $T^6$ is a mixture of two DUV chromophore containing groups selected from the group consisting of $T^1$, $T^2$, $T^3$, $T^4$, and $T^5$. *a* ranges from about 2 to about 15, preferably *a* ranges from about 3 to about 12, more preferably from about 3 to about 10 and the most preferred *a* ranges from about 4 to about 8.

The semiconductor coating compositions further comprise one or more suitable crosslinking agents. Suitable crosslinking agents include, but are not limited to, compounds with two or more reactive functional groups such as, various amino or phenolic crosslinkers, epoxy compounds, compounds with multiple thiol groups, thiiranes, and / or aziridines. In addition, compounds with two or more alkenes, including (meth)acrylate groups, are also suitable crosslinking agents depending on the composition and structure of the NPB. The composition and structure of the NPB will ultimately determine the proper crosslinking agent(s) to employ in the antireflective composition. For example, when the NPB contains amino groups, crosslinking of the semiconductor coating composition film may be accomplished using a crosslinking agent containing multiple epoxide groups. An NPB containing unsaturated reactive groups (e.g., alkenes or acrylic compounds) may employ compounds with multiple thiol groups as crosslinking agents. NPB compounds having phenolic groups may employ amino or phenolic crosslinking agents.

Preferably, the composition comprises one or more amino or phenolic crosslinking agents. Any suitable amino or phenolic crosslinking agent may be used in the present application such as methylolated and/or methylolated and etherified guanamines, methylolated and/or methylolated and etherified melamines, glycolurils and the like. Examples of suitable melamine cross-linking agents are methoxyalkylmelamines such as hexamethoxymethylmelamine, trimethoxymethylmelamine, hexamethoxyethylmelamine, tetramethoxy-ethylmelamine, hexamethoxypropylmelamine, pentamethoxypropylmelamine, and the like. The preferred melamine cross-linking agent is hexamethoxymethyl-melamine. Preferred amino crosslinking agents are MW100LM melamine crosslinker from Sanwa Chemical Co. Ltd., Kanaxawa-ken, Japan; Cymel 303, Cymel 1171, and Powderlink 1174 from Cytec Industries, West Patterson, New Jersey. Examples of suitable phenolic crosslinking agents are disclosed in US Patent Nos. 5,488,182 and 6,777,161 and US Patent application 2005/0238997.

Specific examples of hydroxymethyl-substituted polyfunctional phenols used as crosslinker precursor are 4,4'-[1,4-phenylenebis(methylidene)]bis(3,5-dihydroxymethyl phenol), 4,4'-[1,4-phenylenebis(1-ethylidene)]bis(3,5-dihydroxymethyl phenol), 4,4'-[1,4-phenylenebis(1-propylidene)]bis(3,5-dihydroxymethyl phenol), 4,4'-[1,4-phenylenebis(1-butylidene)]bis(3,5-dihydroxymethyl phenol), 4,4'-[1,4-phenylenebis(1-pentylidene)]bis (3,5-dihydroxymethyl phenol), 4,4'-[1,4-phenylenebis(1-methyl ethylidene)]bis(3,5-dihydroxymethyl phenol), 4,4'-[1,4-phenylenebis(1-ethyl propylidene)]bis(3,5-dihydroxymethyl phenol), 4,4'-[1,4-phenylenebis(1-propyl butylidene)]bis(3,5-dihydroxymethyl phenol), 4,4'-[1,4-phenylenebis(1-butyl pentylidene)]bis(3,5-dihydroxymethyl phenol), 4,4'-[1,3-phenylenebis(methylidene)]bis(3,5-dihydroxymethyl phenol), 4,4'-[1,3-phenylenebis(1-methyl ethylidene)]his (3,5-dihydroxymethyl phenol), 4,4'-[1,3-phenylenebis(1-ethyl propylidene)]bis(3,5-dihydroxymethyl phenol), 4,4'-[1,3-phenylenebis(1-propyl butylidene)]bis(3,5-dihydroxymethyl phenol) and 4,4'-[1,3-phenylenebis(1-butyl pentylidene)]bis(3,5-dihydroxymethyl phenol) are given as specific examples of hydroxymethyl-substituted polyfunctional phenols as crosslinker precursor. Crosslinkers employed in this disclosure can be purchased commercially, or prepared by hydroxymethylation or alkoxymethylation of the corresponding phenols using standard techniques known to those skilled in the art. The preferred phenolic crosslinker is 4-[1-[4-[1,1-bis[4-hydroxy-3,5-bis(methoxymethyl)phenyl]ethyl]phenyl]-1-methylethyl]-2,6-bis(methoxymethyl) phenol available under the commercial name of CLR-19-MF from Honshu Chemical Industries Co. Ltd., Tokyo, Japan.

The semiconductor coating compositions of the present disclosure may further comprise a compound to initiate the crosslinking reaction. Initiating compounds for crosslinking reactions having alkenes or acryic compounds with compounds having multiple thiol groups would include radical generating agents such as peroxides or azo compounds such as AIBN (Azobisisobutyronitrile) or dimethyl-2,2'-azobis(2-methylpropionate). Examples of initiating compounds for crosslinking reactions having phenolic moieties and etherified melamines or glycolurils would include thermal acid generators (TAGs).

TAGs useful in this disclosure are latent acid catalyst(s), which may be classified as either ionic or nonionic TAGs. For example the sulfonic esters of organic acids belong to the class of nonionic TAGs. Examples of nonionic

sulfonate derivatives useful as TAGs include, but are not limited to, cyclohexyltosylate, 2-nitrobenzyl tosylate, 2-nitrobenzyl methylsulfonate, 2,6-dinitro benzyl p-toluenesulfonate, 4-dinitrobenzyl-p-toluenesulfonate, 1,2,3-tris(methane sulfonyloxy) benzene, 1,2,3-tris(methanesulfonyloxy)benzene, 1,2,3 -tris(ethanesulfonyloxy)benzene, 1,2,3-tris(propanesulfonyloxy)benzene, 1,2,3-tris(trifluoromethane sulfonyloxy) benzene, 1,2,3-tris(p-toluene sulfonyloxy) benzene, 4-nitrobenzyl 9,10-dimethoxyanthracene-2-sulfonate and the like.

Suitable latent acid catalyst TAGs classified as ionic TAGs include organic acid salts represented by Structure Ia:

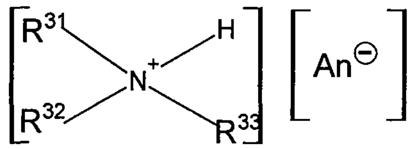

Structure Ia

wherein $R^{31}$, $R^{32}$ and $R^{33}$ are independently a hydrogen atom, substituted or unsubstituted alkyl, substituted or unsubstituted cycloalkyl, substituted or unsubstituted alicyclic, partially or completely halogen substituted alkyl, substituted or unsubstituted aryl, substituted or unsubstituted alkoxy groups, or any two of $R^{31}$, $R^{32}$ and $R^{33}$ or all of $R^{31}$, $R^{32}$ and $R^{33}$ are part of a cyclic or polycyclic group which may contain one or more oxygen, nitrogen or sulfur heteroatoms; $An^{\ominus}$ is selected from the group consisting of sulfonates of substituted or unsubstituted $C_1$-$C_{12}$ alkyl, partially or completely halogen substituted $C_1$-$C_{12}$ alkyl, $C_4$-$C_{15}$ cycloalkyl, partially or completely halogen substituted $C_4$-$C_{15}$ cycloalkyl, $C_7$-$C_{20}$ alicyclic or $C_6$-$C_{20}$ aromatic groups; disulfonates of substituted or unsubstituted $C_1$-$C_{12}$ alkylene, partially or completely halogen substituted $C_1$-$C_{12}$ alkylene, $C_4$-$C_{15}$ cycloalkylene, partially or completely halogen substituted $C_4$-$C_{15}$ cycloalkylene, $C_7$-$C_{20}$ alicyclic or $C_6$-$C_{20}$ aromatic groups; sulfonamides of Structure IIa

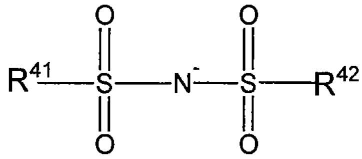

Structure IIa

wherein $R^{41}$ and $R^{42}$ are independently substituted or unsubstituted alkyl, substituted or unsubstituted cycloalkyl, substituted or unsubstituted alicyclic, partially or completely halogen substituted alkyl, or substituted or unsubstituted aryl groups; and methides of Structure IIb

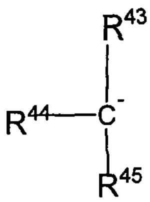

Structure IIb

wherein $R^{43}$, $R^{44}$ and $R^{45}$ are independently $C_1$-$C_{10}$ perfluroalkylsulfonyl groups.

Suitable examples of amines which can be used to generate the ammonium ion include, but are not limited to, tributylamine, triisobutylamine, dicyclohexylamine, N-ethyldicyclohexylamine, 1-methylpyrrolidine, 1-butylpyrrolidine, piperdine, 1-methylpiperidine, hexamethyleneimine, heptamethyleneimine, tropane, quinuclidine, 4-methyl-1-oxa-3-aza-cyclopentane, 4,4-dimethyl-1-oxa-3-aza-cyclopentane, 4,4-diethyl-1-oxa-3-aza-cyclopentane, 4,4-diisopropyl-1-oxa-3-aza-cyclopentane, 4,4-di*tert*-butyl-1-oxa-3-aza-cyclopentane, 4,4-dimethyl-1 -oxa-3 -aza-cyclohexane, 1 -aza-3,7-dioxa-5-ethylbicyclo[3.3.0]octane, 1-aza-3,7-dioxa-5-methylbicyclo[3.3.0]octane, 1-aza-3,7-dioxa-5-*tert*butylbicyclo[3.3.0]octane and the like. Examples of suitable TAGs of this type can be found in U.S. Patent Nos. 3,474,054, 4,200,729, 4,251,665, and 5,187,019.

Another suitable type of latent acid catalyst classified as an ionic TAG are benzylammonium salts of acids represented by Structure Ib and Ic.

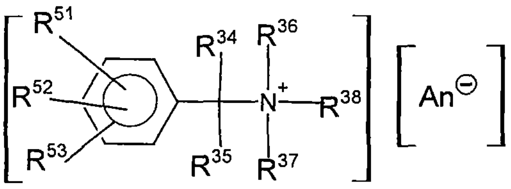

Structure Ib

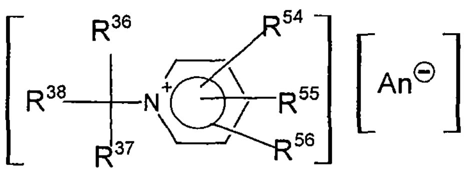

Structure Ic

wherein $R^{34}$ and $R^{35}$ are independently hydrogen, alkyl or halogen groups; $R^{36}$ and $R^{37}$ are independently $C_1$-$C_{10}$ alkyl or alkoxy groups; $R^{38}$ is a phenyl group; $R^{51}$, $R^{52}$, $R^{53}$, $R^{54}$, $R^{55}$ and $R^{56}$ are independently hydrogen, alkyl or halogen groups and $An^{\ominus}$ has the same meaning as defined above.

Suitable examples of benzylic amines which can be used to generate the ammonium ion include, but are not limited to, N-(4-methoxybenzyl)-N,N-dimethylaniline, N-(benzyl)-N,N-dimethylaniline, N-(benzyl)-N,N-dimethyltoluidine, N-(4-methylbenzyl)-N,N-dimethylaniline, N-(4-methoxybenzyl)-N,N-dimethylaniline, N-(4-chlorobenzyl)-N,N-dimethylaniline, N-(t-butylbenzyl)-dimethylpyridine and the like. The ammonium salts may also be quaternary and synthesized by other methods. Examples of this class of ionic TAG may be found in U.S. Patent Nos. 5,132,377, 5,066,722, 6,773,474 and U.S. publication 2005/0215713.

The TAGs useful for the disclosure are those compounds capable of generation of free acid at the bake temperature of the films formed from the antireflective composition. Typically these temperatures range from about 90 °C to about 250 °C. Preferably the TAG will have a very low volatility at temperatures up to about 220 °C. TAGs employed in this disclosure can be purchased commercially (e.g. from King Industries, Norwalk, CT 06852, USA), prepared by published synthetic procedures or synthetic procedures known to those skilled in the art.

The thermal acid generators described above should not be considered photoacid generators. Any sensitivity that the thermal acid generators may have to UV light should be very poor and they cannot practically be used in photolithography as photoacid generators.

The solvent employed should be inert, should dissolve all the components of the photoresist, should not undergo any chemical reaction with the components and should be removable on baking after coating. Suitable solvents for the antireflective compositions include alcohols, ketones, ethers and esters, such as 1-pentanol, propylene glycol monomethyl ether (PGME), 2-heptanone, cyclopentanone, cyclohexanone, γ-butyrolactone, ethylene glycol monomethyl ether, ethylene glycol monoethyl ether, 2-methoxyethyl acetate, propylene glycol monomethyl ether acetate (PGMEA), propylene glycol monoethyl ether acetate, methyl lactate, ethyl lactate, methyl 3-methoxypropionate, ethyl ethoxypropionate, methyl pyruvate, ethyl pyruvate, propyl pyruvate, N-methyl-2-pyrrolidone, N-ethyl-2-pyrrolidone, ethylene glycol monoisopropyl ether, diethylene glycol monoethyl ether, diethylene glycol dimethyl ether and the like. The preferred solvents for the antireflective compositions are 2-heptanone, propylene glycol monomethyl ether, propylene glycol monomethyl ether acetate, ethyl lactate and mixtures thereof.

The thermally curable semiconductor coating compositions may further comprise conventional additives such as adhesion promoters and surfactants. A person skilled in the art will be able to choose the appropriate desired additive and its concentration.

The thermally curable semiconductor coating compositions contain on a total solids basis about 65 to about 95 wt%, preferably about 70 to about 95 wt%, and more preferably about 70 to about 85 wt% of the NPB of Formula ($A^0$). The amount of the crosslinking agent in the thermally curable semiconductor coating compositions on a total solids basis is from about 3 to about 30 wt%, preferably from about 3 to about 27 wt% and more preferably from about 5 to about 25 wt%. The amount of the thermal acid generator in the thermally curable semiconductor coating compositions is on a total solids basis from about 0.1 to about 5 wt%, preferably from about 0.2 to about 4 wt% and more preferably from about 0.2 to about 3 wt%. The amount of solid in the thermally curable semiconductor coating compositions is from about 2 to about 40 wt%, preferably from about 3 to about 20 wt% and more preferably from about 4 to about 15 wt%.

It should be noted that formulation and process optimization is necessary to achieve the best possible results. For example the amount of crosslinking agent needed may vary depending on the NPB composition used and the semiconductor coating film curing temperature. In general, lower crosslinking agent concentrations may be needed with higher semiconductor coating film curing temperatures. The type and concentration of the TAG, especially in regards to TAG effectiveness, also need to be considered, if employed. The selection of the solvent system is also critical. The solvent or solvent blend needs to be compatible with the NPB used and also with the substrate to prevent coating defects.

The thermally-curable semiconductor coating composition of the present disclosure should not undergo significant crosslinking until it reaches a temperature of at least 50 °C. Significant crosslinking below 50 °C may lead to gel formation at room temperature which will reduce the shelf life of the composition. Gel formation results in nonuniform coatings and, if used in lithography, will result in poor line width control in the imaged features.

In another embodiment, the disclosure relates to a process for manufacture of a planarized layer in the manufacture of a semiconductor device. The process comprises the steps of:

a) providing two or more apertures on a semiconductor substrate;
b) at least partially filling the two or more apertures with an aperture fill composition comprising one or more cross-linkable nonpolymerics binders (NPBs) of formula ($A^0$) of this disclosure, one or more cross-linking agents and one or more solvents; and
c) heating the substrate at a temperature sufficient to at least partially cure the composition to form a planarized layer on the substrate

The substrate onto which the thermally-curable aperture fill composition is applied may be, for example, semiconductor materials such as a silicon wafer, compound semiconductor (III-V) or (II-VI) wafer, a ceramic, glass or quartz substrate. Substrates may also contain films or structures used for electronic circuit fabrication such as organic or inorganic dielectrics, copper, aluminum, or other wiring metals. The substrate may also have been coated with an inorganic, organometallic, coating such as silicon oxynitride, spin on carbon hard mask. The substrate should contain topography with at least two apertures, such as vias or trenches.

To fill the apertures on the substrate, the aperture fill composition may be applied uniformly by coating methods known to those skilled in the art. Coating methods include, but are not limited to spray coating, spin coating, offset printing, roller coating, screen printing, extrusion coating, meniscus coating, curtain coating, dip coating, and immersion coating. The preferred coating method is spin coating. The spin speeds employed will vary depending on the viscosity of the aperture fill composition and the film thickness desired. Those skilled in the art understand the relationships between aperture fill composition viscosity, spin speed, and the film thickness desired. Low viscosity formulations are preferred for better filling of the apertures.

After the coating step, the tacky, uncured aperture fill coating is baked using any suitable baking means. Baking means include, but are not limited to, a hot plate and various types of ovens known to those skilled in the art. Suitable ovens include ovens with thermal heating, vacuum ovens with thermal heating, and infrared ovens or infrared track modules. A preferred method of baking is on a hot plate.

Typical times employed for baking the uncured antireflective coating will depend on the chosen baking means and the required times and temperatures will be known are easily determined by those skilled in the art.

The baking process may take place in one or more steps at constant temperatures, different temperatures, or ramped temperatures as long as the total time and temperature are sufficient to remove sufficient solvent and induce sufficient crosslinking in the aperture fill coating to prevent interfacial problems when a photoresist or antireflective film is coated over the aperture fill coating.

When baking on a hot plate employing a two step process, typical times range from about 0.5 minutes to about 5 minutes at temperatures typically from about 80 °C to about 130 °C to remove most of the solvent, followed by a cure step for about 0.5 minutes to about 5 minutes typically at temperatures from about 170 °C to about 250 °C. Alternatively, the initial temperature may start from about 80 °C to about 130 °C and ramp up to about 170 °C to about 250 °C.

In a one step process employing a hot plate, the aperture fill film may be cured for about 0.5 minutes to about 5 minutes at temperatures typically from about 170 °C to about 250 °C.

Whether the process is a one step, two step, or ramped process, it is preferred that final portion of the baking process cure the thermally curable aperture fill composition at temperatures from about 180 °C to about 250 °C, and more preferably at temperatures from about 190 °C to about 220 °C. The preferable cure times are from about 30 to about 180 seconds, and more preferably from about 60 to about 120 seconds. However, the user may optionally elect to use a partially cured film at a lower temperature between about 120 °C and about 150 °C.

In another embodiment, the present disclosure discloses thermally-cured aperture fill coatings prepared from the aperture fill compositions of the present disclosure and prepared by the process above.

The thickness of the partially cured or cured aperture fill film may range from about 10 nm to about 5000 nm. Preferably, the thickness of the partially cured or cured aperture fill film ranges from about 20 nm to about 1000 nm. More preferably, the thickness of the partially cured or cured aperture fill film ranges from about 30 nm to about 500 nm. Most preferably, the thickness of the partially cured or cured aperture fill film ranges from about 50 nm to about 250 nm.

In another embodiment, the disclosure further relates to a process for forming a relief image on a substrate which comprises:

(a) providing a substrate, optionally coated with a first bottom antireflective coating previously applied or an aperture fill composition previously applied;
(b) coating in a first coating step said substrate with an antireflective composition of this disclosure to form an uncured bottom antireflective coating;
(c) baking in a first baking step said uncured bottom antireflective coating to provide a cured bottom antireflective coating (B.A.R.C.);

(d) coating in a second coating step a photoresist over the cured B.A.R.C. to form a photoresist film over the cured B.A.R.C.;

(e) baking the photoresist film in a second baking step to form a photoresist film / cured B.A.R.C./ optional fist bottom antireflective coating stack;

(f) exposing the photoresist film of the stack to Deep UV imaging radiation;

(g) developing a portion of the photoresist film of the stack thereby uncovering a portion of the underlying cured B.A.R.C of the stack; and

(h) rinsing the cured photoresist film / B.A.R.C. / optional first bottom antireflective coating stack with an aqueous rinse; and

(i) etching the uncovered portion of the underlying cured B.A.R.C. of the stack in an oxidizing plasma to produce a relief image.

The substrate onto which the thermally-curable antireflective composition is applied may be, for example, semiconductor materials such as a silicon wafer, compound semiconductor (III-V) or (II-VI) wafer, a ceramic, glass or quartz substrate. Substrates may also contain films or structures used for electronic circuit fabrication such as organic or inorganic dielectrics, copper, aluminum, or other wiring metals. The substrate may also have been coated with an inorganic, organometallic, or organic B.A.R.C., such as silicon oxynitride, organosiloxane B.A.R.C.s, Spin on Carbon hard mask or a B.A.R.C. of this disclosure. Optionally, the substrate may be a semiconductor substrate containing apertures onto which an aperture fill composition has been cured.

Optionally, the user may elect to etch the cured aperture fill composition slightly to thin or remove the cured aperture fill composition film from the tops of the topography. This may be done with a plasma etch process or with aqueous base in cases where the film from the aperture fill composition is alkali soluble.

In the first coating step (b), the antireflective composition may be applied uniformly to a suitable substrate by coating methods known to those skilled in the art. Coating methods include, but are not limited to spray coating, spin coating, offset printing, roller coating, screen printing, extrusion coating, meniscus coating, curtain coating, dip coating, and immersion coating. The preferred coating method is spin coating. The spin speeds employed will vary depending on the viscosity of the antireflective composition and the film thickness desired. Those skilled in the art understand the relationships between antireflective composition viscosity, spin speed, and the film thickness desired.

After the first coating step, the tacky, uncured antireflective coating is baked in a first bake step (c) using a baking means. Baking means include, but are not limited to, a hot plate and various types of ovens known to those skilled in the art. Suitable ovens include ovens with thermal heating, vacuum ovens with thermal heating, and infrared ovens or infrared track modules. A preferred method of baking is on a hot plate.

Typical times employed for baking the uncured antireflective coating will depend on the chosen baking means and the required times and temperatures will be known are easily determined by those skilled in the art.

The baking process may take place in one or more steps at constant temperatures, different temperatures, or ramped temperatures as long as the total time and temperature are sufficient to remove sufficient solvent and induce sufficient crosslinking in the antireflective coating to prevent interfacial problems when the photoresist is coated over the antireflective film.

When baking on a hot plate employing a two step process, typical times range from about 0.5 minutes to about 5 minutes at temperatures typically from about 80 °C to about 130 °C to remove most of the solvent, followed by a cure step for about 0.5 minutes to about 5 minutes typically at temperatures from about 170 °C to about 250 °C. Alternatively, the initial temperature may start from about 80 °C to about 130 °C and ramp up to about 170 °C to about 250 °C.

In a one step process employing a hot plate, the antireflective film may be cured for about 0.5 minutes to about 5 minutes at temperatures typically from about 170 °C to about 250 °C.

Whether the process is a one step, two step, or ramped process, it is preferred that final portion of the baking process cure the thermally curable antireflective composition at temperatures from about 180 °C to about 250 °C and more preferably at temperatures from about 190 °C to about 220 °C. The preferable cure times are from about 30 to about 180 seconds and more preferably from about 60 to about 120 seconds. However, the user may optionally elect to use a partially cured film at a lower temperature between about 120 °C and about 150 °C.

The B.A.R.C. coated substrate is then typically allowed to cool to room temperature to ensure consistent coating thicknesses in the second coating step. The typical film thickness of the antireflective coating thus formed may range from about 50 nm to about 200 nm.

In a second coating step (d), the B.A.R.C. coated substrate is then coated with a photoresist and, in a second baking step (e), baked using a baking means. The coating methods and baking means described above for the antireflective film may be employed. Typical times employed for baking the coated photoresist will depend on the chosen baking means, and the particular photoresist. The required times and temperatures are easily determined by those skilled in the art for the specific combination of methods and materials employed. A preferred method of baking is on a hot plate. When baking on a hot plate, typical times range from about 0.5 minutes to about 5 minutes at temperatures

typically from about 80 °C to about 140 °C. Optimum bake parameters may vary depending on the photoresist and casting solvent employed. Typical photoresist film thicknesses may range from about 30 nm to about 500 nm.

The photoresist coated over the B.A.R.C. may be any radiation-sensitive resist suitable for exposure to radiation between about 100 nm about 300 nm. The photoresist may be a positive or negative tone photoresist. Examples of suitable negative tone Deep UV photoresists can be found in U.S. patent Nos. 5,650,262, 5,296,332, 5,547,812, 6,074,801, 6,146,806, 6,800,416, 6,933,094, and 7,081,326.

The positive tone photoresist is typically a chemically amplified photoresist such as those discussed in U.S. Patent Nos. 5,492,793 and 5,747,622, which are incorporated herein by reference. Suitable chemically amplified photoresists contain an alkali solubilizing group blocked by an acid sensitive group, which can either be found on a dissolution inhibitor or the base polymer. Examples of suitable alkali solubilizing groups include, but are not limited to, carboxylic acids, phenols, hydroxyimides, hydroxymethylimides, fluorinated alcohols and silanols. Examples of suitable blocking groups include, but are not limited to, alkyl groups containing tertiary carbons, and alpha alkoxy alkyls, and arylisopropyl groups. Examples of suitable blocked alkali solubilizing groups include, but are not limited to, *t*-butyl esters, alpha alkoxy esters, alpha alkoxyalkyl aromatic ethers, *t*-butoxyphenyl, *t*-butoxyimido, and *t*-butoxymethylimido. Examples of blocked alkali solubilizing groups can be found in US Patent Nos. 5,468,589, 4,491,628, 5,679,495, 6,379,861, 6,329,125, and 5,206,317.

The positive tone photoresist will also contain a photoacid generating (PAG) compound. Any suitable photoacid generator compounds may be used in the photoresist. The photoacid generator compounds are well known and include, for example, onium salts such as diazonium, sulfonium, sulfoxonium and iodonium salts, nitrobenzylsulfonate esters, oximesulfonates, imidosulfonates and disulfones. Suitable photoacid generator compounds are disclosed, for example, in US Patent Nos. 5,558,978, 5,468,589, 5,554,664 and 6,261,738. US Patent No. 6,261,738 discloses examples of suitable oximesulfonate PAGs. Other suitable photoacid generators are perfluoroalkyl sulfonyl methides and perfluoroalkyl sulfonyl imides as disclosed in US Patent No. 5,554,664.

Suitable examples of photoacid generators are phenacyl p-methylbenzenesulfonate, benzoin p-toluenesulfonate, $\alpha$-(p-toluene-sulfonyloxy)methylbenzoin, 3 -(p-toluenesulfonyloxy)-2-hydroxy-2-phenyl-1-phenylpropyl ether, N-(p-dodecylbenzenesulfonyloxy)-1,8-naphthalimide and N-(phenyl-sulfonyloxy)-1,8-napthalimide.

Examples of suitable onium salts include, but are not limited to, triphenyl sulfonium methanesulfonate, triphenyl sulfonium trifluoromethanesulfonate, triphenyl sulfonium hexafluoropropanesulfonate, triphenyl sulfonium nonafluorobutanesulfonate, triphenyl sulfonium perfluorooctanesulfonate, triphenyl sulfonium phenyl sulfonate, triphenyl sulfonium 4-methyl phenyl sulfonate, triphenyl sulfonium 4-methoxyphenyl sulfonate, triphenyl sulfonium 4-chlorophenyl sulfonate, triphenyl sulfonium camphorsulfonate, 4-methylphenyl-diphenyl sulfonium trifluoromethanesulfonate, bis(4-methylphenyl)-phenyl sulfonium trifluoromethanesulfonate, tris-4-methylphenyl sulfonium trifluoromethanesulfonate, 4-*tert*-butylphenyl-diphenyl sulfonium trifluoromethanesulfonate, 4-methoxyphenyl-diphenyl sulfonium trifluoromethanesulfonate, mesityl-diphenyl sulfonium trifluoromethanesulfonate, 4-chlorophenyl-diphenyl sulfonium trifluoromethanesulfonate, bis(4-chlorophenyl)-phenyl sulfonium trifluoromethanesulfonate, tris(4-chlorophenyl) sulfonium trifluoromethanesulfonate, 4-methylphenyl-diphenyl sulfonium hexafluoropropanesulfonate, bis(4-methylphenyl)-phenyl sulfonium hexafluoropropanesulfonate, tris-4-methylphenyl sulfonium hexafluoropropanesulfonate, 4-tert-butylphenyl-diphenyl sulfonium hexafluoropropane sulfonate, 4-methoxyphenyl-diphenyl sulfonium hexafluoropropane sulfonate, mesityl-diphenyl sulfonium hexafluoropropane sulfonate, 4-chlorophenyl-diphenyl sulfonium hexafluoropropane sulfonate, bis(4-chlorophenyl)-phenyl sulfonium hexafluoropropane sulfonate, tris(4-chlorophenyl) sulfonium hexafluoropropane sulfonate, 4-methylphenyl-diphenyl sulfonium perfluorooctanesulfonate, bis(4-methylphenyl)-phenyl sulfonium perfluorooctanesulfonate, tris-4-methylphenyl sulfonium perfluoroocatanesulfonate, 4-tert-butylphenyl-diphenyl sulfonium perfluorooctane sulfonate, 4-methoxyphenyl-diphenyl sulfonium perfluorooctane sulfonate, mesityl-diphenyl sulfonium perfluorooctane sulfonate, 4-chlorophenyl-diphenyl sulfonium perfluorooctane sulfonate, bis(4-chlorophenyl)-phenyl sulfonium perfluorooctane sulfonate, tris(4-chlorophenyl) sulfonium perfluorooctane sulfonate, diphenyl iodonium hexafluoropropane sulfonate, diphenyl iodonium 4-methylphenyl sulfonate, bis(4-tert-butylphenyl)iodonium trifluoromethane sulfonate, bis(4-tert-butylphenyl)iodonium hexafluoromethane sulfonate, and bis(4-cyclohexylphenyl)iodonium trifluoromethane sulfonate.

Further examples of suitable photoacid generators for use in the positive tone photoresist are bis(p-toluenesulfonyl)diazomethane, methylsulfonyl p-toluenesulfonyldiazomethane, 1-cyclo-hexylsulfonyl-1-(1,1-dimethylethylsulfonyl)diazomethane, bis(1,1-dimethylethylsulfonyl)diazomethane, bis(1-methylethylsulfonyl)diazomethane, bis(cyclohexylsulfonyl)diazomethane, 1-p-toluenesulfonyl-1-1-cyclohexylcarbonyldiazomethane, 2-methyl-2-(p-toluenesulfonyl)propiophenone, 2-methanesulfonyl-2-methyl-(4-methylthiopropiophenone, 2,4-methyl-2-(p-toluenesulfonyl)pent-3 -one, 1-diazo-1-methylsulfonyl-4-phenyl-2-butanone, 2-(cyclohexylcarbonyl-2-(p-toluenesulfonyl)propane, 1-cyclohexylsulfonyl-1 cyclohexylcarbonyldiazomethane, 1 -diazo-1-cyclohexylsulfonyl-3,3-dimethyl-2-butanone, 1 -diazo-1-(1,1-dimethylethylsulfonyl)-3,3-dimethyl-2-butanone, 1-acetyl-1-(1-methylethylsulfonyl)diazomethane, 1-diazo-1-(p-toluenesulfonyl)-3,3-dimethyl-2-butanone, 1-diazo-1-benzenesulfonyl-3,3-dimethyl-2-butanone, 1-diazo-1-(p-toluenesulfonyl)-3-methyl-2-butanone, cyclohexyl 2-diazo-2-(p-toluenesulfonyl)acetate, tert-butyl 2-diazo-2-benzenesulfonylacetate, isopropyl-2-diazo-2-methanesulfonylacetate, cyclohexyl 2-diazo-2-benzenesulfonylacetate, tert-butyl 2 diazo-2-(p-toluenesulfonyl)acetate, 2-nitrobenzyl p-toluenesulfonate, 2,6-dinitrobenzyl p-toluenesulfonate, 2,4-dinitrobenzyl p-trifluoromethylbenzenesulfonate.

The photoacid generator compound is typically employed in the positive tone photoresist in amounts of about 0.0001 to 20 % by weight of polymer solids and more preferably about 1% to 10 % by weight of polymer solids.

Suitable solvents for the positive tone photoresist include ketones, ethers and esters, such as methyl ethyl ketone, methyl isobutyl ketone, 2-heptanone, cyclopentanone, cyclohexanone, 2-methoxy-1-propylene acetate, 2-methoxyethanol, 2-ethoxyethanol, 2-ethoxyethyl acetate, 1-methoxy-2-propyl acetate, 1,2-dimethoxy ethane ethyl acetate, cellosolve acetate, propylene glycol monoethyl ether acetate, propylene glycol methyl ether acetate, methyl lactate, ethyl lactate, methyl pyruvate, ethyl pyruvate, ethyl 3-methoxypropionate, N-methyl-2-pyrrolidone, 1,4-dioxane, ethylene glycol monoisopropyl ether, diethylene glycol monoethyl ether, diethylene glycol monomethyl ether, diethylene glycol dimethyl ether, and the like. The solvent employed should be inert, should dissolve all the components of the photoresist, should not undergo any chemical reaction with the components and should be removable on baking after coating. It is especially important that the thermally-cured B.A.R.C. have no appreciable solubility in the photoresist solvent.

Additionally, base additives may be added to the positive tone photoresist. The purpose of the base additive is to scavenge protons present in the photoresist prior to being irradiated by actinic radiation. The base prevents attack and cleavage of the acid labile groups by the undesirable acids, thereby increasing the performance and stability of the resist. In addition, the base can act as a diffusion control agent to prevent the acid from migrating too far and lower resolution. The percentage of base in the composition should be significantly lower than the photoacid generator or otherwise the photosensitivity becomes too low. The preferred range of the base compounds, when present, is about 3% to 50% by weight of the photoacid generator compound. Nitrogenous bases are preferred. Suitable examples of base additives are cyclopropylamine, cyclobutylamine, cyclopentylamine, dicyclopentylamine, dicyclopentylmethylamine, dicyclopentylethylamine, cyclohexylamine, dimethylcyclohexylamine, dicyclohexylamine, dicyclohexylmethylamine, dicyclohexylethylamine, dicyclohexylbutylamine, cyclohexyl-t-butylamine, cycloheptylamine, cyclooctylamine, 1-adamantanamine, 1-dimethylaminoadamantane, 1-diethylaminoadamantane, 2-adamantanamine, 2-dimethylaminoadamantane, 2-aminonorbornene, 3-noradamantanamine, 2-methylimidazole, tetramethyl ammonium hydroxide, tetrabutylammonium hydroxide, triisopropylamine, 4-dimethylaminopryidine, 4,4'-diaminodiphenyl ether, 2,4,5-triphenylimidazole, and 1,5-diazabicyclo[4.3.0]non-5-ene, 1,8-diazabicyclo[5.4.0]undec-7-ene, guanidine, 1,1-dimethylguanidine, 1,1,3,3-tetramethylguanidine, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine, N-(2-aminoethyl)morpholine, trimethylimidazole, triphenylimidazole, and methyldiphenylimidazole. However, the basic compounds should not be construed as being limited to these examples.

The positive tone photoresist may further comprise conventional additives such as adhesion promoters and surfactants. A person skilled in the art will be able to choose the appropriate desired additive and its concentration.

For the production of relief structures, the photoresist film is imagewise exposed to Deep UV radiation (f). The term 'imagewise' exposure includes both exposure through a photomask containing a predetermined pattern and exposure by means of any other suitable source of Deep UV radiation, such as for example, a computer controlled laser beam which is moved over the surface of the coated substrate. The imagewise exposure generates acid in the exposed regions of the photoresist film which catalyzes the cleavage of the acid labile groups resulting in a polymer which is aqueous alkaline soluble.

The exposure of the photoresist film may be done by conventional exposure means using a conventional exposure tool known to those skilled in the art, or by "immersion lithography". Immersion lithography refers to the use of an imaging apparatus in which the space between the final projection lens and the substrate containing the photoresist film is filled with an immersion fluid having a refractive index n greater than that of air. This type of apparatus is described in US Patent Application Publication No. 2005/0163629. Exposure using the immersion lithography technique is sometimes referred to as a "wet" exposure method while conventional exposures not using immersion lithography are referred to as "dry" exposure methods.

The immersion fluid may be any fluid that has a refractive index $n > 1$, that is sufficiently transparent at the wavelength of the exposing light and does not dissolve or chemically react with the photoresist film. The preferred immersion fluid for use with ArF excimer laser exposure systems comprises water. The water used should be substantially free of substances opaque to the radiation wavelength and be free of impurities affecting the refractive index of water. Additives for the purpose of decreasing the surface tension of water, such as aliphatic alcohols having a refractive index of near or equal to that of water may be used. Examples of suitable alcohols include, but are not limited to, methyl

alcohol, ethyl alcohol and isopropyl alcohol. Additives for the purpose of further increasing the refractive index of the fluid, such as metal methylsulfonate salts or alkyl ammonium methylsulfonates as described in Proc. of SPIE Vol. 6153 61530B, may also be added.

Optionally, prior to exposing the photoresist coated substrate using immersion lithography, a protective coating (topcoat) may be applied directly on top of the photoresist film to prevent contact between the photoresist film and the immersion fluid. This topcoat, if used, should be substantially insoluble in the immersion fluid, be sufficiently transparent to the imaging wavelength radiation, does not intermix with the photoresist film and can be uniformly coated. Examples of suitable topcoats are described in U.S. Patent Application Publication Nos. 2005/0277059, 2006/0189779, 2006/0008748 and 2006/0036005.

The process described above for the production of relief structures preferably includes, as a further process measure, heating of the photoresist film / B.A.R.C. stack (or photoresist film / B.A.R.C./ cured aperture fill composition film stack) between exposure and treatment with the developer. With the aid of this heat treatment, known as a "post-exposure bake", virtually complete reaction of the acid labile groups in the polymer with the acid generated by the exposure is achieved. The duration and temperature of this post-exposure bake can vary within broad limits and depends essentially on the functionalities of the polymer, the type of acid generator and on the concentration of these two components. The exposed photoresist film is typically subjected to temperatures of about 50 °C to about 150 °C for a few seconds to a few minutes, depending on the particular baking means employed. The preferred post-exposure bake is from about 80 °C to about 130 °C for about 5 seconds to about 180 seconds. Any suitable baking means, such as described above after coating, may be employed. The preferred baking means is a hot plate.

After imagewise exposure and any heat treatment of the photoresist film B.A.R.C. stack (or photoresist film / B.A.R.C./ cured aperture fill composition film stack), the exposed or unexposed areas of the photoresist film (which area depends on whether the photoresist is a positive or negative tone photoresist) are removed by dissolution in an aqueous base developer to generate a relief structure (g). Examples of suitable bases include, but are not limited to, inorganic alkalis (e.g., potassium hydroxide, sodium hydroxide, ammonia water), primary amines (e.g., ethylamine, *n*-propylamine), secondary amines (e.g. diethylamine, di-*n*-propylamine), tertiary amines (e.g., triethylamine), alcoholamines (e.g. triethanolamine), quaternary ammonium salts (e.g., tetramethylammonium hydroxide, tetraethylammonium hydroxide), and mixtures thereof. The concentration of base employed will vary depending on the base solubility of the polymer employed and the specific base employed. The most preferred developers are those containing tetramethylammonium hydroxide (TMAH). Suitable concentrations of TMAH range from about 1 wt% to about 5 wt%.

The developer may contain a surfactant in a concentration from about 10 ppm to about 10,000 ppm. A preferred concentration, if a surfactant is employed, is from about 20 ppm to about 5000 ppm. A more preferred concentration, if a surfactant is employed, is from about 20 ppm to about 1000 ppm. Any surfactant type may be employable. Preferred surfactant types include nonionic, anionic, and amphoteric surfactants including their fluorinated versions. Nonionic surfactants, including fluorinated nonionic surfactants, are more preferred.

The developer may contain other additives, such as salts and antifoam agents.

Development of the photoresist relief structures in the photoresist / B.A.R.C. stack (or photoresist film / B.A.R.C./ cured aperture fill composition film stack) can be carried out by means of immersion, spray, puddling, or other similar developing methods known to those skilled in the art at temperatures from about 10 °C to 40 °C for about 30 seconds to about 5 minutes with or without agitation.

After development, the imaged photoresist / B.A.R.C. stack (or photoresist film / B.A.R.C./ cured aperture fill composition film stack) is rinsed with a rinse comprising de-ionized water or comprising de-ionized water containing one or more surfactants, and dried by spinning, baking on a hot plate, in an oven, or other suitable means known to those skilled in the art. A preferred concentration of surfactant, if employed, is from about 10 ppm to about 10000 ppm. A more preferred concentration of surfactant is from about 20 ppm to about 5000 ppm. A most preferred concentration of surfactant is from about 20 ppm to about 1000 ppm. Any surfactant type may be employable. Preferred surfactant types include nonionic, anionic, and amphoteric surfactants including their fluorinated versions. Nonionic surfactants, including fluorinated nonionic surfactants, are more preferred.

In another embodiment, the present disclosure discloses thermally-cured bottom antireflective coatings prepared from the antireflective compositions of the present disclosure. These cured coatings may be formed e.g. by steps a-c in the lithographic process described above. The B.A.R.C. thickness may be any thickness suitable for the lithographic application. A preferred B.A.R.C. film thickness range is from about 60 nm to about 150 nm for the case where only one B.A.R.C. layer is employed. The more preferred B.A.R.C. film thickness is from about 70 nm to about 100 nm when only one B.A.R.C. layer is employed.

The thermally-cured antireflective coatings of the present embodiment possess an index of refraction, n, at the exposing wavelength of preferably more than or equal to 1.5 and less than or equal to 2.2. The extinction coefficient, k, of the antireflective coating at the exposing wavelength is greater than or equal to 0.05 and less than or equal to 0.50. A preferred value of k is from 0.10 to 0.45 to provide a satisfactory antireflection effect at a film thickness of 200 nm or less.

In another embodiment, the present disclosure further discloses a photoresist film / B.A.R.C. stack comprising

a substrate, a thermally-cured coating of a bottom antireflective composition of this disclosure (B.A.R.C.) coated on the substrate, and a photoresist film over the thermally-cured film of the antireflective composition of this disclosure. The photoresist film / B.A.R.C. stack of this disclosure may be prepared, e.g., by steps a-e in the lithographic process described above.

The antireflective coating in the photoresist film / B.A.R.C. stack is present at a thickness necessary to provide reflection control in order to maximize the quality and resolution of the photoresist film during lithographic patterning, yet minimize the amount of phototoresist layer lost during the B.A.R.C. etch process. The B.A.R.C. film thickness is from about 50 nm to about 200 nm. A preferred B.A.R.C. film thickness range is from about 60 nm to about 150 nm. The more preferred B.A.R.C. film thickness is from about 70 nm to about 100 nm.

In the situation where the antireflective coating is applied to a substrate already having a previously coated B.A.R.C. (lower B.A.R.C.), suitable thicknesses, refractive indices and extinction coefficients, k, will be somewhat different than in the previous two embodiments.

The thickness of the B.A.R.C. applied in the process (upper B.A.R.C.) will be thinner, in order to maintain a similar total B.A.R.C. thickness to prevent excess etching of the photoresist layer in the etch step(s) to remove B.A.R.C.(s) in the imaged areas. With a two layer B.A.R.C. system, the film thickness employed for the upper B.A.R.C. is from about 20 nm to about 100 nm. A preferred B.A.R.C. thickness for the upper B.A.R.C. is from about 20 nm to about 80 nm. A more preferred film thickness for the upper B.A.R.C. is from about 20 nm to about 60 nm.

The index of refraction, n, at the exposing wavelength of the upper B.A.R.C. is preferably greater than or equal to 1.6 and less than or equal to 2.2. More preferably, the index of refraction, n, at the exposing wavelength of the upper B.A.R.C. is greater than or equal to 1.7 and less than or equal to 2.2. The extinction coefficient, k, of the upper B.A.R.C. at the exposing wavelength is preferably greater than or equal to 0.10 and less than or equal to 0.4. More preferably, the extinction coefficient, k, of the upper B.A.R.C. at the exposing wavelength is preferably greater than or equal to 0.15 and less than or equal to 0.35.

The thickness of the B.A.R.C. applied prior to the process (lower B.A.R.C.) will also be thinner than in the single B.A.R.C. situation, in order to maintain a similar total B.A.R.C. thickness to prevent excess etching of the photoresist layer in the etch step(s) to remove B.A.R.C.(s) in the imaged areas. With a two layer B.A.R.C. system, the film thickness employed for the lower B.A.R.C. is from about 10 nm to about 80 nm. A preferred B.A.R.C. thickness for the lower B.A.R.C. is from about 20 nm to about 60 nm. A more preferred film thickness for the lower B.A.R.C. is from about 20 nm to about 50 nm.

The index of refraction, n, at the exposing wavelength of the lower B.A.R.C. is preferably greater than or equal to 1.6 and less than or equal to 2.2. More preferably, the index of refraction, n, at the exposing wavelength of the lower B.A.R.C. is greater than or equal to 1.7 and less than or equal to 2.2. The extinction coefficient, k, of the lower B.A.R.C. at the exposing wavelength is preferably greater than or equal to 0.4 and less than or equal to 1. More preferably, the extinction coefficient, k, of the lower B.A.R.C. at the exposing wavelength is preferably greater than or equal to 0.5 and less than or equal to 1.0.

The photoresist film thickness in the photoresist film / B.A.R.C. stack is optimized for lithographic performance and the need to provide plasma etch resistance for both the image transfer into the B.A.R.C. and subsequently into the substrate. Preferably the photoresist film has a thickness from about 50 nm to about 500 nm. A more preferred photoresist film thickness range is from about 80 nm to about 250 nm. The most preferred photoresist film thickness is from 100 nm to 170 nm.

In another embodiment, the present disclosure discloses a photoresist film / B.A.R.C. / aperture fill film stack comprising a semiconductor substrate with at least two apertures, a thermally-cured film of an aperture fill film composition of this disclosure coated on the semiconductor substrate, a thermally-cured film coating of a bottom antireflective composition coated on the aperture fill film, and a photoresist film over the thermally-cured film of the antireflective composition of this disclosure. The photoresist film / B.A.R.C. / aperture fill film stack of this disclosure may be prepared, e.g., by the process for manufacture of a planarized layer described above followed by steps a-e in the lithographic process described above.

In another embodiment, the compositions of the present disclosure comprise nonpolymeric binders (NPBs) which are useful in aperture fill compositions and antireflective compositions.

The NPBs are represented by formula ($B^0$),

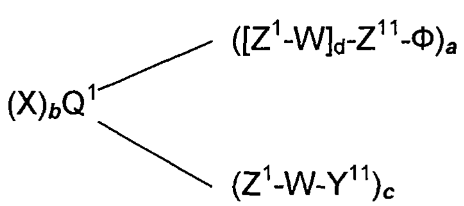

($B^0$)

where $Q^1$ is a multivalent organic nucleus, $Z^1$ and $Z^{11}$ are divalent linking groups, W is a divalent organic bridging group, Φ is an organic DUV chromophore-containing substituent T or an organic substituent ə having little or no absorbance to DUV light, X is a reactive functional group, $Y^{11}$ is a reactive functional group, *a* ranges from about 2 to about 15, *b* ranges from zero to about 10, c ranges from zero to about 5, and *d* = 1, wherein $Q^1$, W, and Φ together contain at least two groups or sites which are reactive in a crosslinking reaction with the proviso that the sum of (*a*+*b*+*c*) is greater than or equal to 3 and $Q^1$ is selected from the group consisting of:

(a) an unsubstituted $C_2$-$C_{40}$ linear, branched, cyclic, or polycyclic aliphatic group not containing as an integral part of a ring or chain structure oxygen, sulfur, or nitrogen atoms;
(b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
(c) an unsubstituted $C_2$-$C_{40}$ aliphatic group containing both cyclic and acyclic components not containing as an integral part of a ring or chain structure oxygen, sulfur, or nitrogen atoms; and
(d) an unsubstituted $C_2$-$C_{40}$ aliphatic group containing both cyclic and acyclic components and as an integral part of a ring or chain structure at least one or more oxygen, sulfur, or nitrogen atoms including mixtures thereof.

$Z^1$, $Z^{11}$, W, $Y^{11}$, X and the various preferred $Q^1$ are as described earlier for (A). Φ is as describe earlier for ($A^0$)
The NPBs are represented by formula (B),

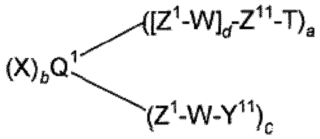

(B)

where $Q^1$ is a multivalent organic nucleus, $Z^1$ and $Z^{11}$ are divalent linking groups, W is a divalent organic bridging group, T is an organic DUV chromophore-containing substituent, X is a reactive functional group, $Y^{11}$ is a reactive functional group, *a* ranges from about 2 to about 15, *b* ranges from zero to about 10, c ranges from zero to about 5, and *d* = 1, wherein $Q^1$, W, and T together contain at least two groups or sites which are reactive in a crosslinking reaction with the proviso that the sum of (*a*+*b*+*c*) is greater than or equal to 3 and $Q^1$ is

(a) an unsubstituted $C_2$-$C_{40}$ linear, branched, cyclic, or polycyclic aliphatic group not containing as an integral part of a ring or chain structure oxygen, sulfur, or nitrogen atoms; $Q^1$ in NPBs not presently claimed may be selected from:
(b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
(c) an unsubstituted $C_2$-$C_{40}$ aliphatic group containing both cyclic and acyclic components not containing as an integral part of a ring or chain structure oxygen, sulfur, or nitrogen atoms, and
(d) an unsubstituted $C_2$-$C_{40}$ aliphatic group containing both cyclic and acyclic components and as an integral part of a ring or chain structure one or more oxygen, sulfur, or nitrogen atoms including mixtures thereof.

$Z^1$, $Z^{11}$, W, T, $Y^{11}$, X and the various preferred $Q^1$ are as described earlier for (A).
Examples of (B) include, but are not limited to the following compounds:

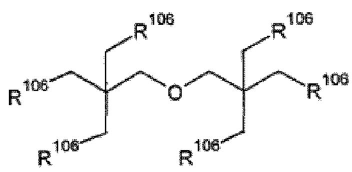

$R^{106}$ = 66%

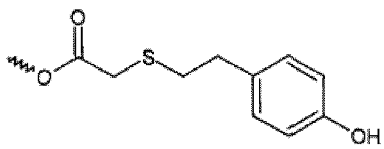

17% OH

(A-38)

17%

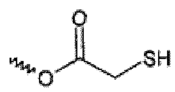

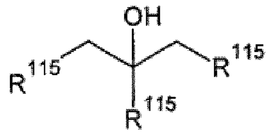

$R^{115}$ =

(A-39)

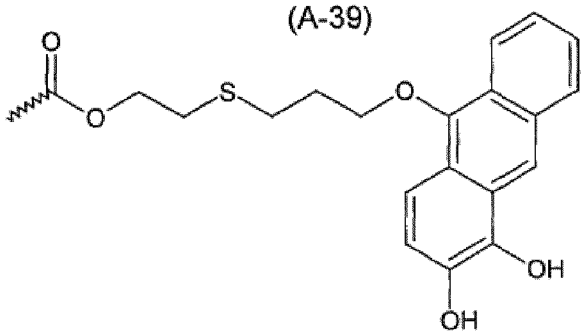

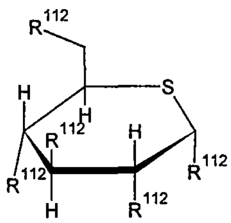

$R^{112}$ = 60%

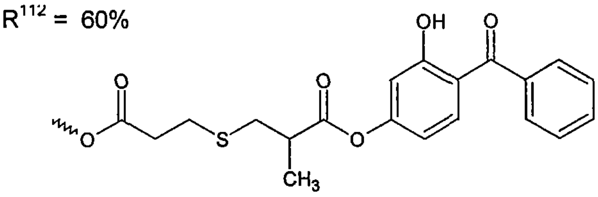

40%

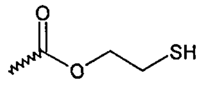

(A-40)

(A-41)

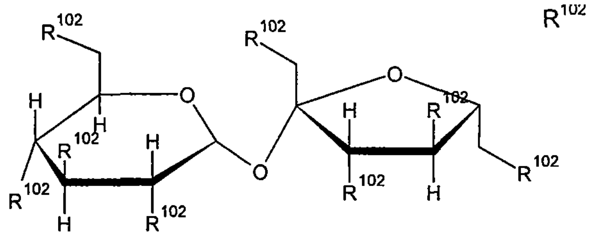

$R^{102}$ = 38%

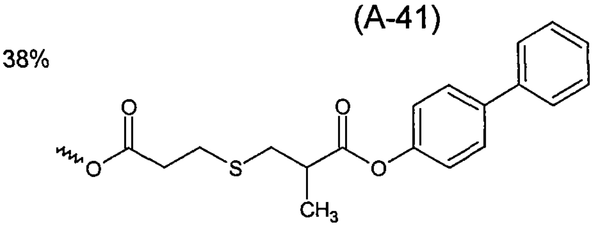

25%

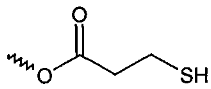

37% OH

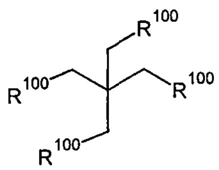

$R^{100}$ = 50%

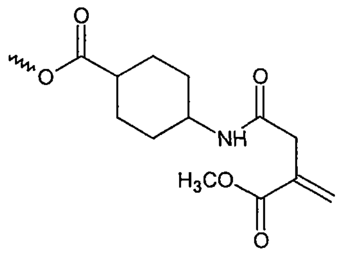

50%

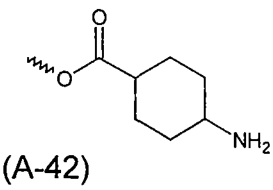

(A-42)

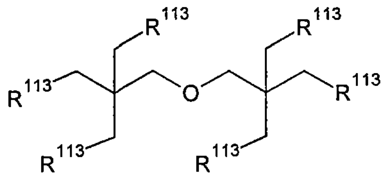

$R^{113}$ = 50%

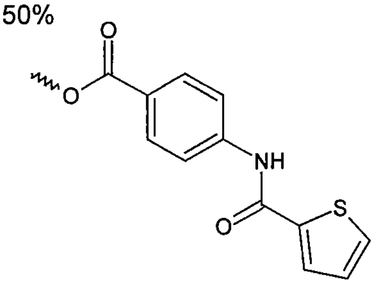

50%

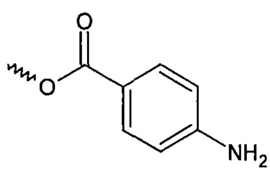

(A-43)

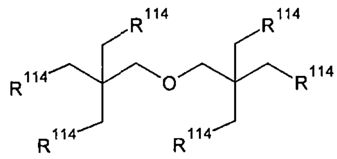

$R^{114}$ = 50%

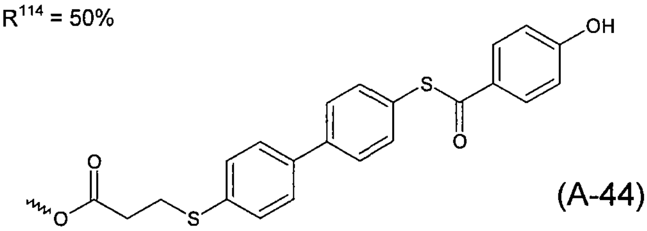

50%

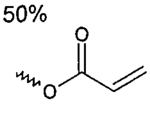

(A-44)

and

(A-46)

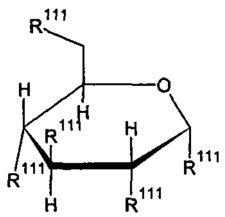

$R^{111}$ = 60%

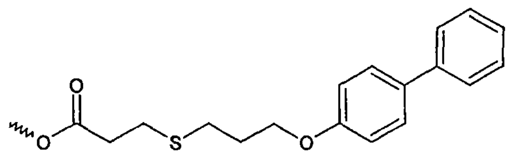

20%

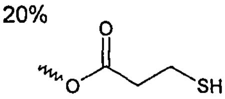

(A-45)

20% OH

In one embodiment of the disclosure the NPCBs are represented by formula (O):

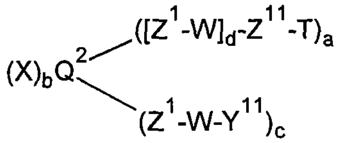

(O)

where X, $Z^1$, $Z^{11}$ $Y^{11}$, W, T, *b,* and *c*, are as described above, *d* = 1 and $Q^2$ is a multivalent organic nucleus consisting of an unsubstituted $C_2$-$C_{40}$ linear, branched, cyclic, or polycyclic aliphatic group not containing as an integral part of a ring or chain structure oxygen, sulfur, or nitrogen atoms, and *a* ranges from about 2 to about 15.

Preferably, $Q^2$ is a multivalent organic nucleus consisting of an unsubstituted $C_3$-$C_{24}$ linear, branched, or cyclic aliphatic group not containing as an integral part of a ring or chain structure oxygen, sulfur, or nitrogen atoms, and *a* ranges from about 3 to about 12.

More preferably, $Q^2$ is a multivalent organic nucleus consisting of an unsubstituted $C_4$-$C_{16}$ linear, or branched, aliphatic group not containing as an integral part of a ring or chain structure oxygen, sulfur, or nitrogen atoms, and *a* ranges from about 3 to about 10.

Most preferably, $Q^2$ is a multivalent organic nucleus consisting of an unsubstituted $C_6$-$C_{12}$ linear, or branched, aliphatic group not containing as an integral part of a ring or chain structure oxygen, sulfur, or nitrogen atoms, and *a* ranges from about 4 to about 8.

In one embodiment of the disclosure the NPCBs are represented by formula (P):

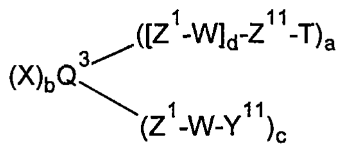

(P)

where X, $Z^1$, $Z^{11}$, $Y^{11}$, W, T, *b,* and *c* are as described above, *d* = 1 and $Q^3$ is a multivalent organic nucleus consisting of an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof, and *a* ranges from about 2 to about 15.

Preferably, $Q^3$ is a multivalent organic nucleus consisting of an unsubstituted $C_2$-$C_{24}$ linear, branched, or cyclic aliphatic group containing as an integral part of a ring or chain structure one or more oxygen, sulfur, or nitrogen atoms including mixtures thereof, and *a* ranges from about 3 to about 12.

More preferably, $Q^3$ is a multivalent organic nucleus consisting of an unsubstituted $C_3$-$C_{16}$ linear, or branched,

aliphatic group containing as an integral part of a ring or chain structure one or more oxygen, sulfur, or nitrogen atoms including mixtures thereof, and *a* ranges from about 3 to about 10.

Most preferably, $Q^3$ is a multivalent organic nucleus consisting of an unsubstituted $C_4$-$C_{12}$ linear, or branched, aliphatic group containing as an integral part of a ring or chain structure one or more oxygen, sulfur, or nitrogen atoms including mixtures thereof, and *a* ranges from about 4 to about 8.

In one embodiment of the disclosure the novel NPCBs are represented by formula (R):

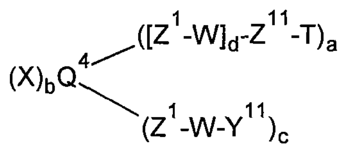

(R)

where X, $Z^1$, $Z^{11}$, $Y^{11}$, W, T, *b*, and *c* are as described above, *d* = 1 and $Q^4$ is an unsubstituted $C_6$-$C_{40}$ multivalent organic nucleus consisting of both cyclic and acyclic components not containing as an integral part of a ring or chain structure oxygen, sulfur, or nitrogen atoms, and *a* ranges from about 2 to about 15.

Preferably $Q^4$ is an unsubstituted $C_6$-$C_{28}$ multivalent organic nucleus consisting of both cyclic and acyclic components not containing as an integral part of a ring or chain structure oxygen, sulfur, or nitrogen atoms, and *a* ranges from about 3 to about 12.

More preferably $Q^4$ is an unsubstituted $C_7$-$C_{22}$ multivalent organic nucleus consisting of both cyclic and acyclic components not containing as an integral part of a ring or chain structure oxygen, sulfur, or nitrogen atoms, and *a* ranges from about 3 to about 10.

Most preferably $Q^4$ is an unsubstituted $C_8$-$C_{18}$ multivalent organic nucleus consisting of both cyclic and acyclic components not containing as an integral part of a ring or chain structure oxygen, sulfur, or nitrogen atoms, and *a* ranges from about 4 to about 8.

In one embodiment of the disclosure the NPCBs are represented by formula (S):

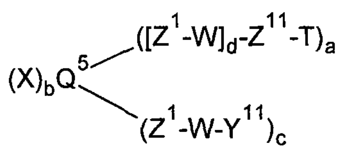

(S)

where X, $Z^1$, $Z^{11}$, $Y^{11}$, W, T, *b*, and *c* are as described above, *d* = 1 and $Q^5$ is an unsubstituted $C_5$-$C_{40}$ multivalent organic nucleus consisting of both cyclic and acyclic components containing as an integral part of a ring or chain structure one or more oxygen, sulfur, or nitrogen atoms including mixtures thereof, and *a* ranges from about 2 to about 15.

Preferably $Q^5$ is an unsubstituted $C_5$-$C_{24}$ multivalent organic nucleus consisting of both cyclic and acyclic components containing as an integral part of a ring or chain structure one or more oxygen, sulfur, or nitrogen atoms including mixtures thereof, and *a* ranges from about 3 to about 12.

More preferably $Q^5$ is an unsubstituted $C_6$-$C_{20}$ multivalent organic nucleus consisting of both cyclic and acyclic components containing as an integral part of a ring or chain structure one or more oxygen, sulfur, or nitrogen atoms including mixtures thereof, and *a* ranges from about 3 to about 10.

Most preferably $Q^5$ is an unsubstituted $C_6$-$C_{16}$ multivalent organic nucleus consisting of both cyclic and acyclic components containing as an integral part of a ring or chain structure one or more oxygen, sulfur, or nitrogen atoms including mixtures thereof, and *a* ranges from about 4 to about 8.

In another embodiment of the disclosure the NPCBs are represented by formula (V):

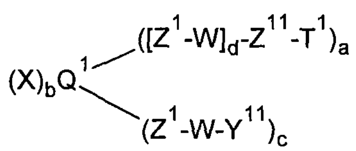

(V)

where $Q^1$, X, $Z^1$, $Z^{11}$, $Y^{11}$, W, *b,* and c are as described above, *d* = 1 and $T^1$ is independently a substituted or unsubstituted phenyl group. *a* is ranges from about 2 to about 15, preferably *a* ranges from about 3 to about 12, more preferably from about 3 to about 10 and the most preferred *a* ranges from about 4 to about 8.

In another embodiment of the disclosure the NPCBs are represented by formula (AA)

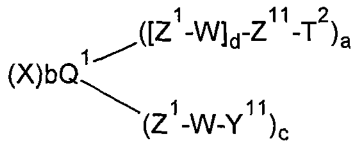

(AA)

where $Q^1$, X, $Z^1$, $Z^{11}$, $Y^{11}$, W, *b,* and *c* are as described above, *d* = 1 and $T^2$ is independently a substituted or unsubstituted $C_3$-$C_5$ mononuclear heteroaryl containing one or more oxygen, sulfur, or nitrogen atoms including mixtures thereof. *a* ranges from about 2 to about 15, preferably *a* ranges from about 3 to about 12, more preferably from about 3 to about 10 and the most preferred *a* ranges from about 4 to about 8.

In another embodiment of the disclosure the NPCBs are represented by formula (AB)

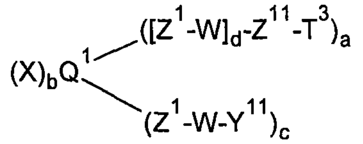

(AB)

where $Q^1$, X, $Z^1$, $Z^{11}$, $Y^{11}$, W, *b*, and *c* are as described above, *d* = 1 and $T^3$ is independently a substituted or unsubstituted $C_{10}$-$C_{30}$ polynuclear aryl. *a* ranges from about 2 to about 15, preferably *a* ranges from about 3 to about 12, more preferably from about 3 to about 10 and the most preferred *a* ranges from about 4 to about 8.

In another embodiment of the disclosure the NPCBs are represented by formula (AC)

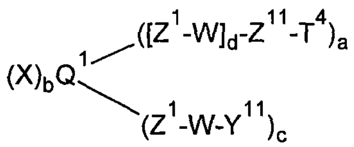

(AC)

where $Q^1$, X, $Z^1$, $Z^{11}$, $Y^{11}$, W, *b,* and *c* are as described above, *d* = 1 and $T^4$ independently is a substituted or unsubstituted $C_6$-$C_{30}$ polynuclear heteroaryl containing one or more oxygen, sulfur, or nitrogen atoms including mixtures thereof, *a* ranges from about 2 to about 15, preferably *a* ranges from about 3 to about 12, more preferably from about 3 to about 10 and the most preferred *a* ranges from about 4 to about 8.

In yet another embodiment of the disclosure the NPCBs are represented by formula (AD)

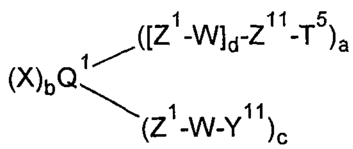

(AD)

where $Q^1$, X, $Z^1$, $Z^{11}$, $Y^{11}$, W, *b*, and *c* are as described above, *d* = 1 and $T^5$ is independently a nonaromatic Deep UV chromophore-containing at least one double bond conjugated with at least one electron withdrawing group. *a* ranges from about 2 to about 15, preferably *a* ranges from about 3 to about 12, more preferably from about 3 to about 10 and the most preferred *a* ranges from about 4 to about 8.

In another embodiment of the disclosure the NPCBs are represented by formula (AE)

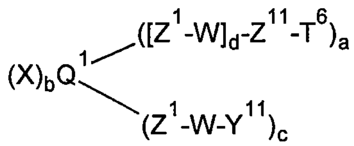

(AE)

where $Q^1$, X, $Z^1$, $Z^{11}$, $Y^{11}$, W, *b*, and *c* are as described above, *d* = 1 and $T^6$ is a mixture of two or more DUV chromophore-containing groups selected from the group consisting of $T^1$, $T^2$, $T^3$, $T^4$, and $T^5$. More preferably $T^6$ is a mixture of two DUV chromophore-containing groups selected from the group consisting of $T^1$, $T^2$, $T^3$, $T^4$, and $T^5$. *a* ranges from about 2 to about 15, preferably *a* ranges from about 3 to about 12, more preferably from about 3 to about 10 and the most preferred *a* ranges from about 4 to about 8.

In a preferred embodiment, the novel NPBs are represented by formula ($B^1$),

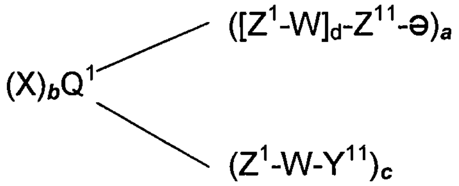

($B^1$)

where $Q^1$ is a multivalent organic nucleus, $Z^1$ and $Z^{11}$ are divalent linking groups, W is a divalent organic bridging group, ə is an organic substituent having little or no absorbance to DUV light, X is a reactive functional group, $Y^{11}$ is a reactive functional group, *a* ranges from about 2 to about 15, *b* ranges from zero to about 10, c ranges from zero to about 5, and *d* = 1, wherein $Q^1$, W, and ə together contain at least two groups or sites which are reactive in a crosslinking reaction with the proviso that the sum of (*a*+*b*+*c*) is greater than or equal to 3 and $Q^1$ is selected from the group consisting of:

a) an unsubstituted $C_2$-$C_{40}$ linear, branched, cyclic, or polycyclic aliphatic group not containing as an integral part of a ring or chain structure oxygen, sulfur, or nitrogen atoms;
b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
c) an unsubstituted $C_2$-$C_{40}$ aliphatic group containing both cyclic and acyclic components not containing as an integral part of a ring or chain structure oxygen, sulfur, or nitrogen atoms, and
d) an unsubstituted $C_2$-$C_{40}$ aliphatic group containing both cyclic and acyclic components and as an integral part of a ring or chain structure one or more oxygen, sulfur, or nitrogen atoms including mixtures thereof.

$Z^1$, $Z^{11}$, W, $Y^{11}$, X and the various preferred $Q^1$ are as described earlier for formula (A).

In one embodiment of the disclosure the NPBs are represented by formula (AF)

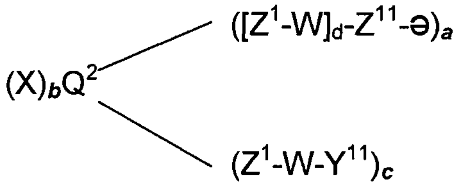

(AF)

where X, $Z^1$, $Z^{11}$, $Y^{11}$, W, *b*, and *c*, are as described above, *d* = 1, a is an organic substituent having little or no absorbance to DUV light and $Q^2$ is a multivalent organic nucleus consisting of an unsubstituted $C_2$-$C_{40}$ linear, branched, cyclic, or polycyclic aliphatic group not containing as an integral part of a ring or chain structure oxygen, sulfur, or nitrogen atoms, and *a* ranges from about 2 to about 15.

Preferably, $Q^2$ is a multivalent organic nucleus consisting of an unsubstituted $C_3$-$C_{24}$ linear, branched, or cyclic aliphatic group not containing as an integral part of a ring or chain structure oxygen, sulfur, or nitrogen atoms, and *a* ranges from about 3 to about 12.

More preferably, $Q^2$ is a multivalent organic nucleus consisting of an unsubstituted $C_4$-$C_{16}$ linear, or branched, aliphatic group not containing as an integral part of a ring or chain structure oxygen, sulfur, or nitrogen atoms, and *a* ranges from about 3 to about 10.

Most preferably, $Q^2$ is a multivalent organic nucleus consisting of an unsubstituted $C_6$-$C_{12}$ linear, or branched, aliphatic group not containing as an integral part of a ring or chain structure oxygen, sulfur, or nitrogen atoms, and *a* ranges from about 4 to about 8.

In one embodiment of the disclosure the NPBs are represented by formula (AG):

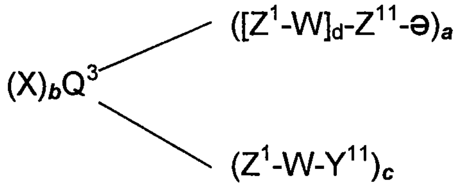

(AG)

where X, $Z^1$, $Z^{11}$, $Y^{11}$, W, *b*, and *c*, are as described above, *d* = 1, ə is an organic substituent having little or no absorbance to DUV light and $Q^3$ is a multivalent organic nucleus consisting of an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof, and *a* ranges from about 2 to about 15.

Preferably, $Q^3$ is a multivalent organic nucleus consisting of an unsubstituted $C_2$-$C_{24}$ linear, branched, or cyclic aliphatic group containing as an integral part of a ring or chain structure one or more oxygen, sulfur, or nitrogen atoms including mixtures thereof, and *a* ranges from about 3 to about 12.

More preferably, $Q^3$ is a multivalent organic nucleus consisting of an unsubstituted $C_3$-$C_{16}$ linear, or branched, aliphatic group containing as an integral part of a ring or chain structure one or more oxygen, sulfur, or nitrogen atoms including mixtures thereof, and *a* ranges from about 3 to about 10.

Most preferably, $Q^3$ is a multivalent organic nucleus consisting of an unsubstituted $C_4$-$C_{12}$ linear, or branched, aliphatic group containing as an integral part of a ring or chain structure one or more oxygen, sulfur, or nitrogen atoms including mixtures thereof, and *a* ranges from about 4 to about 8.

In one embodiment of the disclosure the NPBs are represented by formula (AH):

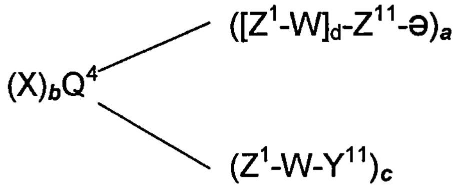

(AH)

where X, $Z^1$, $Z^{11}$, $Y^{11}$, W, *b*, and *c*, are as described above, *d* = 1, ə is an organic substituent having little or no absorbance to DUV light and $Q^4$ is an unsubstituted $C_6$-$C_{40}$ multivalent organic nucleus consisting of both cyclic and acyclic components not containing as an integral part of a ring or chain structure oxygen, sulfur, or nitrogen atoms, and *a* ranges from about 2 to about 15.

Preferably $Q^4$ is an unsubstituted $C_6$-$C_{28}$ multivalent organic nucleus consisting of both cyclic and acyclic components not containing as an integral part of a ring or chain structure oxygen, sulfur, or nitrogen atoms, and *a* ranges from about 3 to about 12.

More preferably $Q^4$ is an unsubstituted $C_7$-$C_{22}$ multivalent organic nucleus consisting of both cyclic and acyclic components not containing as an integral part of a ring or chain structure oxygen, sulfur, or nitrogen atoms, and *a* ranges from about 3 to about 10.

Most preferably $Q^4$ is an unsubstituted $C_8$-$C_{18}$ multivalent organic nucleus consisting of both cyclic and acyclic components not containing as an integral part of a ring or chain structure oxygen, sulfur, or nitrogen atoms, and *a* ranges from about 4 to about 8.

In one embodiment of the disclosure the NPBs are represented by formula (AI):

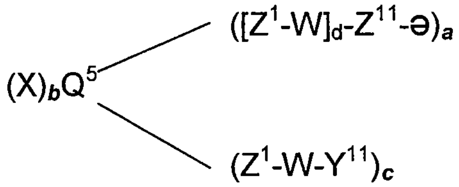

(AI)

where X, $Z^1$, $Z^{11}$, $Y^{11}$, W, *b*, and *c*, are as described above, *d* = 1, ə is an organic substituent having little or no absorbance to DUV light and $Q^5$ is an unsubstituted $C_5$-$C_{40}$ multivalent organic nucleus consisting of both cyclic and acyclic components containing as an integral part of a ring or chain structure one or more oxygen, sulfur, or nitrogen atoms including mixtures thereof, and *a* ranges from about 2 to about 15.

Preferably $Q^5$ is an unsubstituted $C_5$-$C_{24}$ multivalent organic nucleus consisting of both cyclic and acyclic components containing as an integral part of a ring or chain structure one or more oxygen, sulfur, or nitrogen atoms including mixtures thereof, and *a* ranges from about 3 to about 12.

More preferably $Q^5$ is an unsubstituted $C_6$-$C_{20}$ multivalent organic nucleus consisting of both cyclic and acyclic components containing as an integral part of a ring or chain structure one or more oxygen, sulfur, or nitrogen atoms including mixtures thereof, and *a* ranges from about 3 to about 10.

Most preferably $Q^5$ is an unsubstituted $C_6$-$C_{16}$ multivalent organic nucleus consisting of both cyclic and acyclic components containing as an integral part of a ring or chain structure one or more oxygen, sulfur, or nitrogen atoms including mixtures thereof, and *a* ranges from about 4 to about 8.

In another embodiment of the disclosure the NPBs are represented by formula (AJ)

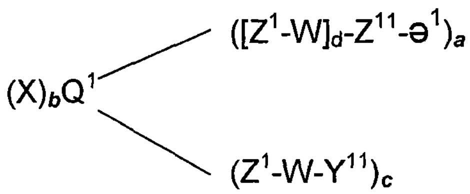

(AJ)

where $Q^1$, X, $Z^1$, $Z^{11}$, $Y^{11}$, W, *b*, and *c* are as described above, *d* = 1 and $ə^1$ is H. *a* ranges from about 2 to about 15, preferably *a* ranges from about 3 to about 12, more preferably from about 3 to about 10 and the most preferred *a* ranges from about 4 to about 8.

In another embodiment of the disclosure the NPBs are represented by formula (AK)

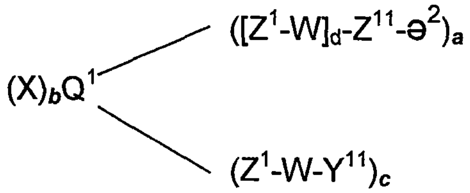

(AK)

where $Q^1$, X, $Z^1$, $Z^{11}$, $Y^{11}$, W, *b*, and *c* are as described above, *d* = 1 and $ə^2$ is a substituted or unsubstituted $C_1$-$C_{24}$ linear, branched, cyclic, or polycyclic alkyl or alkenyl not containing as an integral part of a ring or chain structure oxygen, sulfur, or nitrogen atoms. *a* ranges from about 2 to about 15, preferably *a* ranges from about 3 to about 12, more preferably from about 3 to about 10 and the most preferred *a* ranges from about 4 to about 8.

In another embodiment of the disclosure the NPBs are represented by formula (AL)

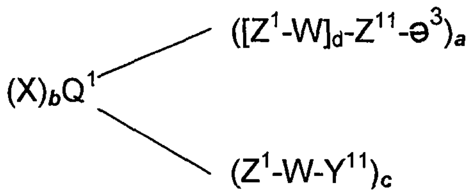

(AL)

where $Q^1$, X, $Z^1$, $Z^{11}$, $Y^{11}$, W, *b*, and *c* are as described above, *d* = 1 and $ə^3$ is a substituted or unsubstituted $C_1$-$C_{24}$ linear, branched, cyclic, or polycyclic alkyl or alkenyl containing as an integral part of a ring or chain structure one or more oxygen, sulfur, or nitrogen atoms including mixtures thereof. *a* ranges from about 2 to about 15, preferably *a* ranges from about 3 to about 12, more preferably from about 3 to about 10 and the most preferred *a* ranges from about 4 to about 8.

In another embodiment of the disclosure the NPBs are represented by formula (AM)

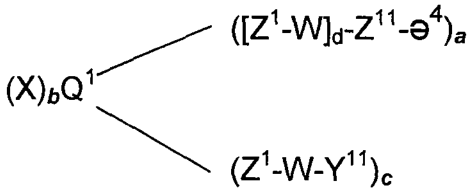

(AM)

where $Q^1$, X, $Z^1$, $Z^{11}$, $Y^{11}$, W, *b*, and *c* are as described above, *d* = 1 and ə$^{4}$ is a mixture of two or more of ə$^{1}$ or ə$^{2}$ or ə$^{3}$. *a* ranges from about 2 to about 15, preferably *a* ranges from about 3 to about 12, more preferably from about 3 to about 10 and the most preferred *a* ranges from about 4 to about 8.

The present disclosure provides semiconductor substrate coating compositions that employ nonpolymeric binders (NPBs) to create bottom antireflective coatings and aperture fill compositions with tunable plasma etch rates, virtually no intermixing with photoresist films, excellent substrate adhesion, and tunable optical properties. They are suitably used with either positive or negative tone photoresist films for producing high resolution relief images on substrates for the production of semiconductor, electronic, and optical devices.

The following examples are provided to illustrate the principles and practice of the present disclosure more clearly. It should be understood that the present disclosure is not limited to the examples described.

**Synthesis Example 1**

Synthesis of NPCB-1

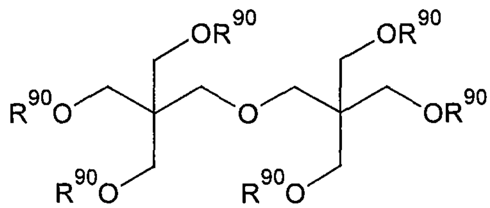

$R^{90}$ = 40% H, 60%

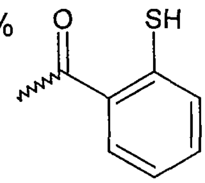

Dipentaerythritol (5.57 g, 19.7 mmol) and thiosalicylic acid (18.81 g, 118 mmol) were dispersed in toluene (18 ml) in a 100 ml, three-neck flask. Concentrated sulfuric acid (two drops) was added and the flask was heated with stirring to 120 °C for six hours. The reaction mixture was cooled to room temperature and washed with deionized water until the pH of the aqueous layer was neutral. The organic phase was separated and dried over magnesium sulfate. The solution was filtered and the solvent removed by rotary evaporation to yield a viscous liquid. $^{1}H$ NMR spectroscopy indicated an average of 3.6 mercaptobenzoate groups/dipentaerythritol. The product was dissolved in PGMEA to give a 35.5 wt% solution which was used without further purification.

**Synthesis Example 2**

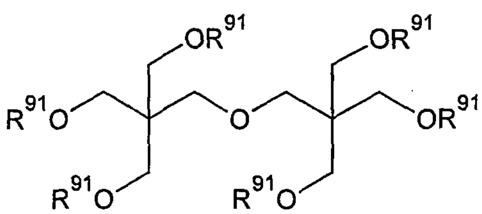

$R^{91}$ = 15% H, 85%

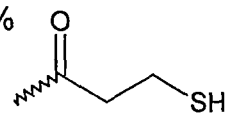

Dipentaerythritol (30.32 g, 0.107 mol) and 3-mercaptopropionic acid (78.84 g, 0.743 mol) were dispersed in toluene (34 ml) in a 250 ml, three-neck flask. Concentrated sulfuric acid (four drops) was added and the flask was heated with stirring to 120 °C for six hours. The reaction mixture was cooled to room temperature and washed with deionized water until the pH of the aqueous layer was neutral. The organic phase was separated and dried over magnesium sulfate.

The solution was filtered and the solvent removed by rotary evaporation to yield a viscous liquid. $^1$H NMR spectroscopy indicated an average of 5.1 mercaptopropionate groups/dipentaerythritol. The product was dissolved in THF to give a 51.5 wt% solution which was used without further purification.

**Synthesis Example 3**

Synthesis of NPCB-2

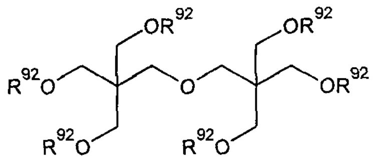

$R^{92}$ = 15% H, 32%

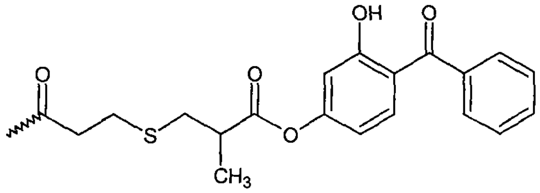

53%

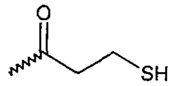

A 50 ml, one-neck flask was charged with the solution prepared in Synthesis Example 2 (7.79 g, 5.8 mmol), 2-hydroxy-4-(methacryloyloxy)benzophenone (3.44 g, 11.6 mmol), dimethyl-2,2'-azobis(2-methylpropionate) (0.13 g, 0.56 mmol) and THF (8.19 g). The solution was heated with stirring in an oil bath at 65 °C for 24 hours. The solution was cooled to room temperature and the solvent removed by rotary evaporation to yield a viscous liquid. $^1$H NMR spectroscopy indicated an average of 1.9 hydroxybenzophenone groups/dipentaerythritol. The product was dissolved in PGMEA to give a 44.7 wt% solution which was used without further purification.

**Synthesis Example 4**

Synthesis of NPCB-3

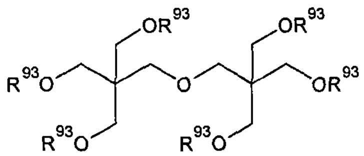

$R^{93}$ = 15% H, 48%

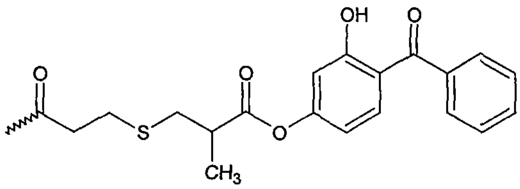

37%

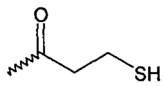

A 50 ml, one-neck flask was charged with the solution prepared in Synthesis Example 2 (3.85 g, 2.9 mmol), 2-hydroxy-4-(methacryloyloxy)benzophenone (2.57 g, 8.7 mmol), dimethyl-2,2'-azobis(2-methylpropionate) (0.03 g, 0.13 mmol) and THF (3.26 g). The solution was heated with stirring in an oil bath at 65 °C for 24 hours. The solution was cooled to room temperature and the solvent removed by rotary evaporation to yield a viscous liquid. $^1$H NMR spectroscopy indicated an average of 2.9 hydroxybenzophenone groups/dipentaerythritol. The product was dissolved in PGMEA to give a 45.5 wt% solution which was used without further purification.

**Synthesis Example 5**

Synthesis of NPCB-4

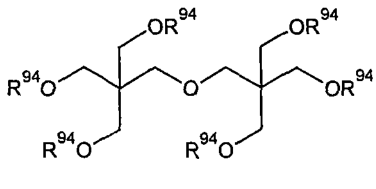

$R^{94}$ = 15% H, 70% 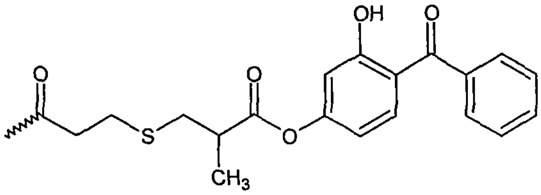 15% 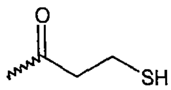

A 50 ml, one-neck flask was charged with the solution prepared in Synthesis Example 2 (3.92 g, 2.9 mmol), 2-hydroxy-4-(methacryloyloxy)benzophenone (3.42 g, 11.5 mmol), dimethyl-2,2'-azobis(2-methylpropionate) (0.39 g, 1.7 mmol) and THF (5.80 g). The solution was heated with stirring in an oil bath at 65 °C for 24 hours. The solution was cooled to room temperature and the solvent removed by rotary evaporation to yield a viscous liquid. $^1$H NMR spectroscopy indicated an average of 4.2 hydroxybenzophenone groups/dipentaerythritol. The product was dissolved in PGMEA to give a 38.5 wt% solution which was used without further purification.

**Synthesis Example 6**

Synthesis of NPCB-5

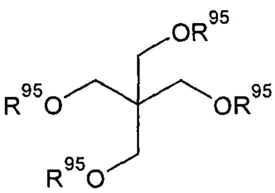

$R^{95}$ = 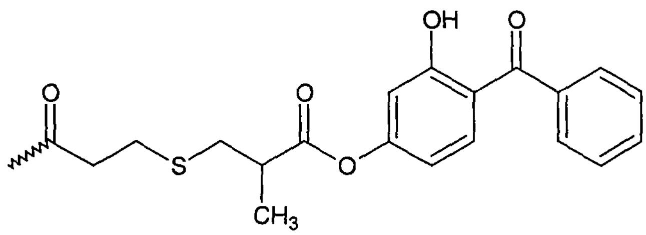

Pentaerythritol tetrakis(3-mercaptopropionate) (1.09 g, 2.2 mmol), 2-hydroxy-4-(methacryloyloxy)benzophenone (2.57 g, 8.7 mmol), and dimethyl-2,2'-azobis(2-methylpropionate) (0.26 g, 1.1 mmol) were dissolved in THF (5.11 g) in a 50 ml, one-neck flask. The solution was heated with stirring in an oil bath at 65 °C for 24 hours. The solution was cooled to room temperature and the solvent removed by rotary evaporation to yield a viscous liquid. $^1$H NMR spectroscopy indicated 4.3 hydroxybenzophenone groups/pentaerythritol. The product was dissolved in PGMEA to give a 33.4 wt% solution which was used without further purification.

**Synthesis Example 7**

Synthesis of NPCB-6

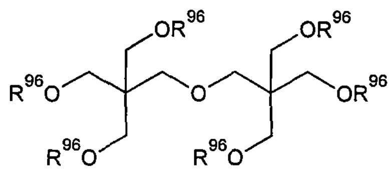

$R^{96}$ = 15% H, 35% 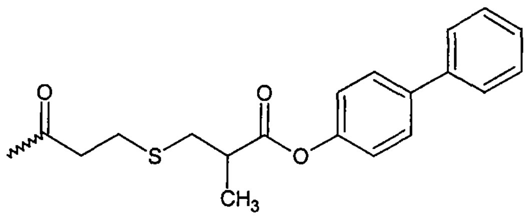 50% 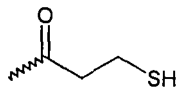

A 50 ml, one-neck flask was charged with the solution prepared in Synthesis Example 2 (7.73 g, 5.8 mmol), biphenyl methacrylate (2.75 g, 11.5 mmol), dimethyl-2,2'-azobis(2-methylpropionate) (0.03 g, 0.13 mmol) and THF (6.32 g). The solution was heated with stirring in an oil bath at 65 °C for 24 hours. The solution was cooled to room temperature and the solvent removed by rotary evaporation to yield a viscous liquid. $^1$H NMR spectroscopy indicated an average of 2.1 biphenyl groups/dipentaerythritol. The product was dissolved in PGMEA to give a 58.3 wt% solution which was used without further purification.

**Synthesis Example 8**

Synthesis of NPCB-7

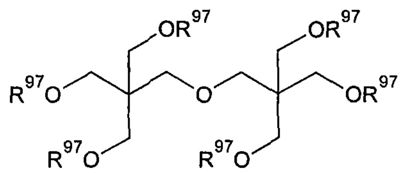

$R^{97}$ = 15% H, 53% 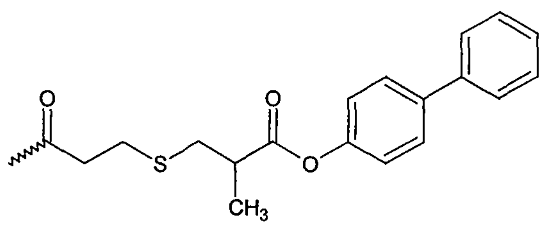 32% 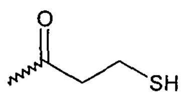

A 50 ml, one-neck flask was charged with the solution prepared in Synthesis Example 2 (7.71 g, 5.8 mmol), 4-biphenyl methacrylate (4.11 g, 17.2 mmol), dimethyl-2,2'-azobis(2-methylpropionate) (0.05 g, 0.22 mmol) and THF (8.48 g). The solution was heated with stirring in an oil bath at 65 °C for 24 hours. The solution was cooled to room temperature and the solvent removed by rotary evaporation to yield a viscous liquid. $^1$H NMR spectroscopy indicated an average of 3.2 biphenyl groups/dipentaerythritol. The product was dissolved in PGMEA to give a 70.6 wt% solution which was used without further purification.

**Synthesis Example 9**

Synthesis of NPCB-8

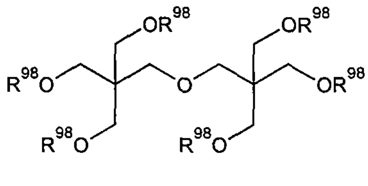

$R^{98}$ = 15% H, 85%

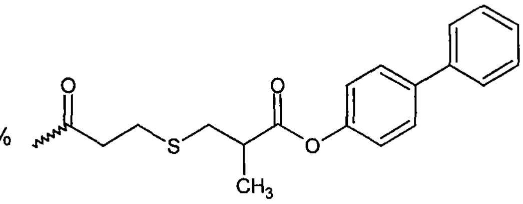

A 50 ml, one-neck flask was charged with the solution prepared in Synthesis Example 2 (3.85 g, 2.9 mmol), 4-biphenyl methacrylate (3.46 g, 14.5 mmol), dimethyl-2,2'-azobis(2-methylpropionate) (0.05 g, 0.22 mmol) and THF (6.32 g). The solution was heated with stirring in an oil bath at 65 °C for 24 hours. The solution was cooled to room temperature and the solvent removed by rotary evaporation to yield a solid. $^1$H NMR spectroscopy indicated an average of 5.1 biphenyl groups/dipentaerythritol. The product was dissolved in PGMEA to give a 40.0 wt% solution which was used without further purification.

**Synthesis Example 10**

Synthesis of NPB-1

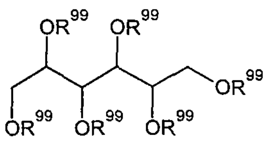

$R^{99}$ = 50% H, 50%

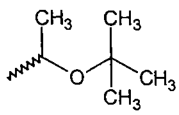

A 50-mL, one-neck flask was charged with d-sorbitol (1.16 g, 0.0064 mol), t-butyl vinyl ether (3.84 g, 0.0383 mol), p-toluenesulfonic acid solution in ethyl acetate (0.06 g, 2% w/w). The solution was stirred at room temperature for 4 hours. CR-20 ion exchange resin (0.7 g) was added to the flask. The solution was filtered and solvent removed by rotary evaporation to yield a white solid. $^1$H NMR spectroscopy indicated an average of three t-butyl acetal groups per sorbitol. The product was dissolved in PGMEA to give a 35 wt% solution which was used without further purification.

**Synthesis Example 11**

Synthesis of NPB-2

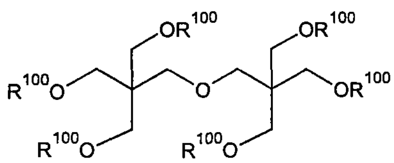

$R^{100}$ =

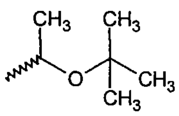

A 50-mL, one-neck flask was charged with dipentaerythritol (1.49 g, 0.0059 mol), t-butyl vinyl ether (3.51 g, 0.0350 mol), p-toluenesulfonic acid solution in ethyl acetate (0.07 g, 2% w/w). The solution was stirred at room temperature for 4 hours. CR-20 ion exchange resin (0.7 g) was added to the flask. The solution was filtered and solvent removed by rotary evaporation to yield a white solid. $^1$H NMR spectroscopy indicated an average of six t-butyl acetal groups per dipentaerythritol. The product was dissolved in PGMEA to give a 35 wt% solution which was used without further purification.

**Formulation Examples**

Antireflective compositions were formulated in an amber bottle by mixing the NPCB solution as prepared in the Synthesis Examples, a 5 wt% solution of Crosslinker in PGMEA, TAG (either as a solid or as a 1 wt% solution in PGMEA), a 0.1 wt% solution of Surfactant in PGMEA (if added) and solvent to adjust the solid content of the formulation. The

mixture was then rolled overnight, and the antireflective composition filtered through a 0.20 μm Teflon filter. Exact amounts of the components are listed in Table 1 below.

**Table 1. Formulation Compositions**

| Form. Ex. | NPCB (amount, g) | Crosslinker (amount, g) | TAG (amount, g) | Surfactant (amount, mg) | Solvent (amount, g) |
|---|---|---|---|---|---|
| 1 | NPCB-1 (0.088) | CLR-19MF (0.023) | 2168E (0.002) | - | PGMEA (1.388) |
| 2 | NPCB-1 (0.089) | CLR-19MF (0.023) | 2168E (0.001) | - | PGMEA (1.388) |
| 3 | NPCB-1 (0.099) | MW100LM (0.011) | 2168E (0.002) | - | PGMEA (1.388) |
| 4 | NPCB-1 (0.100) | MW100LM (0.011) | 2168E (0.001) | - | PGMEA (1.388) |
| 5 | NPCB-1 (0.395) | CLR-19MF (0.100) | 2168E (0.005) | R-08 (0.05) | PGMEA (9.500) |
| 6 | NPCB-1 (0.420) | MW100LM (0.075) | 2168E (0.005) | R-08 (0.05) | PGMEA (9.500) |
| 7 | NPCB-1 (0.0.792) | MW100LM (0.090) | 2168E (0.018) | R-08 (0.09) | PGMEA (11.100) |
| 8 | NPCB-2 (0.390) | CLR-19MF (0.100) | 2168E (0.010) | FC-430 (0.05) | PGMEA (9.500) |
| 9 | NPCB-2 (0.176) | MW100LM (0.020) | 2168E (0.004) | FC-430 (0.02) | PGMEA (3.800) |
| 10 | NPCB-3 (0.585) | CLR-19MF (0.150) | 2168E (0.015) | FC-430 (0.08) | PGMEA (14.250) |
| 11 | NPCB-4 (0.585) | CLR-19MF (0.150) | 2168E (0.015) | FC-430 (0.08) | PGMEA (14.250) |
| 12 | NPCB-4 (0.667) | MW100LM (0.075) | 2168E (0.008) | FC-430 (0.08) | PGMEA (14.250) |
| 13 | NPCB-4 (0.440) | MW100LM (0.050) | CXC-1614 (0.010) | FC-430 (0.05) | PGMEA (9.500) |
| 14 | NPCB-5 (0.390) | CLR-19MF (0.100) | 2168E (0.010) | FC-430 (0.05) | PGMEA (9.500) |
| 15 | NPCB-6 (0.390) | CLR-19MF (0.100) | 2168E (0.010) | FC-430 (0.05) | PGMEA (9.500) |
| 16 | NPCB-7 (0.585) | CLR-19MF (0.150) | 2168E (0.015) | FC-430 (0.08) | PGMEA (14.250) |
| 17 | NPCB-7 (0.667) | MW100LM (0.075) | 2168E (0.008) | FC-430 (0.08) | PGMEA (14.250) |
| 18 | NPCB-7 (0.440) | MW100LM (0.050) | CXC-1614 (0.010) | FC-430 (0.05) | PGMEA (9.500) |
| 19 | NPCB-8 (0.585) | CLR-19MF (0.150) | 2168E (0.015) | FC-430 (0.08) | PGMEA (14.250) |
| 20 | NPCB-8 (0.667) | MW100LM (0.075) | 2168E (0.008) | FC-430 (0.08) | PGMEA (14.250) |

**CLR-19-MF** is an alkoxymethylphenyl derivative crosslinker from Honshu Chemicals Industries Co. Ltd, Japan.
**MW100LM** is a melamine crosslinker from Sanwa Chemical Co. Ltd., Kanaxawa-ken, Japan.
TAGs **2168E** and **CXC-1614** are commercially available from King Industries Inc., USA.
**R-08** is a nonionic fluorinated acrylic copolymer-based surfactant available from Dainippon Ink & Chemical of Japan.
**FC-430** is a nonionic fluoroaliphatic polymeric ester surfactant commercially available from 3M Company, USA.

**Lithographic Evaluation Procedure**

Silicon wafers were spin coated with a thermally curable antireflective composition and baked (dried and cured) on a hotplate at 205 °C for 90 seconds resulting in a B.A.R.C. film thickness of 80-106 nm.

A photoresist (similar to Example 18 in U.S. Patent Application 2007/0105045) was then spin coated over the B.A.R.C. and post-apply baked (PAB) at 100 °C for either 60 or 90 seconds to achieve a target film thickness of approximately 120 nm. Subsequently, the coated substrate was exposed with a patterned exposure array using quadrupole illumination with an ArF excimer laser (193 nm) applied by an ASML PASS 5500/1100 stepper with a numerical aperture (NA) of 0.75 and a Sigma of 0.92/0.72. A 6% attenuated phase shift reticle was used to pattern the photoresist film. The exposed wafers were then subjected to post-exposure bake (PEB) treatment on a hotplate at 100 °C for either 60 or 90 seconds. The PEB-treated wafers were then puddle developed with a 2.38 wt% aqueous solution of tetramethylammonium hydroxide (TMAH). The developed wafers were rinsed with deionized water and spun dry.

The resulting resist patterns were analyzed by using a KLA eCD-2 top-down scanning electron microscope for sizing energy (Esize) and depth of focus (DOF). Esize was defined as the exposure energy required to reproduce the target dimension, as predefined by the reticle. DOF was defined as the range of focal positions where the printed dimension did not deviate from +/- 10% of the target dimension, based on the sizing energy at optimal focus. The wafers were then sheared cross-sectionally across the photoresist relief image and the profiles were examined using a Hitachi S4300 SEM.

The photoresist / B.A.R.C. stack exhibited good resolution allowing the patterning of dense 75 nm lines/spaces.

The photoresist / B.A.R.C. interface exhibited no significant intermixing with the profiles of the relief pattern appearing comparable to those formed on a commercially available B.A.R.C..

**Table 2. Lithographic Results**

| Litho Ex. | Form. Ex. | B.A.R .C. FT (nm) | PAB (°C/sec) | Photoresist FT (nm) | PAB (°C/sec) | PEB (°C/sec) | Target Feature | Esize ($mJ/cm^2$) | DOF (□m) |
|---|---|---|---|---|---|---|---|---|---|
| 1 | 5 | 83 | 205/90 | 120 | 100/90 | 100/90 | 75nm l/s 150nm pitch | 31 | 0.60 |
| 2 | 6 | 81 | 205/90 | 119 | 100/60 | 100/90 | 75nm l/s 150nm pitch | 33 | - |
| 3 | 7 | 106 | 205/90 | 123 | 100/60 | 100/60 | 75nm l/s 150nm pitch | 37 | - |
| 4 | 10 | 80 | 205/90 | 120 | 100/90 | 100/90 | 75nm l/s 150nm pitch | 32 | 0.65 |
| 5 | 15 | 80 | 205/90 | 120 | 100/60 | 100/60 | 75nm l/s 150nm pitch | 29 | 0.40 |
| 6 | 16 | 80 | 205/90 | 120 | 100/60 | 100/60 | 75nm l/s 150nm pitch | 30 | 0.65 |
| 7 | 19 | 80 | 205/90 | 120 | 100/60 | 100/60 | 75nm l/s 150nm pitch | 30 | 0.70 |

l/s = lines/spaces

PLASMA ETCH AND OPTICAL DATA

The B.A.R.C. composition was spin coated onto a silicon wafer and baked on a hotplate at 205 °C for 90 sec to form a 145-170 nm B.A.R.C. film. The real refractive index (n) and extinction coefficient (k) of the B.A.R.C. film was measured by ellipsometry. The B.A.R.C. was etched using a HBr/$O_2$ transformer coupled plasma (TCP) (Pressure: 5mTorr; Temperature: 60 °C; HBr flow rate: 30 sccm; O2 flow rate: 30 sccm; Time: 20 sec; rf power: 250 W). In addition, as the amount and nature of the chromophore group is varied, the optical properties (n & k) of the B.A.R.C. can be altered in a controlled manner. As the table below clearly indicates, antireflective compositions of the present disclosure provide B.A.R.C.s with tunable plasma etch rates and controlled optical properties.
The results are shown in Table 3

**TABLE 3**

| Form. Ex. | B.A.R.C. FT (nm) | PAB (°C/sec) | n | k | Etch Rate (nm/sec) |
|---|---|---|---|---|---|
| 11 | 162 | 205/90 | 1.679 | 0.458 | 15.2 |
| 13 | 166 | 205/90 | 1.739 | 0.392 | 19 |
| 18 | 148 | 205/90 | 1.562 | 0.347 | 16.4 |
| 19 | 169 | 205/90 | 1.556 | 0.469 | 11.4 |
| 20 | 168 | 205/90 | 1.582 | 0.421 | 14.3 |
| ARC 29A | | | | | 17 |
| Resist | | | | | 1.7 |

**General Formulation Procedure 1**

Semiconductor substrate coating compositions of the present invention are formulated in an amber bottle by mixing a solution of the binder (NPB or NPCB) in PGMEA, a 5 wt% solution of Crosslinker in PGMEA, TAG (either as a solid or as a 1 wt% solution in PGMEA), 0.5 mg of a 0.1 wt% solution of Surfactant in PGMEA (if added) and PGMEA to adjust the solids content of the formulation. The formulations are mixed by rolling overnight or until all components are completely dissolved. The semiconductor substrate coating composition is then filtered through a 0.20 μm Teflon filter. Exact amounts of the formulation components are listed in Table 4 below.

**Table 4. Formulation Compositions**

| Form. Ex. | Binder (amount, g) | Crosslinker (amount, g) | TAG (amount, g) | Solvent 1/Solvent 2 (amount, g) |
|---|---|---|---|---|
| 21 | $A^0$-4 (4.50) | MW100LM (0.60) | 2168E (0.075) | PGMEA (94.82) |
| 22 | $A^0$-5 (4.30) | MW100LM (0.65) | | PGMEA (95.05) |
| 23 | $A^0$-7 (4.25) | MW100LM (0.65) | | PGMEA (95.10) |
| 24 | $A^0$-10 (3.90) | MW100LM (0.50) | 2168E / CXC-1614 (0.035 / 0.065) | PGMEA (95.50) |
| 25 | $A^0$-11 (4.75) | MW100LM (0.70) | 2168E (0.070) | PGMEA (94.48) |
| 26 | $A^0$-13 (4.00) | MW100LM (0.70) | | PGMEA (95.30) |
| 27 | $A^0$-14 / A-42 (3.25 / 3.25) | MW100LM (0.80) | 2168E (0.100) | PGMEA (92.60) |
| 28 | $A^0$-15 (5.00) | MW100LM (0.75) | CXC-1614 (0.12) | PGMEA (94.13) |
| 29 | $A^0$-16 / A-38 (2.50/ 2.50) | MW100LM (0.80) | 2168E (0.100) | PGMEA / 2-heptanone (70.58/23.52) |
| 30 | $A^0$-17 (6.50) | MW100LM (0.75) | 2168E (0.075) | PGMEA (92.68) |
| 31 | $A^0$-20 (3.85) | MW100LM (0.55) | 2168E (0.055) | PGMEA (95.55) |
| 32 | $A^0$-21 (4.40) | MW100LM (0.50) | 2168E (0.050) | PGMEA (95.05) |
| 33 | A-30 (5.25) | MW100LM (0.70) | 2168E (0.065) | PGMEA (93.99) |
| 34 | A-31 (4.00) | CLR-19MF (1.00) | 2168E (0.100) | PGMEA (94.90) |
| 35 | A-38 (5.00) | CLR-19MF (1.30) | 2168E (0.130) | PGMEA (93.57) |
| 36 | A-39 (6.50) | MW100LM (0.75) | 2168E (0.080) | PGMEA / 2-heptanone (74.14 / 18.53) |

(continued)

| Form. Ex. | Binder (amount, g) | Crosslinker (amount, g) | TAG (amount, g) | Solvent 1/Solvent 2 (amount, g) |
|---|---|---|---|---|
| 37 | A-42 (4.40) | CLR-19MF (1.15) | 2168E (0.120) | PGMEA (94.33) |
| 38 | A-43 (6.00) | CLR-19MF (1.50) | 2168E / CXC-1614 (0.075 / 0.090) | PGMEA (92.34) |
| 39 | A-50 (6.67) | MW100LM (0.75) | 2168E (0.080) | PGMEA (92.50) |

**General Planarization Procedure 1**

Semiconductor substrates having varied topography, including but not limited to, high (> 1) aspect ratio apertures are spin coated with a thermally curable semiconductor substrate coating composition of the present invention and baked to dry and cure the film on a hotplate at 205 °C for 60 seconds resulting in a planarized film having a thickness (above the existing topography) of 50-120 nm.

**General Planarization Procedure 2**

Semiconductor substrates having varied topography, including but not limited to, high (> 1) aspect ratio apertures are spin coated with a thermally curable semiconductor substrate coating composition of the present invention and baked to dry and partially cure the film on a hotplate at 130 °C for 90 seconds resulting in a planarized film having a thickness (above the existing topography) of 50-100 nm.

**General Lithographic Procedure 1**

A photoresist composition is spin coated over a B.A.R.C. of the present invention (prepared using either General Planarization Procedure 1 or 2) and post-apply baked (PAB) at 120 °C for 60 seconds to achieve a target film thickness of approximately 120 nm. Subsequently, the coated substrate is exposed with a patterned exposure array using an ArF excimer laser (193 nm). The exposed wafers are then subjected to post-exposure bake (PEB) treatment on a hotplate at 120 °C for 60 seconds. The PEB-treated wafers are then puddle developed with a 2.38 wt% aqueous solution of tetramethylammonium hydroxide (TMAH). The developed wafers are rinsed with deionized water and spun dry.

**Lithographic Examples 8-16**

Formulations for Lithographic Examples 8-16 are prepared using General Formulation Procedure 1 and are lithographically evaluated using General Lithographic Procedure 1.

**Table 5. Lithographic Results: Examples 8-16**

| Litho Ex. | Form. Ex. | B.A.R.C. FT (nm) | Photoresist FT (nm) |
|---|---|---|---|
| 8 | 33 | 75 | 125 |
| 9 | 34 | 50 | 120 |
| 10 | 30 | 100 | 115 |
| 11 | 36 | 80 | 120 |
| 12 | 27 | 120 | 120 |
| 13 | 38 | 90 | 125 |
| 14 | 37 | 95 | 118 |
| 15 | 39 | 65 | 122 |
| 16 | 29 | 100 | 120 |

The B.A.R.C. / photoresist interface exhibits no significant intermixing and the profiles of the relief pattern are comparable to those formed on a commercially-available B.A.R.C.. Cross sectional scanning electron micrographs indicate superior aperture filling compared to a commercial B.A.R.C..

### General Lithographic Procedure 2

A commercially-available antireflective coating composition (such as ARC27 available from Brewer Science, Rolla, MO) is spin coated over a planarized substrate previously coated with an aperture fill composition of the present invention (prepared using General Planarization Procedure 1) and post-apply baked (PAB) at 200 °C for 90 seconds to achieve a target B.A.R.C. film thickness of approximately 30 nm. A photoresist composition is spin coated over the B.A.R.C. and post-apply baked (PAB) at 130 °C for 60 seconds to achieve a target film thickness of approximately 100 nm. Subsequently, the coated substrate is exposed with a patterned exposure array using an ArF excimer laser (193 nm). The exposed wafers are then subjected to post-exposure bake (PEB) treatment on a hotplate at 120 °C for 60 seconds. The PEB-treated wafers are then puddle developed with a 2.38 wt% aqueous solution of tetramethylammonium hydroxide (TMAH). The developed wafers are rinsed with deionized water and spun dry.

### Lithographic Examples 18-22

Formulations for Lithographic Examples 18-22 are prepared using General Formulation Procedure 1 and are lithographically evaluated using General Lithographic Procedure 2.

**Table 6. Lithographic Results: Examples 18-22**

| Litho Ex. | Form. Ex. | Aperture Fill FT (nm) | B.A.R.C. FT (nm) | Photoresist FT (nm) |
|---|---|---|---|---|
| 18 | 22/ARC27 | 75 | 30 | 100 |
| 19 | 25/ARC27 | 80 | 30 | 105 |
| 20 | 23/ARC27 | 100 | 30 | 95 |
| 21 | 30/ARC27 | 50 | 30 | 105 |
| 22 | 21/ARC27 | 120 | 30 | 100 |

The aperture fill / B.A.R.C. interface exhibited no significant intermixing and the profiles of the relief pattern are superior and more uniformed compared to those formed on a commercially-available B.A.R.C. alone. Cross sectional scanning electron micrographs indicate superior aperture filling compared to a commercial B.A.R.C..

### General Lithographic Procedure 3

An antireflective composition of the present invention is spin coated over a planarized substrate previously coated with an aperture fill composition of the present invention (prepared using General Planarization Procedure 1) and post-apply baked (PAB) at 205 °C for 60 seconds to achieve a target B.A.R.C. film thickness of approximately 150 nm. A photoresist composition is spin coated over the B.A.R.C. and post-apply baked (PAB) at 125 °C for 60 seconds to achieve a target film thickness of approximately 120 nm. Subsequently, the coated substrate is exposed with a patterned exposure array using an ArF excimer laser (193 nm). The exposed wafers are then subjected to post-exposure bake (PEB) treatment on a hotplate at 130 °C for 60 seconds. The PEB-treated wafers are then puddle developed with a 2.38 wt% aqueous solution of tetramethylammonium hydroxide (TMAH). The developed wafers are rinsed with deionized water and spun dry.

### Lithographic Examples 23-32

Formulations for Lithographic Examples 23-32 are prepared using General Formulation Procedure 1 and are lithographically evaluated using General Lithographic Procedure 3.

**Table 7. Lithographic Results: Examples 23-32**

| Litho Ex. | Form. Ex. | Aperture Fill FT (nm) | B.A.R.C. FT (nm) | Photoresist FT (nm) |
|---|---|---|---|---|
| 23 | 26/29 | 75 | 150 | 125 |
| 24 | 28/35 | 80 | 152 | 120 |
| 25 | 21/38 | 100 | 155 | 115 |
| 26 | 30/39 | 50 | 150 | 120 |
| 27 | 31/33 | 120 | 145 | 120 |
| 28 | 32/33 | 90 | 148 | 125 |

(continued)

| Litho Ex. | Form. Ex. | Aperture Fill FT (nm) | B.A.R.C. FT (nm) | Photoresist FT (nm) |
|---|---|---|---|---|
| 29 | 22/34 | 95 | 150 | 118 |
| 30 | 23/33 | 95 | 150 | 118 |
| 31 | 24/39 | 95 | 150 | 118 |
| 32 | 25/35 | 95 | 150 | 118 |

The aperture fill / B.A.R.C. / photoresist interfaces exhibit no significant intermixing and the profiles of the relief pattern appear superior and more uniform compared to those formed on a commercially-available B.A.R.C.. Cross sectional scanning electron micrographs indicate superior aperture filling compared to a commercial B.A.R.C..

**General Lithographic Procedure 4**

A second antireflective composition of the present invention is spin coated over a planarized substrate previously coated with a first antireflective composition of the present invention (prepared using General Planarization Procedure 1) and post-apply baked (PAB) at 180 °C for 90 seconds to achieve a target B.A.R.C. film thickness of approximately 180 nm. A photoresist composition is spin coated over the B.A.R.C. and post-apply baked (PAB) at 130 °C for 60 seconds to achieve a target film thickness of approximately 100 nm. Subsequently, the coated substrate is exposed with a patterned exposure array using an ArF excimer laser (193 nm). The exposed wafers are then subjected to post-exposure bake (PEB) treatment on a hotplate at 130 °C for 60 seconds. The PEB-treated wafers are then puddle developed with a 2.38 wt% aqueous solution of tetramethylammonium hydroxide (TMAH). The developed wafers are rinsed with deionized water and spun dry.

**Lithographic Examples 33-38**

Formulations for Lithographic Examples 33-38 are prepared using General Formulation Procedure 1 and are lithographically evaluated using General Lithographic Procedure 4.

**Table 8. Lithographic Results: Examples 33-38**

| Litho Ex. | Form. Ex. | B.A.R.C.1 FT (nm) | B.A.R.C .2 FT (nm) | Photoresis t FT (nm) |
|---|---|---|---|---|
| 33 | 36/37 | 60 | 80 | 100 |
| 34 | 37/27 | 60 | 100 | 100 |
| 35 | 37/27 | 80 | 100 | 105 |
| 36 | 35/29 | 75 | 90 | 98 |
| 37 | 38/35 | 60 | 90 | 102 |
| 38 | 34/39 | 50 | 50 | 100 |

The lower B.A.R.C. / upper B.A.R.C. / photoresist interfaces exhibits no significant intermixing and the profiles of the relief pattern appear superior and more uniform compared to those formed on a commercially-available B.A.R.C.. Cross sectional scanning electron micrographs indicate superior aperture filling compared to a commercial B.A.R.C..

While this disclosure has been described herein with reference to the specific embodiments thereof, it will be appreciated that changes, modification and variations can be made without departing from the scope of the inventive concept disclosed herein. Accordingly, it is intended to embrace all such changes, modification and variations that fall with the scope of the appended claims.

## Claims

**1.** A semiconductor coating composition useful as aperture fill compositions and bottom antireflective coatings, the semiconductor coating composition comprising:

(1) at least one nonpolymeric, binder (NPB);
(2) at least one crosslinking agent; and
(3) at least one solvent, and

wherein the nonpolymeric binder (NPB) is a non-polymeric, chromophore-containing binder (NPCB) represented by formula (B),

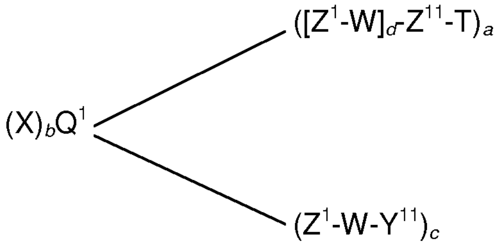

(B)

where:

$Q^1$ is a multivalent organic nucleus;
$Z^1$ and $Z^{11}$ are divalent linking groups;
W is a divalent organic bridging group;
T is an organic DUV chromophore-containing substituent, the DUV chromophore selected from the group consisting of:

a susbstituted or unsubstituted phenyl,
a substituted or unsubstituted $C_3$-$C_5$ mononuclear heteroaryl containing one or more oxygen, sulfur, or nitrogen atoms including mixtures thereof,
a substituted or unsubstituted $C_{10}$-$C_{30}$ polynuclear aryl,
a substituted or unsubstituted $C_6$-$C_{30}$ polynuclear heteroaryl containing one or more oxygen, sulfur, or nitrogen atoms including mixtures thereof, and
a nonaromatic Deep UV chromophore-containing at least one double bond conjugated with at least one electron withdrawing group;

X is a reactive functional group, each X group may be the same or different and is selected from the group consisting of hydroxyl, sulfhydryl, primary or secondary amino, alkenyl, allyl ether, vinyl ether, (meth)acryl, halogen, sulfonate, carboxyl, carboxyl ester, carboxyl anhydride, and carboxyl acid halide;
$Y^{11}$ is a reactive functional group;
*a* ranges from 2 to 15;
b ranges from zero to 10;
c ranges from zero to 5; and
*d* = 1,

wherein $Q^1$, W, and T together contain at least two groups or sites which are reactive in a crosslinking reaction with the proviso that the sum of (*a*+*b*+*c*) is greater than or equal to 3 and $Q^1$ is an unsubstituted $C_2$-$C_{40}$ linear, branched, cyclic, or polycyclic aliphatic group not containing as an integral part of a ring or chain structure oxygen, sulfur, or nitrogen atoms.

**2.** A semiconductor coating composition according to claim 1 further comprising at least one NPB represented by formula ($A^6$):

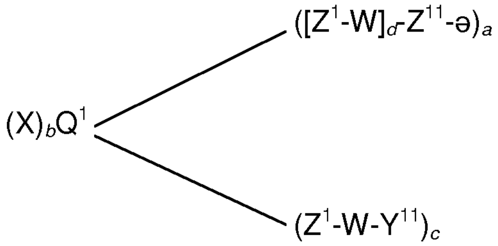

($A^6$)

where:

$Z^1$ and $Z^{11}$ are divalent linking groups,

W is a divalent organic bridging group,
ə is an organic substituent having little or no absorbance to DUV light selected from:

a hydrogen atom;
a substituted or unsubstituted $C_1$-$C_{24}$ linear, branched, cyclic, or polycyclic alkyl or alkenyl not containing as an integral part of a ring or chain structure oxygen, sulfur, or nitrogen atoms; and
a substituted or unsubstituted $C_1$-$C_{24}$ linear, branched, cyclic, or polycyclic alkyl or alkenyl containing as an integral part of a ring or chain structure one or more oxygen, sulfur, or nitrogen atoms including mixtures thereof,

*a* ranges from 2 to 15,
*b* ranges from zero to 10,
*c* ranges from zero to 5, and
*d* is independently zero or 1,

wherein $Q^1$, W, and ə together contain at least two groups or sites which are reactive in a crosslinking reaction and with the proviso that the sum of ($a$+$b$+$c$) is greater than or equal to 3 and $Q^1$ is selected from the group consisting of:

a) an unsubstituted $C_2$-$C_{40}$ linear, branched, cyclic, or polycyclic aliphatic group not containing as an integral part of a ring or chain structure oxygen, sulfur, or nitrogen atoms;
b) an unsubstituted $C_2$-$C_{40}$ linear, branched, cyclic, or polycyclic aliphatic group containing as an integral part of a ring or chain structure one or more oxygen, sulfur, or nitrogen atoms including mixtures thereof;
c) an unsubstituted $C_2$-$C_{40}$ aliphatic group containing both cyclic and acyclic components not containing as an integral part of a ring or chain structure oxygen, sulfur, or nitrogen atoms; and
d) an unsubstituted $C_2$-$C_{40}$ aliphatic group containing both cyclic and acyclic components and as an integral part of a ring or chain structure one or more oxygen, sulfur, or nitrogen atoms including mixtures thereof.

**3.** A lithographic process for forming a relief image on a substrate wherein the process comprises:

(a) providing a substrate, optionally coated with a first bottom antireflective coating previously applied or an aperture fill composition previously applied;
(b) coating in a first coating step said substrate with a semiconductor coating composition of claim 1 which is a bottom antireflective composition to form an uncured bottom antireflective coating (B.A.R.C);
(c) baking in a first baking step said uncured bottom antireflective coating to provide a cured bottom antireflective coating B.A.R.C;
(d) coating in a second coating step a photoresist over the cured B.A.R.C. to form a photoresist film over the cured B.A.R.C;
(e) baking the photoresist film in a second baking step to form a photoresist film / cured B.A.R.C./ optional first bottom antireflective coating stack;
(f) exposing the photoresist film of the stack to Deep UV imaging radiation;
(g) developing a portion of the photoresist film of the stack thereby uncovering a portion of the underlying cured B.A.R.C of the stack;
(h) rinsing the cured photoresist film / B.A.R.C. / optional first bottom antireflective coating stack with an aqueous rinse; and
(i) etching the uncovered portion of the underlying cured B.A.R.C. of the stack in an oxidizing plasma to produce a relief image.

**4.** A substrate having a relief image thereon produced according to the process of claim 3.

## Patentansprüche

**1.** Halbleiterbeschichtungszusammensetzung verwendbar als Öffnungsfüllzusammensetzungen und untere Antireflexbeschichtungen, die Halbleiterbeschichtungszusammensetzung umfassend:

(1) mindestens ein nicht polymeres Bindemittel (NPB);
(2) mindestens ein Vernetzungsmittel; und

(3) mindestens ein Lösungsmittel, und

wobei das nicht polymere Bindemittel (NPB) ein nicht polymeres Chromophorenthaltendes Bindemittel (NPCB) dargestellt durch die Formel (B)

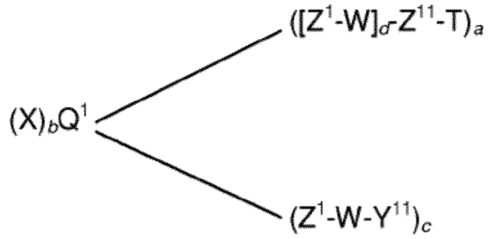

(B)

ist,
wobei

$Q^1$ ein multivalenter organischer Nukleus ist;
$Z^1$ und $Z^{11}$ divalente Verbindungsgruppen sind;
W eine divalente organische Überbrückungsgruppe ist,
T ein organischer DUV Chromophor enthaltender Substituent ist, wobei das DUV Chromophor ausgewählt ist aus der Gruppe bestehend aus:

einem substituierten oder unsubstituierten Phenyl,
einem substituierten oder unsubstituierten $C_3$-$C_5$ mononuklearen Heteroaryl enthaltend ein oder mehrere Sauerstoff-, Schwefel- oder Stickstoffatome einschließlich Mischungen davon,
einem substituierten oder unsubstituierten $C_{10}$-$C_{30}$ polynukleären Aryl,
einem substituierten oder unsubstituierten $C_6$-$C_{30}$ polynukleären Heteroaryl enthaltend ein oder mehrere Sauerstoff-, Schwefel- oder Stickstoffatome einschließlich Mischungen davon, und
einem nicht aromatischen tiefen UV Chromophor-enthaltenden Substituenten mit mindestens einer Doppelbindung, die mit mindestens einer elektronenziehenden Gruppe konjugiert ist;

X eine reaktive funktionelle Gruppe ist, wobei jede X Gruppe gleich oder verschieden sein kann und ausgewählt ist aus der Gruppe bestehend aus Hydroxyl, Sulfhydryl, primärem oder sekundärem Amino, Alkenyl, Allylether, Vinylether, (Meth)acryl, Halogen, Sulfonat, Carboxyl, Carboxylester, Carboxylanhydrid und Carboxylsäurehalogenid;
$Y^{11}$ eine reaktive funktionelle Gruppe ist;
a sich im Bereich von 2 bis 15 bewegt;
*b* sich im Bereich von null bis 10 bewegt;
*c* sich im Bereich von null bis 5 bewegt; und
*d* = 1,

wobei $Q^1$, W und T zusammen mindestens zwei Gruppen oder Stellen enthalten, die in einer Vernetzungsreaktion reaktiv sind, mit der Bedingung, dass die Summe von (a+b+c) größer als oder gleich 3 ist und $Q^1$ eine unsubstituierte $C_2$-$C_{40}$ lineare, verzweigte, cyclische oder polycyclische aliphatische Gruppe ist, die keine Sauerstoff-, Schwefel- oder Stickstoffatome als einen integralen Teil einer Ring- oder Kettenstruktur enthält.

**2.** Halbleiterbeschichtungszusammensetzung gemäß Anspruch 1 ferner umfassend mindestens einen NPB dargestellt durch die Formel ($A^6$):

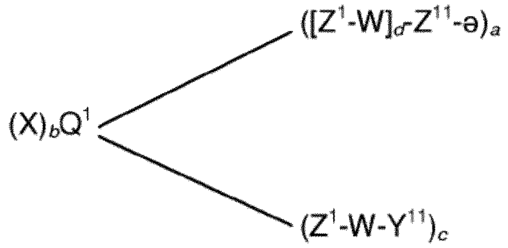

($A^6$)

wobei

$Z^1$ und $Z^{11}$ divalente Verbindungsgruppen sind,
W eine divalente organische Überbrückungsgruppe ist,

Ə ein organischer Substituent mit geringer oder keiner Absorbanz von DUV Licht ist, der ausgewählt ist aus:

einem Wasserstoffatom;
einem substituierten oder unsubstituierten $C_1$-$C_{24}$ linearen, verzweigten, cyclischen oder polycyclischen Alkyl oder Alkenyl, das keine Sauerstoff-, Schwefel- oder Stickstoffatome als einen integralen Teil einer Ring- oder Kettenstruktur enthält; und
einem substituierten oder unsubstituierten $C_1$-$C_{24}$ linearen, verzweigten, cyclischen oder polycyclischen Alkyl oder Alkenyl, das ein oder mehrere Sauerstoff-, Schwefel- oder Stickstoffatome einschließlich Mischungen davon als einen integralen Teil einer Ring- oder Kettenstruktur enthält,

*a* sich im Bereich von 2 bis 15 bewegt,
*b* sich im Bereich von null bis 10 bewegt,
*c* sich im Bereich von null bis 5 bewegt, und
*d* unabhängig null oder 1 ist,

wobei $Q^1$, W und Ə zusammen mindestens zwei Gruppen oder Stellen enthalten, die in einer Vernetzungsreaktion reaktiv sind und mit der Bedingung, dass die Summe von (a+b+c) größer als oder gleich 3 ist und $Q^1$ ausgewählt ist aus der Gruppe bestehend aus:

a) einer unsubstituierten $C_2$-$C_{40}$ linearen, verzweigten, cyclischen oder polycyclischen aliphatischen Gruppe, die keine Sauerstoff-, Schwefel- oder Stickstoffatome als einen integralen Teil einer Ring- oder Kettenstruktur enthält,
b) einer unsubstituierten $C_2$-$C_{40}$ linearen, verzweigten, cyclischen oder polycyclischen aliphatischen Gruppe, die ein oder mehrere Sauerstoff- , Schwefel- oder Stickstoffatome einschließlich Mischungen davon als einen integralen Teil einer Ring- oder Kettenstruktur enthält,
c) einer unsubstituierten $C_2$-$C_{40}$ aliphatischen Gruppe enthaltend sowohl cyclische als auch acyclische Komponenten, die keine Sauerstoff-, Schwefel- oder Stickstoffatome als einen integralen Teil einer Ring- oder Kettenstruktur enthalten,
d) einer unsubstituierten $C_2$-$C_{40}$ aliphatischen Gruppe enthaltend sowohl cyclische als auch acyclische Komponenten und ein oder mehrere Sauerstoff-, Schwefel- oder Stickstoffatome einschließlich Mischungen davon als einen integralen Teil einer Ring- oder Kettenstruktur.

**3.** Lithographisches Verfahren zur Bildung eines Reliefs auf einem Substrat, wobei das Verfahren umfasst:

(a) Bereitstellung eines Substrats, gegebenenfalls beschichtet mit einer ersten unteren Antireflexbeschichtung, die zuvor aufgebracht wurde, oder einer Öffnungsfüllzusammensetzung, die zuvor aufgebracht wurde;
(b) Beschichten des Substrats in einem ersten Beschichtungsschritt mit einer Halbleiterbeschichtungszusammensetzung nach Anspruch 1, die eine untere Antireflexzusammensetzung ist, um eine ungehärtete untere Antireflexbeschichtung (B.A.R.C) zu bilden;
(c) Backen der ungehärteten unteren Antireflexbeschichtung in einem ersten Backschritt, um eine gehärtete untere Antireflexbeschichtung B.A.R.C bereitzustellen;
(d) Beschichten eines Fotolacks über die gehärtete B.A.R.C. in einem zweiten Beschichtungsschritt, um einen Fotolackfilm über der gehärteten B.A.R.C zu bilden;
(e) Backen des Fotolackfilms in einem zweiten Backschritt, um einen Fotolackfilm / gehärtete B.A.R.C. / gegebenenfalls erste untere Antireflexbeschichtung Stapel zu bilden;
(f) den Fotolackfilm des Stapels tiefer UV Bildgebungsstrahlung aussetzen;
(g) Entwickeln eines Teils des Fotolackfilms des Stapels, wodurch ein Teil der unterliegenden gehärteten B.A.R.C des Stapels freigelegt wird;
(h) Wässern des gehärteter Fotolackfilm / B.A.R.C / gegebenenfalls erste untere Antireflexbeschichtung Stapels mit einer wässrigen Spülung; und
(i) Ätzen des freigelegten Teils der unterliegenden gehärteten B.A.R.C. des Stapels in einem oxidierenden Plasma, um ein Relief herzustellen.

**4.** Substrat mit einem Relief darauf, hergestellt gemäß dem Verfahren nach Anspruch 3.

**Revendications**

**1.** Composition de revêtement semi-conducteur pouvant servir de compositions de remplissage d'ouverture et de revêtements de fond antireflet, la composition de revêtement semi-conducteur comprenant :

(1) au moins un liant non polymère (NPB) ;
(2) au moins un agent de réticulation ; et
(3) au moins un solvant, et

dans laquelle le liant non polymère (NPB) est un liant non polymère contenant un chromophore (NPCB) représenté par la formule (B),

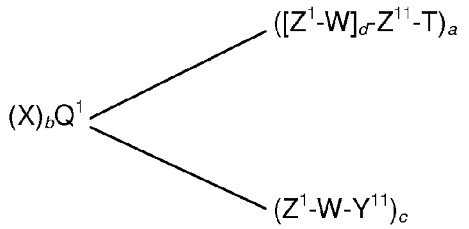

(B)

dans laquelle :

$Q^1$ représente un noyau atomique organique multivalent ;
$Z^1$ et $Z^{11}$ représentent des groupes de liaison divalents ;
W représente un groupe de pontage organique divalent ;
T représente un substituant organique contenant un chromophore DUV, le chromophore DUV étant choisi dans le groupe consistant en :

un groupe phényle substitué ou non substitué,
un groupe hétéroaryle mononucléaire en $C_3$ à $C_5$ substitué ou non substitué contenant un ou plusieurs atome(s) d'oxygène, de soufre, ou d'azote comportant des mélanges de ceux-ci,
un groupe aryle polynucléaire en $C_{10}$ à $C_{30}$ substitué ou non substitué,
un groupe hétéroaryle polynucléaire en $C_6$ à $C_{30}$ substitué ou non substitué contenant un ou plusieurs atome(s) d'oxygène, de soufre, ou d'azote comportant des mélanges de ceux-ci, et
un chromophore à UV Profond non aromatique contenant au moins une double liaison conjuguée à au moins un groupe attracteur d'électrons ;

X représente un groupe fonctionnel réactif, chaque groupe X peut être identique ou différent et est choisi dans le groupe consistant en des groupes hydroxyle, sulfhydryle, amino primaire ou secondaire, alcényle, éther allylique, éther vinylique, (méth)acryle, un atome d'halogène, des groupes sulfonate, carboxyle, ester carboxylique, anhydride carboxylique et halogénure d'acide carboxylique ;
$Y^{11}$ représente un groupe fonctionnel réactif ;
*a* est compris entre 2 et 15 ;
*b* est compris entre zéro et 10 ;
*c* est compris entre zéro et 5 ; et
*d* = 1,
dans laquelle $Q^1$, W, et T contiennent ensemble au moins deux groupes ou sites qui sont réactifs dans une réaction de réticulation à condition que la somme de ($a$+$b$+$c$) soit supérieure ou égale à 3 et que $Q^1$ soit un groupe aliphatique, cyclique ou polycyclique, ramifié, linéaire en $C_2$ à $C_{40}$ non substitué ne contenant pas, en tant que partie intégrante d'une structure de noyau ou en chaîne, des atomes d'oxygène, de soufre, ou d'azote.

**2.** Composition de revêtement semi-conducteur selon la revendication 1, comprenant en outre au moins un NPB représenté par la formule ($A^6$) :

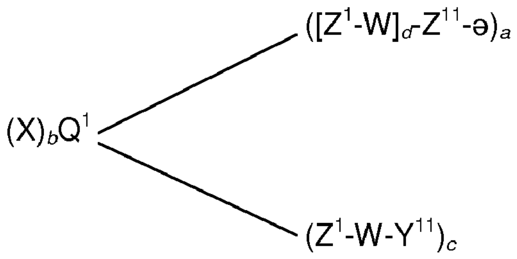

(A$^6$)

dans laquelle :

$Z^1$ et $Z^{11}$ représentent des groupes de liaison divalents,
W représente un groupe de pontage organique divalent,
ə représente un substituant organique ayant peu ou pas d'absorbance à la lumière DUV choisi entre :

un atome d'hydrogène ;
un groupe alkyle ou alcényle cyclique ou polycyclique ramifié, linéaire en $C_1$ à $C_{24}$ substitué ou non substitué ne contenant pas, en tant que partie intégrante d'une structure de noyau ou en chaîne, des atomes d'oxygène, de soufre, ou d'azote ; et
un groupe alkyle ou alcényle cyclique ou polycyclique, ramifié, linéaire en $C_1$ à $C_{24}$ substitué ou non substitué contenant, en tant que partie intégrante d'une structure de noyau ou en chaîne, un ou plusieurs atome(s) d'oxygène, de soufre, ou d'azote comportant des mélanges de ceux-ci,

a est compris entre 2 et 15,
b est compris entre zéro et 10,
c est compris entre zéro et 5, et
d vaut indépendamment zéro ou 1,
dans laquelle $Q^1$, W, et ə contiennent ensemble au moins deux groupes ou sites qui sont réactifs dans une réaction de réticulation et à condition que la somme de ($a$+$b$+$c$) soit supérieure ou égale à 3 et que $Q^1$ soit choisi dans le groupe consistant en :

a) un groupe aliphatique cyclique ou polycyclique, ramifié, linéaire en $C_2$ à $C_{40}$ non substitué ne contenant pas, en tant que partie intégrante d'une structure de noyau ou en chaîne, des atomes d'oxygène, de soufre, ou d'azote ;
b) un groupe aliphatique cyclique ou polycyclique, ramifié, linéaire en $C_2$ à $C_{40}$ non substitué contenant, en tant que partie intégrante d'une structure de noyau ou en chaîne, un ou plusieurs atome(s) d'oxygène, de soufre, ou d'azote comportant des mélanges de ceux-ci ;
c) un groupe aliphatique en $C_2$ à $C_{40}$ non substitué contenant à la fois des composants cycliques et acycliques ne contenant pas, en tant que partie intégrante d'une structure de noyau ou en chaîne, des atomes d'oxygène, de soufre, ou d'azote ; et
d) un groupe aliphatique en $C_2$ à $C_{40}$ non substitué contenant à la fois des composants cycliques et acycliques et contenant, en tant que partie intégrante d'une structure de noyau ou en chaîne, un ou plusieurs atome(s) d'oxygène, de soufre, ou d'azote comportant des mélanges de ceux-ci.

**3.** Procédé lithographique pour former une image en relief sur un substrat, dans lequel le procédé comprend les étapes consistant :

(a) à fournir un substrat, revêtu facultativement d'un premier revêtement de fond antireflet précédemment appliqué ou d'une composition de remplissage d'ouverture précédemment appliquée ;
(b) à revêtir dans une première étape de revêtement ledit substrat d'une composition de revêtement semi-conducteur de la revendication 1 qui est une composition de fond antireflet pour former un revêtement de fond antireflet non durci (B.A.R.C) ;
(c) à cuire dans une première étape de cuisson ledit revêtement de fond antireflet non durci pour fournir un revêtement de fond antireflet durci B.A.R.C ;
(d) à déposer dans une deuxième étape de revêtement une résine photosensible sur le B.A.R.C durci pour former un film de résine photosensible sur le B.A.R.C durci ;

(e) à cuire le film de résine photosensible dans une deuxième étape de cuisson pour former un empilement de film de résine photosensible/B.A.R.C durci/premier revêtement de fond antireflet facultatif ;
(f) à exposer le film de résine photosensible de l'empilement à un rayonnement d'imagerie UV Profond ;
(g) à développer une partie du film de résine photosensible de l'empilement découvrant ainsi une partie du B.A.R.C durci sous-jacent de l'empilement ;
(h) à rincer l'empilement de film de résine photosensible durci/B.A.R.C/premier revêtement de fond antireflet facultatif par un rinçage aqueux ; et
(i) à graver la partie découverte du B.A.R.C durci sous-jacent de l'empilement dans un plasma oxydant pour produire une image en relief.

**4.** Substrat ayant une image en relief sur celui-ci produite selon le procédé de la revendication 3.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6057239 A
- WO 2008072624 A1
- EP 1850180 A1
- US 7132216 B
- US 5488182 A
- US 6777161 B
- US 20050238997 A
- US 3474054 A
- US 4200729 A
- US 4251665 A
- US 5187019 A
- US 5132377 A
- US 5066722 A
- US 6773474 B
- US 20050215713 A
- US 5650262 A
- US 5296332 A
- US 5547812 A
- US 6074801 A
- US 6146806 A
- US 6800416 B
- US 6933094 B
- US 7081326 B
- US 5492793 A
- US 5747622 A
- US 5468589 A
- US 4491628 A
- US 5679495 A
- US 6379861 B
- US 6329125 B
- US 5206317 A
- US 5558978 A
- US 5554664 A
- US 6261738 B
- US 20050163629 A
- US 20050277059 A
- US 20060189779 A
- US 20060008748 A
- US 20060036005 A
- US 20070105045 A


### Non-patent literature cited in the description


- *Advances in Resist Technology and Processing,* 2005, vol. 5753, 417-435
- *ADVANCES IN RESIST TECHNOLOGY AND PROCESSING,* 2007, vol. 6519, 651928-1, 651928-10, 651929-1, 651929-10, 65192A-1, 65192A-8
- *Proc. of SPIE*